(19) Europäisches Patentamt
European Patent Office
Office européen des brevets

(11) EP 4 749 682 A1

(12) EUROPEAN PATENT APPLICATION
published in accordance with Art. 153(4) EPC

(43) Date of publication:
**27.05.2026 Bulletin 2026/22**

(21) Application number: **24845263.3**

(22) Date of filing: **19.06.2024**

(51) International Patent Classification (IPC):
***H01L 21/027*** (2006.01) ***B29C 59/02*** (2006.01)
***C08F 20/18*** (2006.01)

(52) Cooperative Patent Classification (CPC):
**B29C 59/02; C08F 20/18; H10P 76/00**

(86) International application number:
**PCT/JP2024/022283**

(87) International publication number:
**WO 2025/022881 (30.01.2025 Gazette 2025/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.07.2023 JP 2023119299**

(71) Applicant: **Canon Kabushiki Kaisha**
**Tokyo, 146-8501 (JP)**

(72) Inventors:
- **SHIRONO, Jumpei**
  **Tokyo 146-8501 (JP)**
- **ITO, Toshiki**
  **Tokyo 146-8501 (JP)**
- **OOTSUKA, Masanobu**
  **Tokyo 146-8501 (JP)**
- **MASHIDA, Ayano**
  **Tokyo 146-8501 (JP)**
- **MATSUSHIMA, Hinako**
  **Tokyo 146-8501 (JP)**
- **IMAMURA, Hideki**
  **Tokyo 146-8501 (JP)**

(74) Representative: **TBK**
**Bavariaring 4-6**
**80336 München (DE)**

# (54) CURABLE COMPOSITION, FILM FORMING METHOD, AND METHOD FOR PRODUCING ARTICLE

(57) A curable composition containing a polymerizable compound (a), a photopolymerization initiator (b), a solvent (d), and a surfactant (c1), characterized in that the curable composition has a viscosity of not less than 1.3 mPa·s and not more than 60 mPa·s at 23°C and at 1 atm, a content of the solvent (d) with respect to the whole curable composition is larger than 5 vol% and not more than 95 vol%, a boiling point of the solvent (d) is less than 250°C at 1 atm, and letting $\alpha 1$ [°] be a contact angle of a composition obtained by removing the solvent (d) and the surfactant (c1) from the curable composition to a substrate and $\alpha 2$ [°] be the contact angle of a composition obtained by removing the solvent (d) from the curable composition to the substrate, $\alpha 2$ is larger than $\alpha 1$.

F I G. 1D

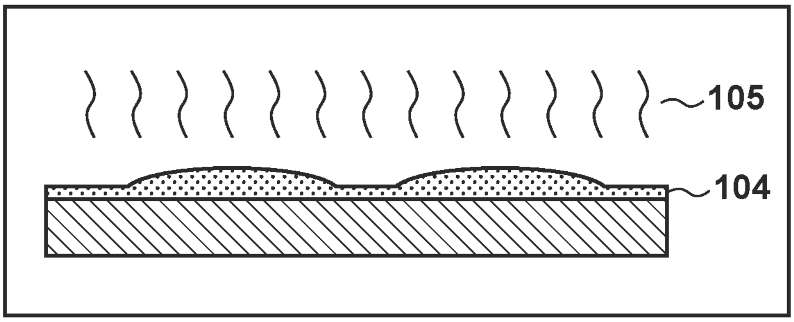

## Description

TECHNICAL FIELD

The present invention relates to a curable composition, a film forming method and an article manufacturing method.

BACKGROUND ART

For semiconductor devices and MEMS, requirements for miniaturization are increasing, and as a micropatterning technique, an imprint technique (optical imprint technique) has received a great deal of attention as a microfabrication technique. In the imprint technique, a curable composition is cured in a state in which a mold with a fine concave-convex pattern formed on the surface is in contact with the curable composition supplied (applied) onto a substrate. Thus, the pattern of the mold is transferred to the cured film of the curable composition, thereby forming the pattern on the substrate. According to the imprint technique, it is possible to form, on a substrate, a fine pattern (structure) on a several nanometer order.

An example of a pattern forming method using the imprint technique will be described. First, a curable composition in liquid form is discretely dropped (arranged) in a pattern formation region on a substrate. The droplets of the curable composition arranged in the pattern formation region spread on the substrate. This phenomenon is called pre-spreading. Next, a mold is brought into contact with (pressed against) the curable composition on the substrate. Thus, the droplets of the curable composition spread to the whole region of the gap between the substrate and the mold by a capillary phenomenon. This phenomenon is called spreading. Also, by the capillary phenomenon, the curable composition fills concave portions that form the pattern of the mold. This phenomenon is called filling. Note that the time until spreading and filling are completed is called a filling time. If the filling of the curable composition is completed, the curable composition is irradiated with light to cure the curable composition. Then, the mold is released from the cured curable composition on the substrate. By executing these steps, the pattern of the mold is transferred to the curable composition on the substrate, and the pattern of the curable composition is formed. Here, the pattern of the curable composition formed on the substrate includes a residual film. The residual film is a cured film remaining between the substrate and a concave portion of the cured film of the curable composition (a convex portion of the pattern of the mold).

A photolithography step of fabricating a semiconductor device requires planarization of a substrate. For example, in an extreme ultraviolet exposure technique (EUV) as a photolithography technique attracting attention in recent years, the depth of focus at which a projected image is formed decreases as miniaturization advances, so the unevenness on the surface of a substrate to which a curable composition is supplied must be decreased to a few tens of nm or less. Flatness equivalent to that of EUV is required in an imprint technique as well, in order to improve the filling properties of a curable composition and the line width accuracy. As a planarization technique, there is known a technique of obtaining a flat surface by discretely dropping, on an uneven substrate, droplets of a curable composition in an amount corresponding to the unevenness, and curing the curable composition in a state in which a mold having a flat surface is in contact with the curable composition.

In the pattern forming method or planarization technique using the imprint technique, since the mold is brought into contact in a state in which the droplets of the curable composition dropped onto the substrate are not in contact with each other, bubbles are inevitably entrapped between the mold, the substrate, and the curable composition. Hence, a long time is needed until the bubbles are diffused to the mold or the substrate and disappear, and this is one of factors for lowering productivity (throughput). Hence, there is proposed a technique of bonding the droplets of the curable composition to each other before the curable composition on the substrate and the mold are brought into contact with each other (see PTL 1).

CITATION LIST

PATENT LITERATURE

PTL 1: Japanese Patent Laid-Open No. 2022-188736

SUMMARY OF INVENTION

TECHNICAL PROBLEM

However, in the technique disclosed in PTL 1, since the droplets of the curable composition dropped on the substrate so spread at a high speed that the droplets bond to each other, the curable composition may extrude from a

desired region (pattern formation region). The length of the curable composition extruded from the desired region is called an "extrusion amount".

Also, in the technique disclosed in PTL 1, at the time when the mold is brought into contact with the curable composition on the substrate, since the curable composition has fluidity, it may extrude from the contact surface of the mold and adhere to (crawl up) the side wall of the mold. The phenomenon that the curable composition crawls up and adheres to the side wall (side surface) of the mold is called "oozing". The cured product of the curable composition adhering to the side wall of the mold remains as unnecessary matter on the substrate or drops from the side wall of the mold onto the substrate at an unexpected timing, causing a large defect on the substrate.

The present invention provides a new technique concerning a curable composition.

## SOLUTION TO PROBLEM

A curable composition as one aspect of the present invention is that a curable composition containing a polymerizable compound (a), a photopolymerization initiator (b), a solvent (d), and a surfactant (c1), characterized in that the curable composition has a viscosity of not less than 1.3 mPa·s and not more than 60 mPa·s at 23°C and at 1 atm, a content of the solvent (d) with respect to the whole curable composition is larger than 5 vol% and not more than 95 vol%, a boiling point of the solvent (d) is less than 250°C at 1 atm, and letting $\alpha 1$ [°] be a contact angle of a composition obtained by removing the solvent (d) and the surfactant (c1) from the curable composition to a substrate and $\alpha 2$ [°] be the contact angle of a composition obtained by removing the solvent (d) from the curable composition to the substrate, $\alpha 2$ is larger than $\alpha 1$.

## ADVANTAGEOUS EFFECTS OF INVENTION

According to the present invention, a new technique concerning a curable composition is provided.

Other features and advantages of the present invention will be apparent from the following description taken in conjunction with the accompanying drawings. Note that the same reference numerals denote the same or like components throughout the accompanying drawings.

## BRIEF DESCRIPTION OF DRAWINGS

The accompanying drawings, which are incorporated in and constitute a part of the specification, illustrate embodiments of the invention and, together with the description, serve to explain principles of the invention.

Fig. 1A is a view for explaining a pattern forming method (film forming method) according to one aspect of the present invention.
Fig. 1B is a view for explaining a pattern forming method (film forming method) according to one aspect of the present invention.
Fig. 1C is a view for explaining a pattern forming method (film forming method) according to one aspect of the present invention.
Fig. 1D is a view for explaining a pattern forming method (film forming method) according to one aspect of the present invention.
Fig. 1E is a view for explaining a pattern forming method (film forming method) according to one aspect of the present invention.
Fig. 1F is a view for explaining a pattern forming method (film forming method) according to one aspect of the present invention.
Fig. 1G is a view for explaining a pattern forming method (film forming method) according to one aspect of the present invention.
Fig. 2 is a view for explaining the behavior of a droplet of a curable composition after drop.
Fig. 3 is a view showing the shape of a droplet in a case where a flow of droplets is induced by the Marangoni effect.
Fig. 4 is a view for explaining the behavior of a droplet of a curable composition after drop.
Fig. 5 is a view for explaining the behavior of a droplet of a curable composition after drop.
Fig. 6 is a view for explaining the behavior of a droplet of a curable composition after drop.
Fig. 7A is a view for explaining the flow behavior of a droplet of the curable composition during a waiting step.
Fig. 7B is a view for explaining the flow behavior of a droplet of the curable composition during a waiting step
Fig. 7C is a view for explaining the flow behavior of a droplet of the curable composition during a waiting step
Fig. 7D is a view for explaining the flow behavior of a droplet of the curable composition during a waiting step
Fig. 8 is a view showing comparison between a contact step in a prior art and a contact step in the present invention;
Fig. 9 is a view for explaining the concept of an oozing phenomenon;
Fig. 10 is a view showing a state in which the curable composition crawls up the side wall of a mold;

Fig. 11 is a view showing a result of measuring a contact angle to a substrate;
Fig. 12 is a view showing a result of measuring a surface tension;
Fig. 13 is a view showing a time-rate change of the radius of a droplet;
Fig. 14 is a view showing a result of measuring the extrusion amount of a liquid film;
Fig. 15 is a view showing a state in which a droplet is isolated on a substrate;
Fig. 16 is a view showing a state in which a practically continuous liquid film is formed on a substrate;
Fig. 17 is a view showing the summary of experiment results concerning three types of compositions;
Fig. 18 is a view showing the dependence of the maximum radius of a droplet on $\Delta\gamma$;
Fig. 19 is a view showing a result of measuring a contact angle to a mold; and
Fig. 20 is a view showing a result of obtaining an oozing height by numerical calculation;

DESCRIPTION OF EMBODIMENTS

An embodiment of the present invention will be described in detail below with reference to the accompanying drawings. Note that the following embodiment does not limit the invention according to the scope of the appended claims. Although a plurality of features are described in the embodiment, not all the features are essential to the invention and the plurality of features may arbitrarily be combined. The same reference numerals denote the same or similar parts and a repetitive description thereof will be omitted.
When providing a novel technique concerning a curable composition, the present inventors found a curable composition in which the droplets of the curable composition discretely dropped (arranged) on a substrate bond to each other, and a solvent contained in the curable composition can volatilize, and a process condition therefor.

[Curable Composition]

A curable composition (A) according to the present invention can be a curable composition for inkjet. The curable composition (A) according to the present invention is a composition containing at least a component (a) as a polymerizable compound, and a component (b) as a photopolymerization initiator, and a component (d) as a solvent.
In this specification, a cured film means a film cured by polymerizing the curable composition on a substrate. Note that the shape of the cured film is not particularly limited, so the film can have a pattern shape on the surface. Also, a cured film remaining between a recessed portion of the cured film of the curable composition (a projecting portion of a mold pattern) and the substrate will be called a residual film.

<Component (a): Polymerizable Compound>

The component (a) is a polymerizable compound. In this specification, the polymerizable compound is a compound that reacts with a polymerizing factor (for example, a radical) generated from a photopolymerization initiator (the component (b)), and forms a film made of a polymer compound by a chain reaction (polymerization reaction).
An example of the polymerizable compound as described above is a radical polymerizable compound. The polymerizable compound as the component (a) can be formed by only one type of a polymerizable compound, and can also be formed by a plurality of types of (one or more types of) polymerizable compounds.
Examples of the radical polymerizable compound are a (meth)acrylic compound, a styrene-based compound, a vinyl-based compound, an allylic compound, a fumaric compound, and a maleic compound.
The (meth)acrylic compound is a compound having one or more acryloyl groups or methacryloyl groups. Examples of a monofunctional (meth)acrylic compound having one acryloyl group or methacryloyl group are as follows, but the compound is not limited to these examples.
Phenoxyethyl (meth)acrylate, phenoxy-2-methylethyl (meth)acrylate, phenoxyethoxyethyl (meth)acrylate, 3-phenoxy-2-hydroxypropyl (meth)acrylate, 2-phenylphenoxyethyl (meth)acrylate, 4-phenylphenoxyethyl (meth)acrylate, 3-(2-phenylphenyl)-2-hydroxypropyl (meth)acrylate, (meth)acrylate of EO-modified p-cumylphenol, 2-bromophenoxyethyl (meth)acrylate, 2,4-dibromophenoxyethyl (meth)acrylate, 2,4,6-tribromophenoxyethyl (meth)acrylate, EO-modified phenoxy (meth)acrylate, PO-modified phenoxy (meth)acrylate, polyoxyethylenenonylphenylether (meth)acrylate, isobornyl (meth)acrylate, 1-adamantyl (meth)acrylate, 2-methyl-2-adamantyl (meth)acrylate, 2-ethyl-2-adamantyl (meth) acrylate, bornyl (meth)acrylate, tricyclodecanyl (meth)acrylate, dicyclopentanyl (meth)acrylate, dicyclopentenyl (meth) acrylate, cyclohexyl (meth)acrylate, 4-butylcyclohexyl( meth)acrylate, acryloylmorpholine, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, isostearyl

(meth)acrylate, benzyl (meth)acrylate, tetrahydrofurfuryl (meth)acrylate, butoxyethyl (meth)acrylate, ethoxydiethyleneglycol (meth)acrylate, polyethyleneglycol mono(meth)acrylate, polypropyleneglycol mono(meth)acrylate, methoxyethyleneglycol (meth)acrylate, ethoxyethyl (meth)acrylate, methoxypolyethyleneglycol (meth)acrylate, methoxypolypropyleneglycol (meth)acrylate, diacetone (meth)acrylamide, isobutoxymethyl (meth)acrylamide, N,N-dimethyl (meth)acrylamide, t-octyl (meth)acrylamide, dimethylaminoethyl (meth)acrylate, diethylaminoethyl (meth)acrylate, 7-amino-3,7-dimethyloctyl (meth)acrylate, N,N-diethyl (meth)acrylamide, N,N-dimethylaminopropyl (meth)acrylamide, 1- or 2-naphthyl (meth)acrylate, 1- or 2-naphthylmethyl (meth)acrylate, 3- or 4-phenoxybenzyl (meth)acrylate, cyanobenzyl (meth) acrylate, naphthalene methyl (meth)acrylate.

Examples of commercially available products of the above-described monofunctional (meth)acrylic compounds are as follows, but the products are not limited to these examples.

ARONIX® M101, M102, M110, M111, M113, M117, M5700, TO-1317, M120, M150, and M156 (manufactured by TOAGOSEI); MEDOL10, MIBDOL10, CHDOL10, MMDOL30, MEDOL30, MIBDOL30, CHDOL30, LA, IBXA, 2-MTA, HPA, and Viscoat #150, #155, #158, #190, #192, #193, #220, #2000, #2100, and #2150 (manufactured by OSAKA ORGANIC CHEMICAL INDUSTRY); Light Acrylate BO-A, EC-A, DMP-A, THF-A, HOP-A, HOA-MPE, HOA-MPL, PO-A, P-200A, NP-4EA, NP-8EA, Epoxy Ester M-600A, POB-A, and OPP-EA (manufactured by KYOEISHA CHEMICAL); KAYARAD® TC110S, R-564, and R-128H (manufactured by NIPPON KAYAKU); NK Ester AMP-10G, AMP-20G, and A-LEN-10 (manufactured by SHIN-NAKAMURA CHEMICAL); FA-511A, 512A, and 513A (manufactured by Hitachi Chemical); PHE, CEA, PHE-2, PHE-4, BR-31, BR-31M, and BR-32 (manufactured by DKS); VP (manufactured by BASF); ACMO, DMAA, and DMAPAA (manufactured by Kohjin); and HRD-01 (manufactured by NIPPON SHOKUBAI).

Examples of a polyfunctional (meth)acrylic compound having two or more acryloyl groups or methacryloyl groups are as follows, but the compound is not limited to these examples.

Trimethylolpropane di(meth)acrylate, trimethylolpropane tri(meth)acrylate, EO-modified trimethylolpropane tri(meth)acrylate, PO-modified trimethylolpropane tri(meth)acrylate, EO- and PO-modified trimethylolpropane tri(meth)acrylate, dimethylol tricyclodecane di(meth)acrylate, pentaerythritol tri(meth)acrylate, pentaerythritol tetra(meth)acrylate, ethylene glycol di(meth)acrylate, tetraethylene glycol di(meth)acrylate, polyethylene glycol di(meth) acrylate, polypropylene glycol di(meth)acrylate, 1,4-butanediol di(meth)acrylate, 1,6-hexanediol di(meth)acrylate, neopentyl glycol di(meth)acrylate, 1,9-nonanediol di(meth)acrylate, 1,10-decanediol di(meth)acrylate, 1,3-adamantanedimethanol di(meth)acrylate, tris(2-hydroxyethyl)isocyanurate tri(meth)acrylate, tris(acryloyloxy)isocyanurate, bis(hydroxymethyl)tricyclodecane di(meth)acrylate, dipentaerythritol penta(meth)acrylate, dipentaerythritol hexa(meth)acrylate, EO-modified 2,2-bis(4-((meth)acryloxy)phenyl)propane, PO-modified 2,2-bis(4-((meth)acryloxy)phenyl)propane, EO- and PO-modified 2,2-bis(4-((meth)acryloxy)phenyl)propane, o-, m-, or p-benzene di(meth)acrylate, and o-, m-, or p-xylylene di(meth)acrylate.

Examples of commercially available products of the above-described polyfunctional (meth)acrylic compounds are as follows, but the products are not limited to these examples.

Yupimer® UV SA1002 and SA2007 (manufactured by Mitsubishi Chemical); Viscoat #195, #230, #215, #260, #335HP, #295, #300, #360, #700, GPT, and 3PA (manufactured by OSAKA ORGANIC CHEMICAL INDUSTRY); Light Acrylate 4EG-A, 9EG-A, NP-A, DCP-A, BP-4EA, BP-4PA, TMP-A, PE-3A, PE-4A, and DPE-6A (manufactured by KYOEISHA CHEMICAL); KAYARAD® PET-30, TMPTA, R-604, DPHA, DPCA-20, -30, -60, and -120, HX-620, D-310, and D-330 (manufactured by NIPPON KAYAKU); ARONIX® M208, M210, M215, M220, M240, M305, M309, M310, M315, M325, and M400 (manufactured by TOAGOSEI); Ripoxy® VR-77, VR-60, and VR-90 (manufactured by Showa Highpolymer); OGSOL EA-0200 and OGSOL EA-0300 (manufactured by Osaka Gas Chemicals); and SR295 and SR355 (manufactured by Sartomer).

Note that in the above-described compound group, (meth)acrylate means acrylate or methacrylate having an alcohol residue equal to acrylate. A (meth)acryloyl group means an acryloyl group or a methacryloyl group having an alcohol residue equal to the acryloyl group. EO indicates ethylene oxide, and an EO-modified compound A indicates a compound in which a (meth)acrylic acid residue and an alcohol residue of a compound A bond via the block structure of an ethylene oxide group. Also, PO indicates a propylene oxide, and a PO-modified compound B indicates a compound in which a (meth)acrylic acid residue and an alcohol residue of a compound B bond via the block structure of a propylene oxide group.

Practical examples of the styrene-based compound are as follows, but the compound is not limited to these examples.

Alkylstyrene such as styrene, 2,4-dimethyl-α-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethylstyrene, o-ethylstyrene, m-ethylstyrene, p-ethylstyrene, diethylstyrene, triethylstyrene, propylstyrene 2,4-diisopropylstyrene, butylstyrene, hexylstyrene, heptylstyrene, and octylstyrene; styrene halide such as fluorostyrene, o-chlorostyrene, m-chlorostyrene, p-chlorostyrene, o-bromostyrene, m-bromostyrene, p-bromostyrene, dibromostyrene, and iodostyrene; and a compound having a styryl group as a polymerizable functional group, such as nitrostyrene, acetylstyrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinylnaphthalene, 2-vinylnaphthalene, 4-vinyl-p-terphenyl, 1-vinylanthracene, α-methylstyrene, o-isopropenyltoluene, m-isopropenyltoluene, p-isopropenyltoluene, 2,3-dimethyl-α-methylstyrene, 3,5-dimethyl-α-methylstyrene, p-isopropyl-α-methylstyrene, α-ethylstyrene, α-chlorostyrene, divinylbenzene, diisopropylbenzene, and divinylbiphenyl.

Practical examples of the vinyl-based compound are as follows, but the compound is not limited to these examples.

Vinylpyridine, vinylpyrrolidone, vinylcarbazole, vinyl acetate, and acrylonitrile; conjugated diene monomers such as butadiene, isoprene, and chloroprene; vinyl halide such as vinyl chloride and vinyl bromide; a compound having a vinyl group as a polymerizable functional group, for example, vinylidene halide such as vinylidene chloride, vinyl ester of organic carboxylic acid and its derivative (for example, vinyl acetate, vinyl propionate, vinyl butyrate, vinyl benzoate, and divinyl adipate), and (meth)acrylonitrile.

Note that in this specification, (meth)acrylonitrile is a general term for acrylonitrile and methacrylonitrile.

Examples of the acrylic compound are as follows, but the compound is not limited to these examples.

Allyl acetate, allyl benzoate, diallyl adipate, diallyl terephthalate, diallyl isophthalate, and diallyl phthalate.

Examples of the fumaric compound are as follows, but the compound is not limited to these examples.

Dimethyl fumarate, diethyl fumarate, diisopropyl fumarate, di-sec-butyl fumarate, diisobutyl fumarate, di-n-butyl fumarate, di-2-ethylhexyl fumarate, and dibenzyl fumarate.

Examples of the maleic compound are as follows, but the compound is not limited to these examples.

Dimethyl maleate, diethyl maleate, diisopropyl maleate, di-sec-butyl maleate, diisobutyl maleate, di-n-butyl maleate, di-2-ethylhexyl maleate, and dibenzyl maleate.

Other examples of the radical polymerizable compound are as follows, but the compound is not limited to these examples.

Dialkylester of itaconic acid and its derivative (for example, dimethyl itaconate, diethyl itaconate, diisopropyl itaconate, di-sec-butyl itaconate, diisobutyl itaconate, di-n-butyl itaconate, di-2-ethylhexyl itaconate, and dibenzyl itaconate), an N-vinylamide derivative of organic carboxylic acid (for example, N-methyl-N-vinylacetamide), and maleimide and its derivative (for example, N-phenylmaleimide and N-cyclohexylmaleimide).

If the component (a) is formed by a plurality of types of compounds having one or more polymerizable functional groups, both a monofunctional polymerizable compound and a polyfunctional polymerizable compound are preferably included. The ratio of the polyfunctional polymerizable compound in the component (a) is preferably 20 wt% or more, more preferably 25 wt% or more, and particularly preferably 40 wt% or more. This is because if a monofunctional compound and a polyfunctional compound are combined, a cured film having well-balanced performance, for example, a high mechanical strength, a high dry etching resistance, and a high heat resistance can be obtained.

The film forming method according to the present invention requires a few milliseconds to a few hundreds of seconds until droplets of the curable composition (A) discretely arranged on a substrate combine with each other and form a practically continuous liquid film, so a waiting step (to be described later) is necessary. In this waiting step, the solvent (d) is volatilized, but the polymerizable compound (a) must not be volatilized. Accordingly, the boiling points of one or more types of polymerizable compounds included in the polymerizable compound (a) at normal pressure are preferably 250°C or more, more preferably 300°C or more, and further preferably 350°C or more. Also, to obtain a high dry etching resistance and a high heat resistance, the cured film of the curable composition (A) preferably contains at least a compound having a cyclic structure such as an aromatic structure, an aromatic heterocyclic structure, or an alicyclic structure. Note that the normal pressure is 1 atm (atmospheric pressure).

The boiling point of the polymerizable compound (a) is almost correlated with the molecular weight. Therefore, the molecular weights of one or more types of polymerizable compounds included in the polymerizable compound (a) are preferably 200 or more, more preferably 240 or more, and further preferably 250 or more. However, even when the molecular weight is 200 or less, the compound is preferably usable as the polymerizable compound (a) of the present invention if the boiling point is 250°C or more. As described above, the boiling points of one or more types of polymerizable compounds included in the polymerizable compound (a) are preferably 250°C or more at normal pressure.

In addition, the vapor pressure at 80°C of the polymerizable compound (a) is preferably 0.001 mmHg or less. If the polymerizable compound (a) includes one or more types of polymerizable compounds, the vapor pressures of the one or more types of polymerizable compounds at 80°C are preferably 0.001 mmHg or less. This is so because, although it is favorable to heat the curable composition when accelerating volatilization of the solvent (component (d)) (to be described later), it is necessary to suppress volatilization of the polymerizable compound (a) during heating.

Note that the boiling point and the vapor pressure of each of various kinds of organic compounds at normal pressure can be calculated by, for example, Hansen Solubility Parameters in Practice (HSPiP) 5th Edition. 5.3.04.

<Ohnishi Parameter of Component (a)>

It is known that a dry etching rate V of an organic compound, a number N of all atoms in the organic compound, a

number Nc of all carbon atoms in a composition, and a number No of all oxygen atoms in the composition have a relationship of equation (1) below (see NPL 1).

$$V \propto N/(N_C - N_o) \ ...(1)$$

where N/(Nc - No) is also called "Ohnishi Parameter" (to be referred to as "OP" hereinafter). For example, US-2020-0286740 has disclosed a technique of obtaining a photocurable composition having a high dry etching resistance by using a polymerizable compound having a small OP.

Equation (1) indicates that an organic compound having many oxygen atoms in a molecule or having few aromatic ring structures or alicyclic structures has a large OP and a high dry etching rate.

In the curable composition (A) according to the present invention, the OP of the component (a) is 1.80 or more and 4.00 or less. The OP of the component (a) is more preferably 2.00 or more and 3.50 or less, and particularly preferably 2.40 or more and 3.00 or. When the OP of the component (a) is 4.00 or less, the cured film of the curable composition (A) has a high dry etching resistance. Also, when the OP of the component (a) is 1.80 or more, the cured film of the curable composition (A) can easily be removed when the underlayer is processed by using the cured film of the curable composition (A). When the component (a) is formed by a plurality of types polymerizable compounds $a_1$, $a_2$,..., $a_n$, the OP is calculated as a weighted average value (molar fraction weighted average value) based on the molar fraction as indicated by equation (2) below. If the component (a) contains one or more types of polymerizable compounds, the OP of the component (a) is calculated as the molar fraction weighted average value of an N/(Nc-No) value of each molecule of the one or more types of polymerizable compounds.

$$OP = \sum_{i=n} n_i OP_i = n_1 OP_1 + n_2 OP_2 + \cdots + n_n OP_n \quad ...(2)$$

where $OP_n$ is the OP of the component $a_n$, and $n_n$ is the molar fraction occupied by the component $a_n$ in the entire component (a).

To set the OP of the component (a) to 1.80 or more and 2.70 or less, a compound (a-1) having two or more cyclic structures, in which at least one of the cyclic structures is an aromatic structure or an aromatic heterocyclic structure, is preferably contained at least as the component (a).

<Compound (a-1): Polymerizable Compound Having Aromatic Structure, Aromatic Heterocyclic Structure, or Alicyclic Structure>

The polymerizable compound (a) according to the present invention may contain a polymerizable compound (a-1) having an aromatic structure, an aromatic heterocyclic structure, or an alicyclic structure. Also, the ratio of the component (a-1) in the component (a) is preferably 65 wt% or more. When the ratio of the component (a-1) is 65 wt% or more, the OP can be suppressed to 2.70 or less.

Examples of the cyclic structure are an aromatic structure, an aromatic heterocyclic structure, and an alicyclic structure.

The carbon number of the aromatic structure is preferably 6 to 22, more preferably 6 to 18, and further preferably 6 to 10. Practical examples of the aromatic ring are as follows.

A benzene ring, a naphthalene ring, an anthracene ring, a phenanthrene ring, a phenalene ring, a fluorene ring, a benzocyclooctene ring, an acenaphthylene ring, a biphenylene ring, an indene ring, an indane ring, a triphenylene ring, a pyrene ring, a chrysene ring, a perylene ring, and a tetrahydronaphthalene ring.

Note that, of the above-described aromatic rings, a benzene ring or a naphthalene ring is preferable, and a benzene ring is more preferable. The aromatic ring can have a structure in which a plurality of rings are connected. Examples are a biphenyl ring and a bisphenyl ring.

The carbon number of the aromatic heterocyclic structure is preferably 1 to 12, more preferably 1 to 6, and further preferably 1 to 5. Practical examples of the aromatic heterocycle are as follows.

A thiophene ring, a furan ring, a pyrrole ring, an imidazole ring, a pyrazole ring, a triazole ring, a tetrazole ring, a thiazole ring, a thiadiazole ring, an oxadiazole ring, an oxazole ring, a pyridine ring, a pyrazine ring, a pyrimidine ring, pyridazine ring, an isoindole ring, an indole ring, an indazole ring, a purine ring, a quinolizine ring, an isoquinoline ring, a quinoline ring, a phthalazine ring, a naphthyridine ring, a quinoxaline ring, a quinazoline ring, a cinnoline ring, a carbazole ring, an acridine ring, a phenazine ring, a phenothiazine ring, a phenoxathiine ring, and a phenoxazine ring.

The carbon number of the alicyclic structure is preferably 3 or more, more preferably 4 or more, and further preferably 6 or more. In addition, the carbon number of the alicyclic structure is preferably 22 or less, more preferably 18 or

less, further preferably 6 or less, and still further preferably 5 or less. Practical examples are as follows.

A cyclopropane ring, a cyclobutane ring, a cyclobutene ring, a cyclopentane ring, a cyclohexane ring, a cyclohexene ring, a cycloheptane ring, a cyclooctane ring, a dicyclopentadiene ring, a spirodecane ring, a spirononane ring, a tetrahydro dicyclopentadiene ring, an octahydronaphthalene ring, a decahydronaphthalene ring, a hexahydroindane ring, a bornane ring, a norbornane ring, a norbornene ring, an isobornane ring, a tricyclodecane ring, a tetracyclododecane ring, and an adamantane ring.

Practical examples of the polymerizable compound (a-1) having a boiling point of 250°C or more are as follows, but the compound is not limited to these examples.

3-phenoxybenzyl acrylate (mPhOBzA, OP = 2.54, boiling point = 367.4°C, 80°C vapor pressure = 0.0004 mmHg, molecular weight = 254.3)

[Formula 1]

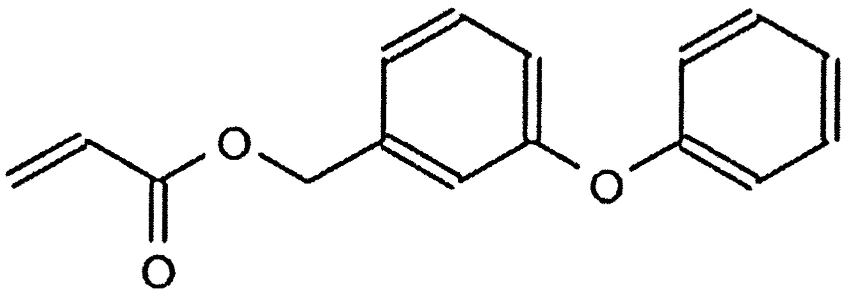

1-naphthyl acrylate (NaA, OP = 2.27, boiling point = 317°C, 80°C vapor pressure = 0.0422 mmHg, molecular weight = 198)

[Formula 2]

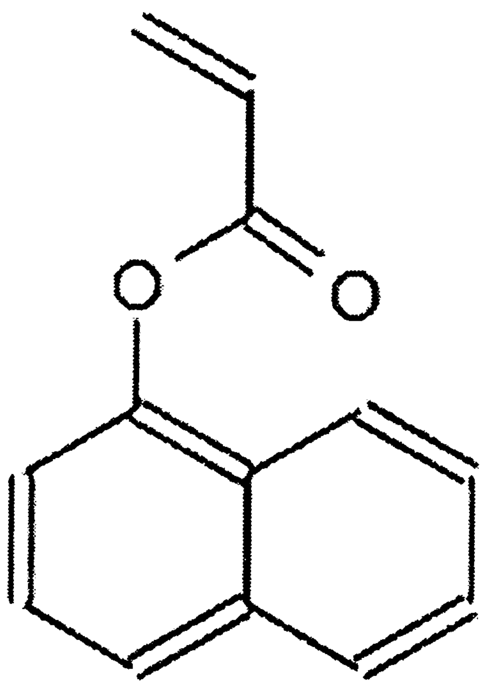

2-phenylphenoxyethyl acrylate (PhPhOEA, OP = 2.57, boiling point = 364.2°C, 80°C vapor pressure = 0.0006 mmHg, molecular weight = 268.3)

[Formula 3]

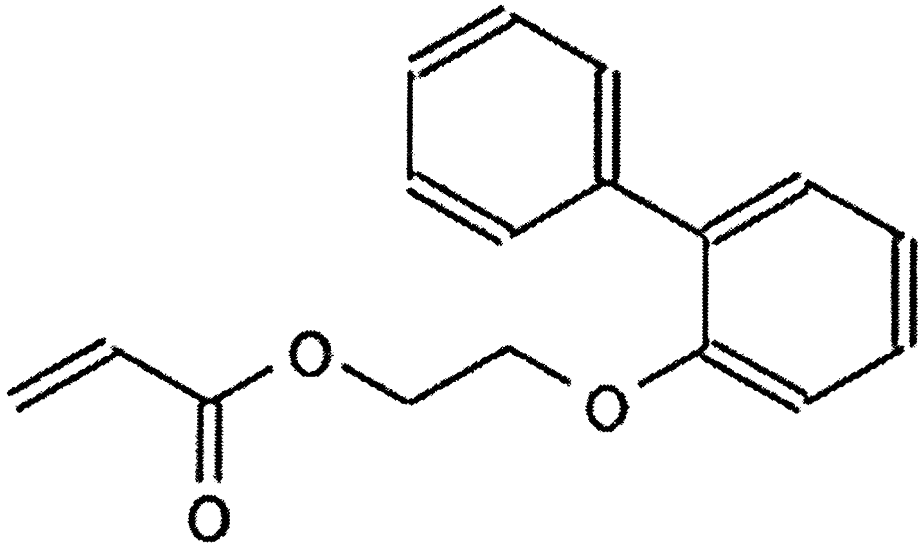

1-naphthylmethyl acrylate (Na1MA, OP = 2.33, boiling point = 342.1°C, 80°C vapor pressure = 0.042 mmHg, molecular weight = 212.2)

[Formula 4]

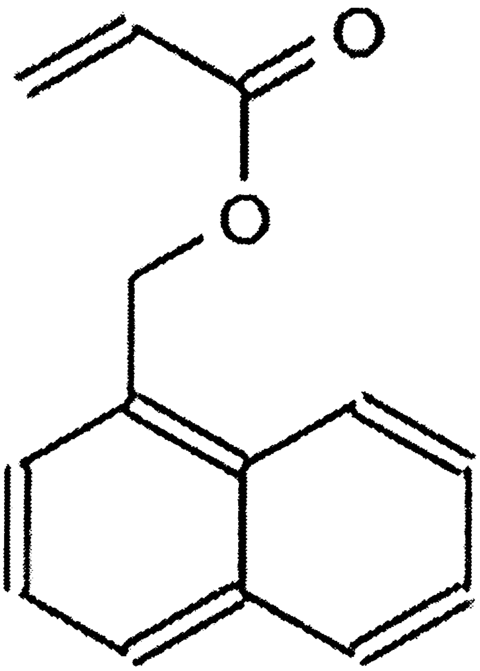

2-naphthylmethyl acrylate (Na2MA, OP = 2.33, boiling point = 342.1°C, 80°C vapor pressure = 0.042 mmHg, molecular weight = 212.2)

[Formula 5]

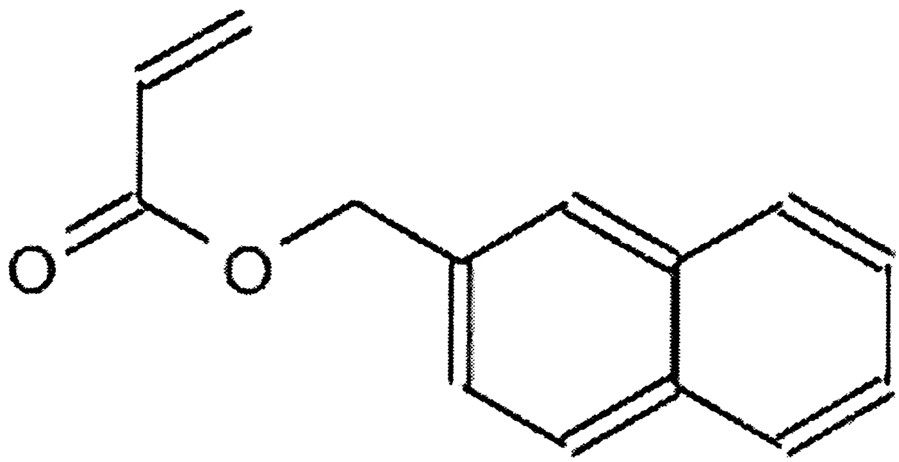

DPhPA indicated by the formula below (OP = 2.38, boiling point = 354.5°C, 80°C vapor pressure = 0.0022 mmHg, molecular weight = 266.3)

[Formula 6]

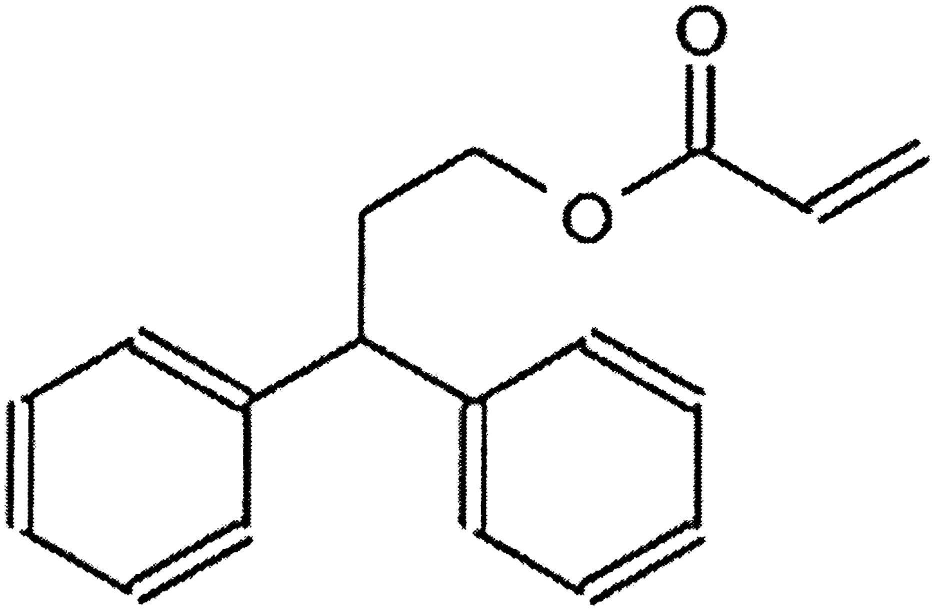

PhBzA indicated by the formula below (OP = 2.29, boiling point = 350.4°C, 80°C vapor pressure = 0.0022 mmHg, molecular weight = 238.3)

[Formula 7]

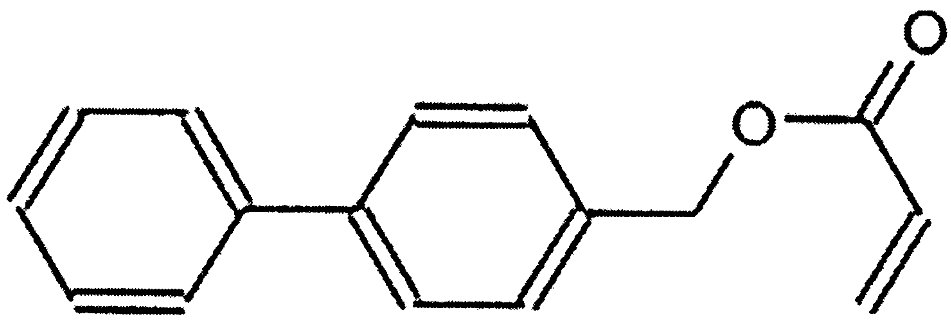

FLMA indicated by the formula below (OP = 2.20, boiling point = 349.3°C, 80°C vapor pressure = 0.0018 mmHg, molecular weight = 250.3)

[Formula 8]

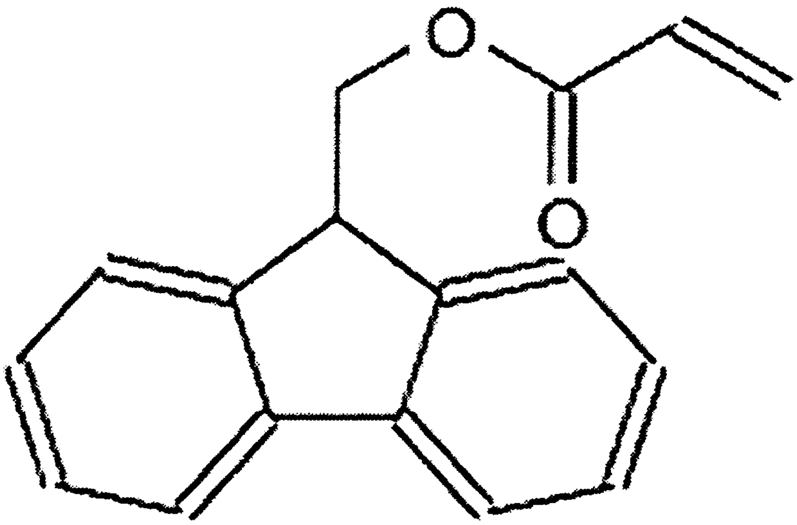

ATMA indicated by the formula below (OP = 2.13, boiling point = 414.9°C, 80°C vapor pressure = 0.0001 mmHg, molecular weight = 262.3)

[Formula 9]

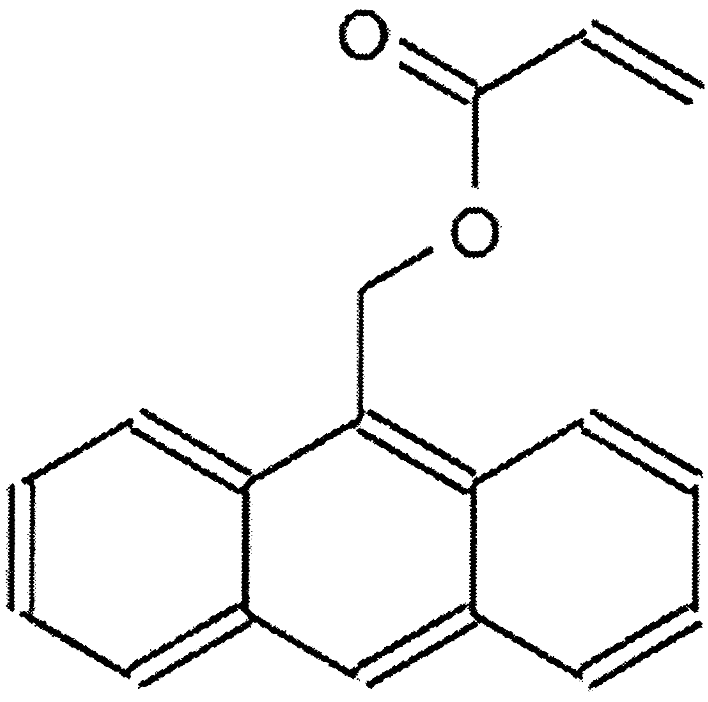

DNaMA indicated by the formula below (OP = 2.00, boiling point = 489.4°C, 80°C vapor pressure < 0.0001 mmHg, molecular weight = 338.4)

[Formula 10]

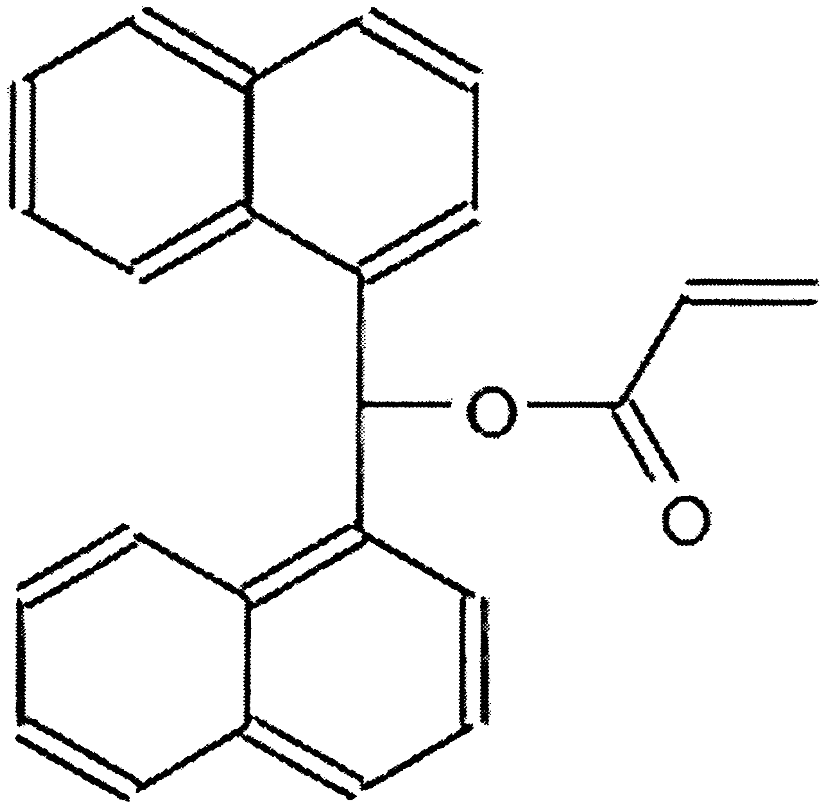

BPh44DA indicated by the formula below (OP = 2.63, boiling point = 444°C, 80°C vapor pressure < 0.0001 mmHg, molecular weight = 322.3)

[Formula 11]

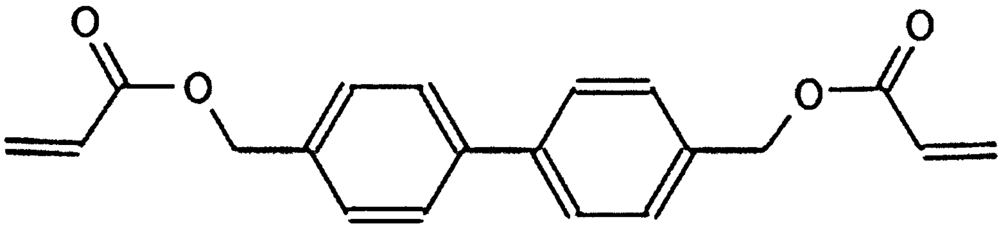

BPh43DA indicated by the formula below (OP = 2.63, boiling point = 439.5°C, 80°C vapor pressure < 0.0001 mmHg, molecular weight = 322.3)

[Formula 12]

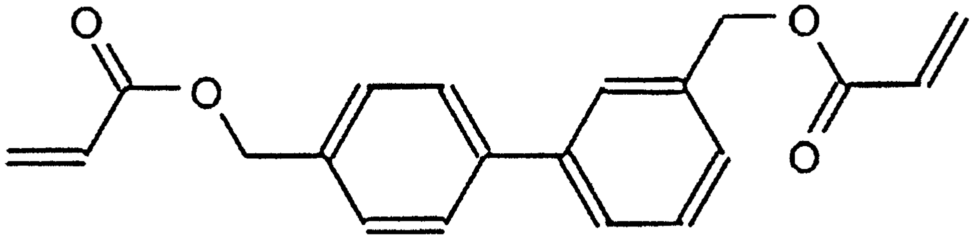

DPhEDA indicated by the formula below (OP = 2.63, boiling point = 410°C, 80°C vapor pressure < 0.0001 mmHg, molecular weight = 322.3)

[Formula 13]

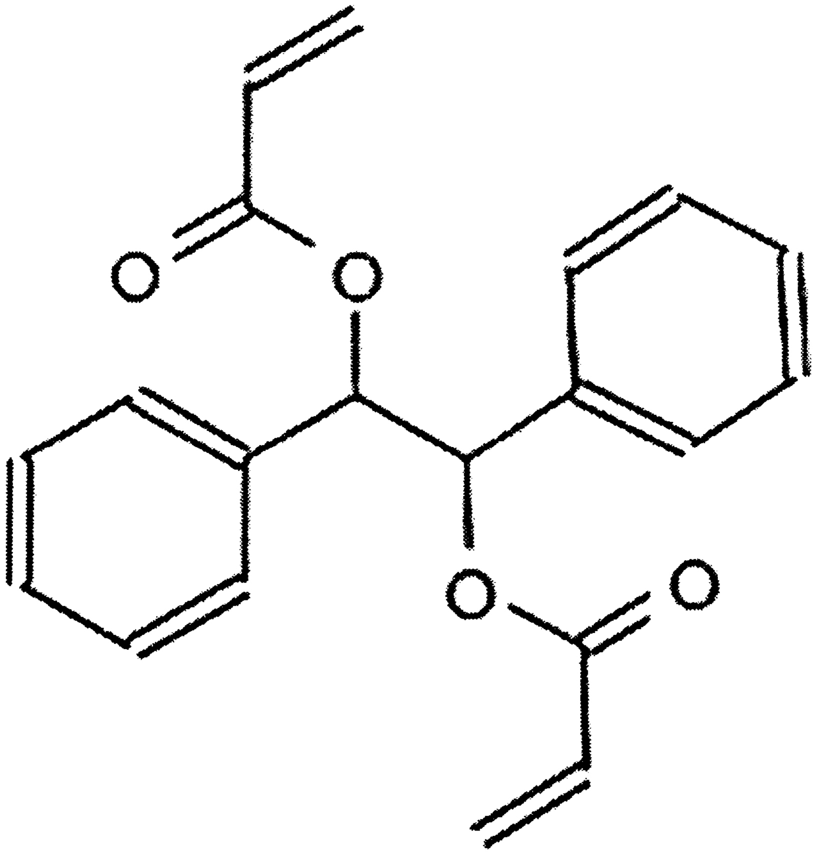

BPMDA indicated by the formula below (OP = 2.68, boiling point = 465.7°C, 80°C vapor pressure < 0.0001 mmHg, molecular weight = 364.4)

[Formula 14]

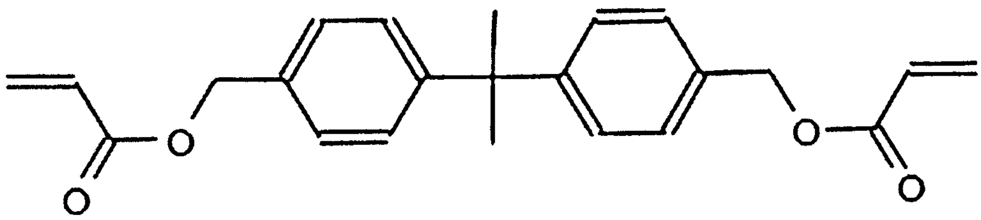

Na13MDA indicated by the formula below (OP = 2.71, boiling point = 438.8°C, 80°C vapor pressure < 0.0001 mmHg, molecular weight = 296.3)

[Formula 15]

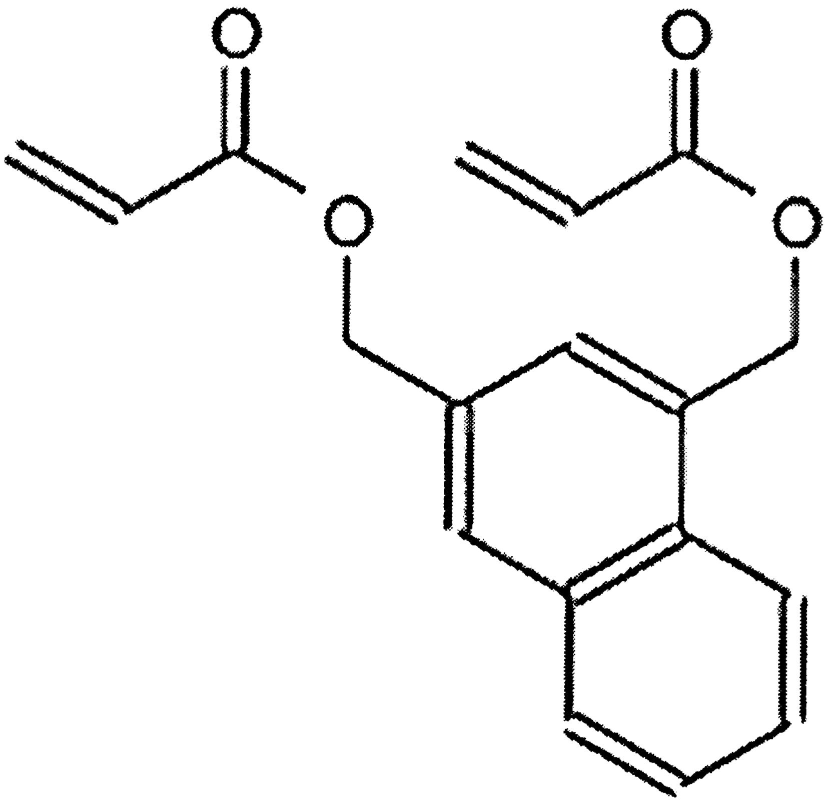

Formula below (a-1-1) (OP = 2.40, boiling point = 333.4°C, 80°C vapor pressure = 0.0181 mmHg, molecular weight = 199.2)

[Formula 16]

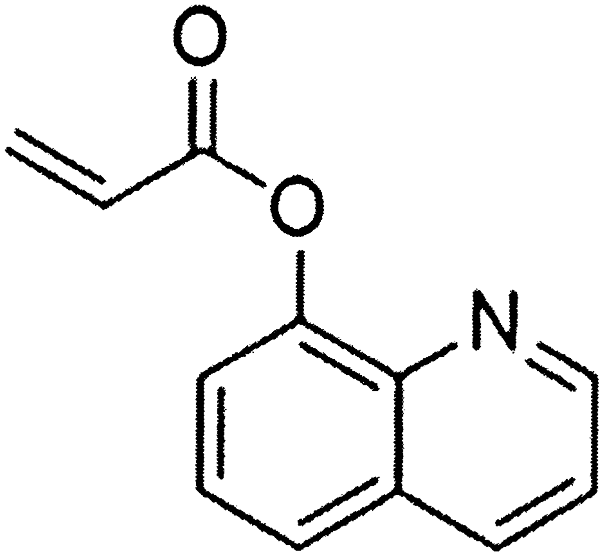

Formula below (a-1-2) (OP = 2.40, boiling point = 333.4°C, 80°C vapor pressure = 0.0181 mmHg, molecular weight = 199.2)

[Formula 17]

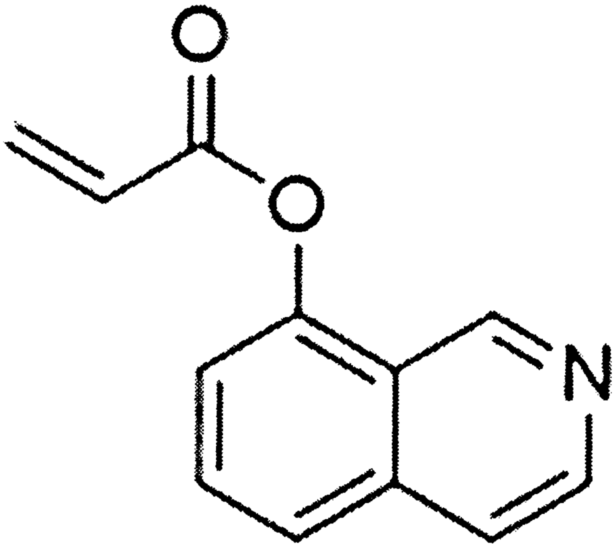

Formula below (a-1-3) (OP = 1.86, boiling point = 369.5°C, 80°C vapor pressure = 0.0053 mmHg, molecular weight = 193.3)

[Formula 18]

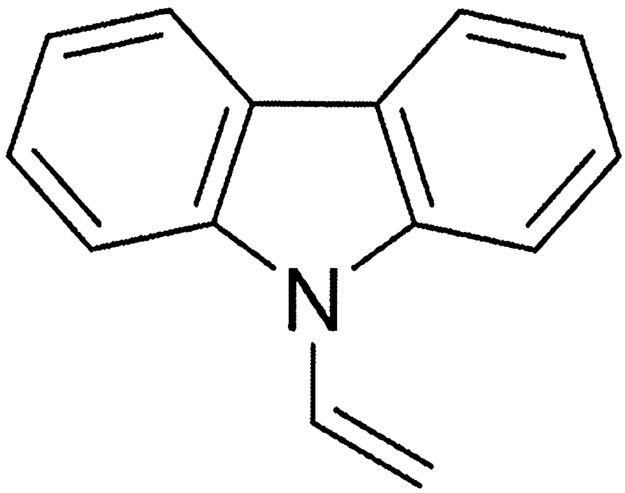

Formula below (a-1-4) (OP = 2.85, boiling point = 438.8°C, 80°C vapor pressure < 0.0001 mmHg, molecular weight = 296.3)

[Formula 19]

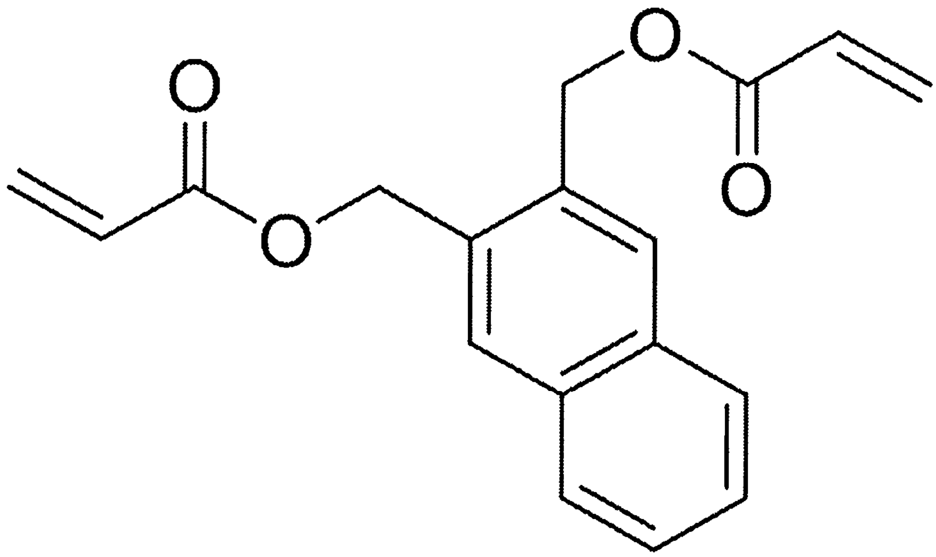

Formula below (a-1-5) (OP = 2.71, boiling point = 438.8°C, 80°C vapor pressure < 0.0001 mmHg, molecular weight = 296.3)

[Formula 20]

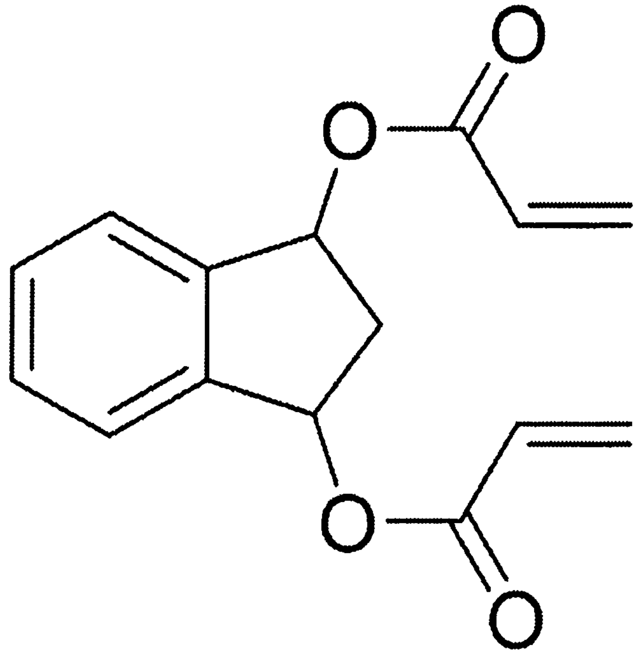

Formula below (a-1-6) (OP = 2.87, boiling point = 421.0°C, 80°C vapor pressure < 0.0001 mmHg, molecular weight = 338.4)

[Formula 21]

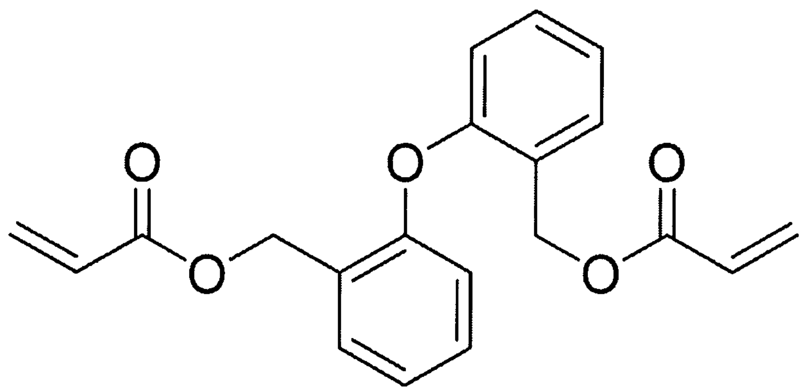

Formula below (a-1-7) (OP = 2.87, boiling point = 465.2°C, 80°C vapor pressure < 0.0001 mmHg, molecular weight = 338.4)

[Formula 22]

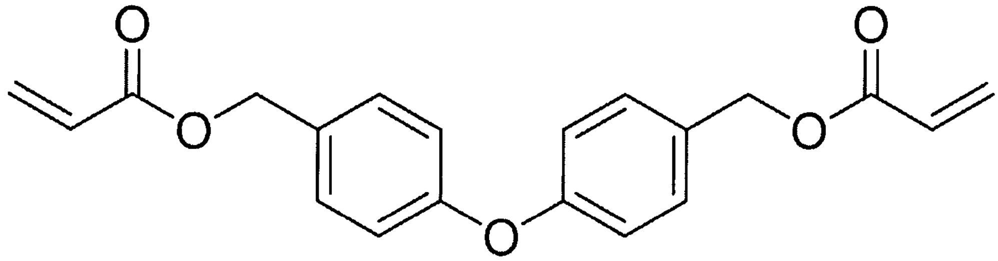

Formula below (a-1-8) (OP = 2.68, boiling point = 465.7°C, 80°C vapor pressure < 0.0001 mmHg, molecular weight = 364.4)

[Formula 23]

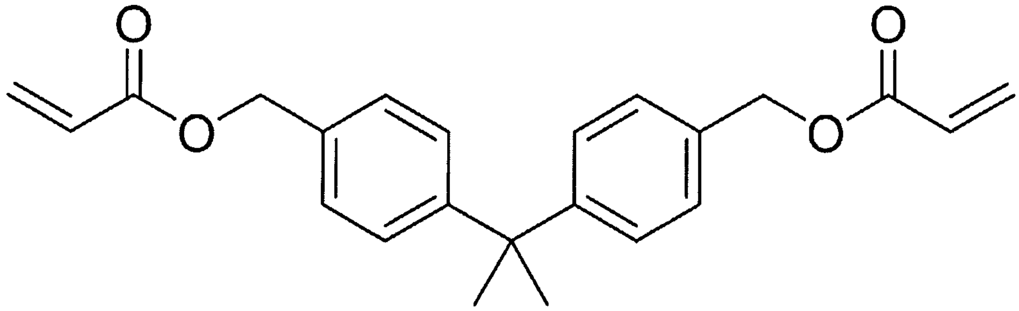

Formula below (a-1-9) (OP = 2.50, boiling point = 433.1°C, 80°C vapor pressure < 0.0001 mmHg, molecular weight = 320.3)

[Formula 24]

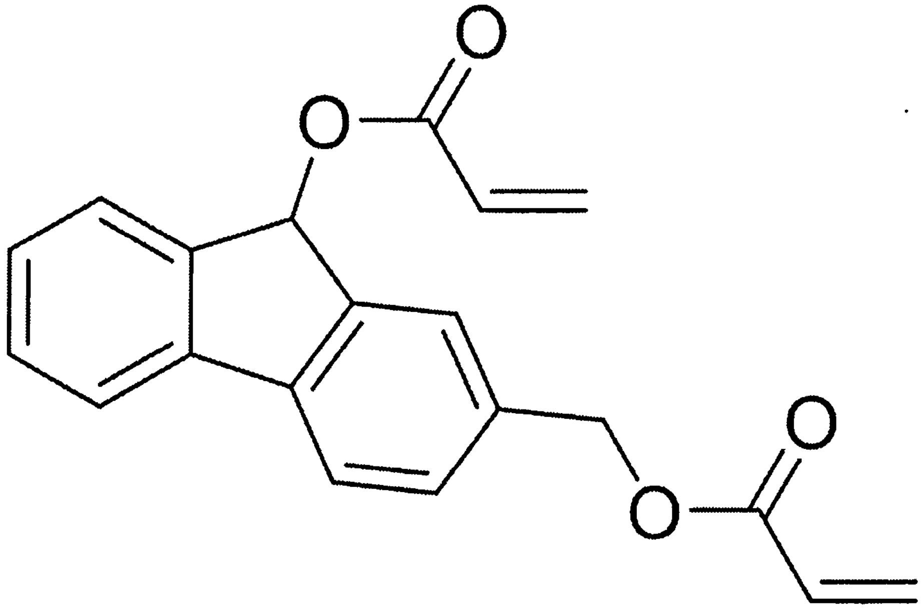

Formula below (a-1-10) (OP = 2.64, boiling point = 468.1°C, 80°C vapor pressure < 0.0001 mmHg, molecular weight = 326.4)

[Formula 25]

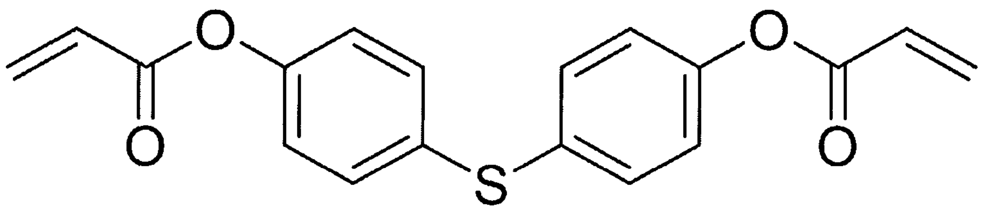

Formula below (a-1-11) (OP = 3.25, boiling point = 553.4°C, 80°C vapor pressure < 0.0001 mmHg, molecular weight = 358.4)

[Formula 26]

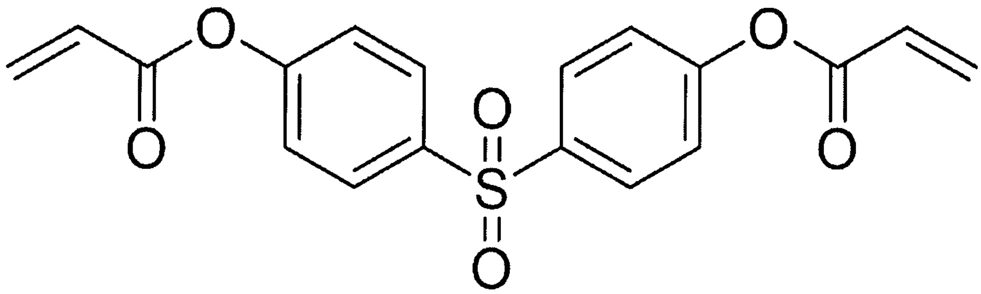

Formula below (a-1-12) (OP = 2.63, boiling point = 443.9°C, 80°C vapor pressure < 0.0001 mmHg, molecular weight = 322.4)

[Formula 27]

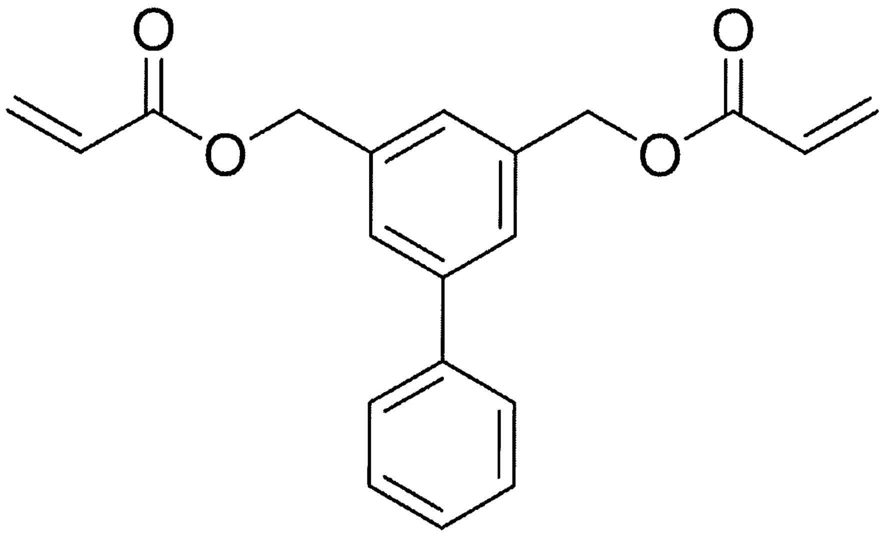

Formula below (a-1-13) (OP = 2.89, boiling point = 509.3°C, 80°C vapor pressure < 0.0001 mmHg, molecular weight = 406.4)

[Formula 28]

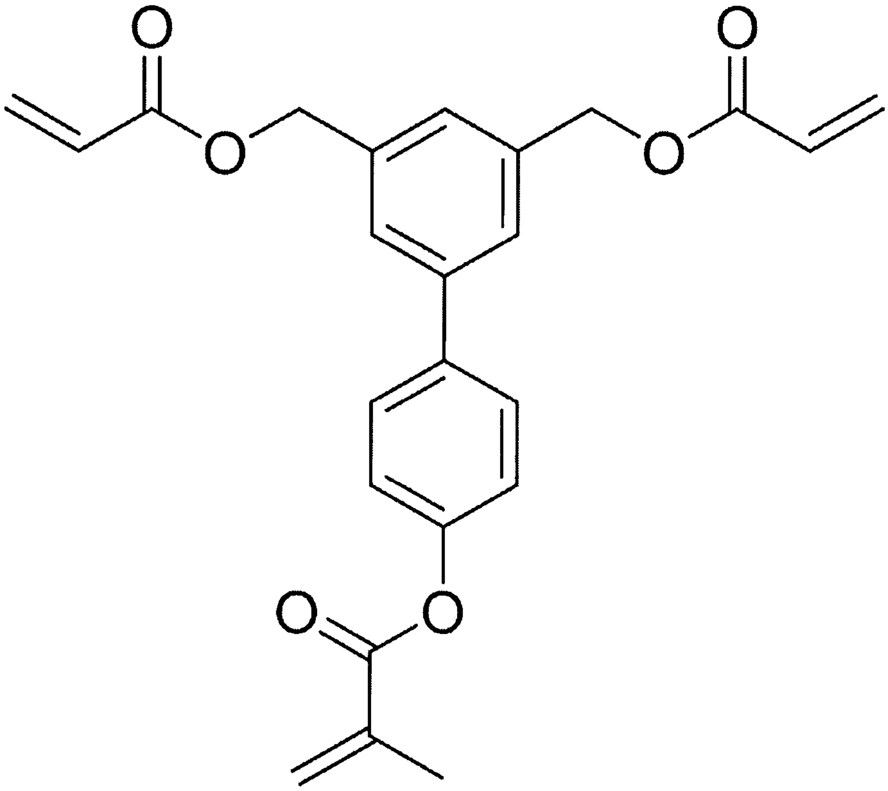

Formula below (a-1-14) (OP = 2.63, boiling point = 450.0°C, 80°C vapor pressure < 0.0001 mmHg, molecular weight = 322.4)

[Formula 29]

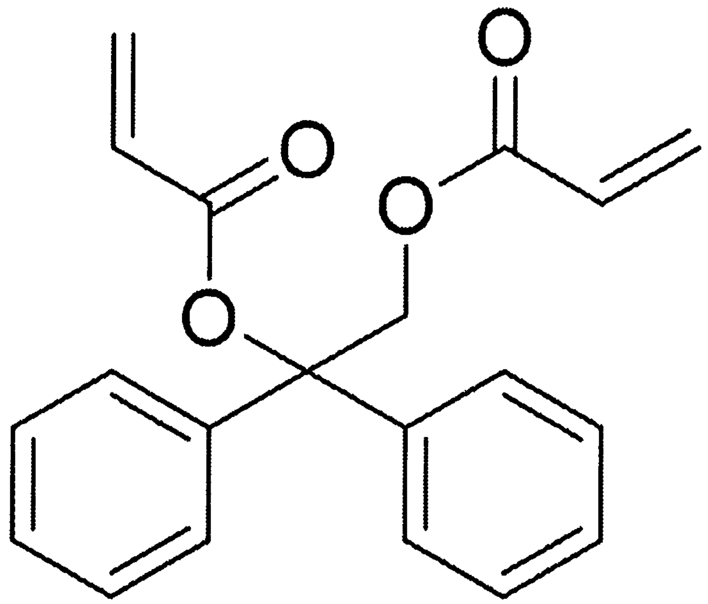

Formula below (a-1-15) (OP = 3.00, boiling point = 476.5°C, 80°C vapor pressure < 0.0001 mmHg, molecular weight = 366.4)

[Formula 30]

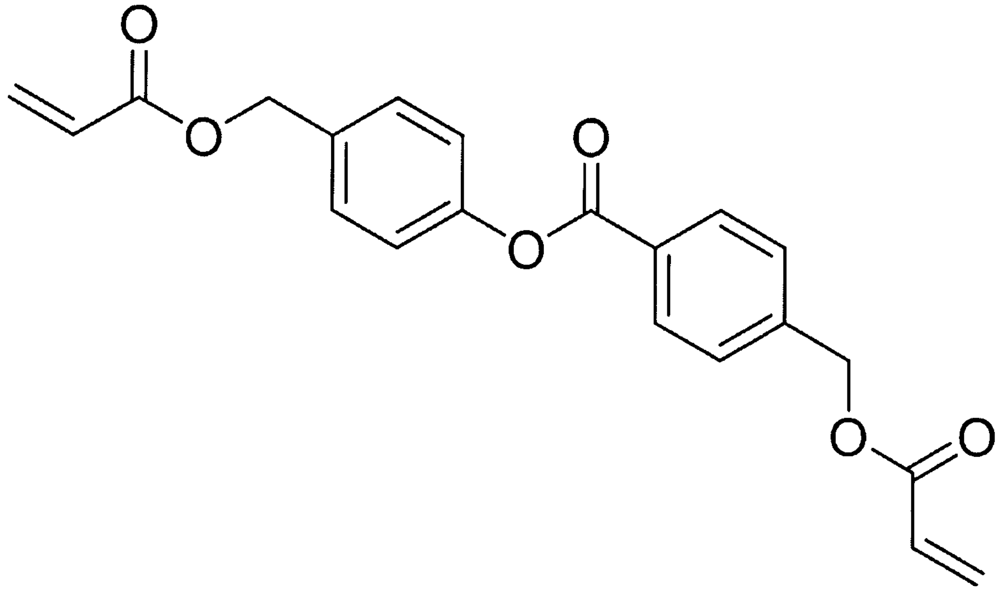

Formula below (a-1-16) (OP = 2.68, boiling point = 447.4°C, 80°C vapor pressure < 0.0001 mmHg, molecular weight = 364.4)

[Formula 31]

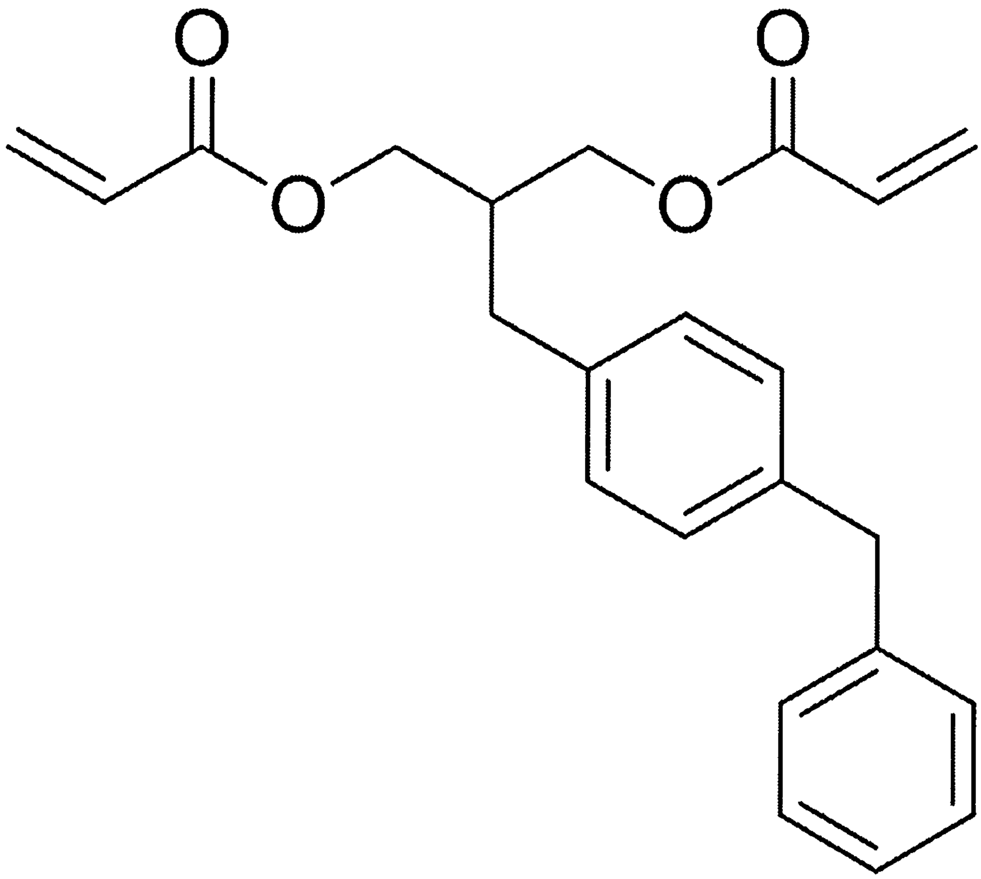

Formula below (a-1-17) (OP = 2.36, boiling point = 543.8°C, 80°C vapor pressure < 0.0001 mmHg, molecular weight = 398.5)

[Formula 32]

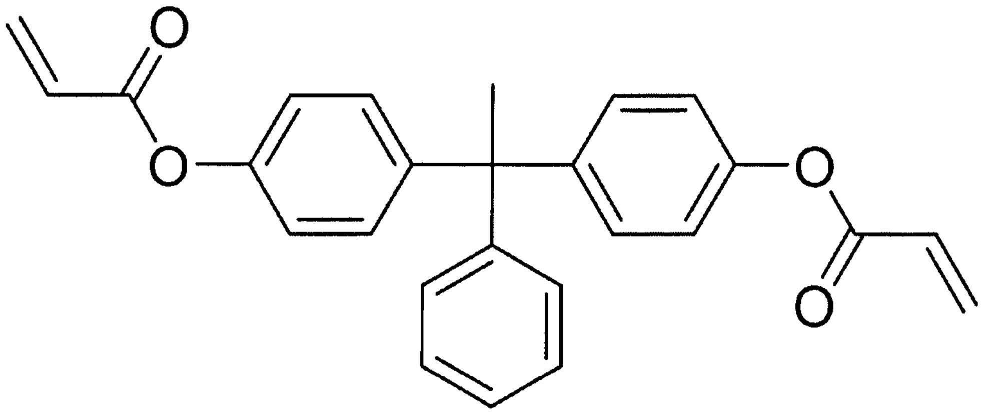

Formula below (a-1-18) (OP = 3.27, boiling point = 526.9°C, 80°C vapor pressure < 0.0001 mmHg, molecular weight = 396.4)

[Formula 33]

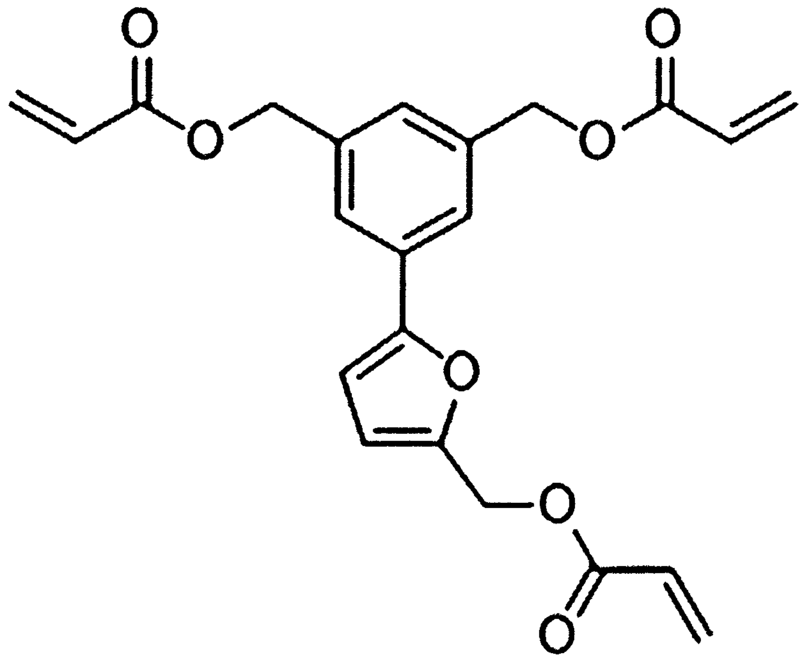

Formula below (a-1-19) (OP = 2.71, boiling point = 333.7°C, 80°C vapor pressure = 0.0302 mmHg, molecular weight = 244.3)

[Formula 34]

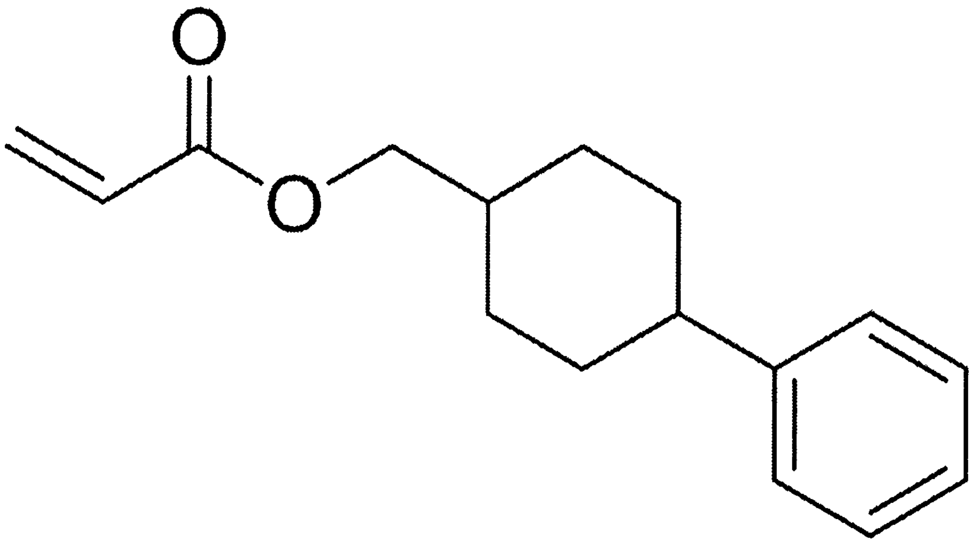

Formula below (a-1-20) (OP = 2.73, boiling point = 333.7°C, 80°C vapor pressure = 0.0134 mmHg, molecular weight = 258.3)

[Formula 35]

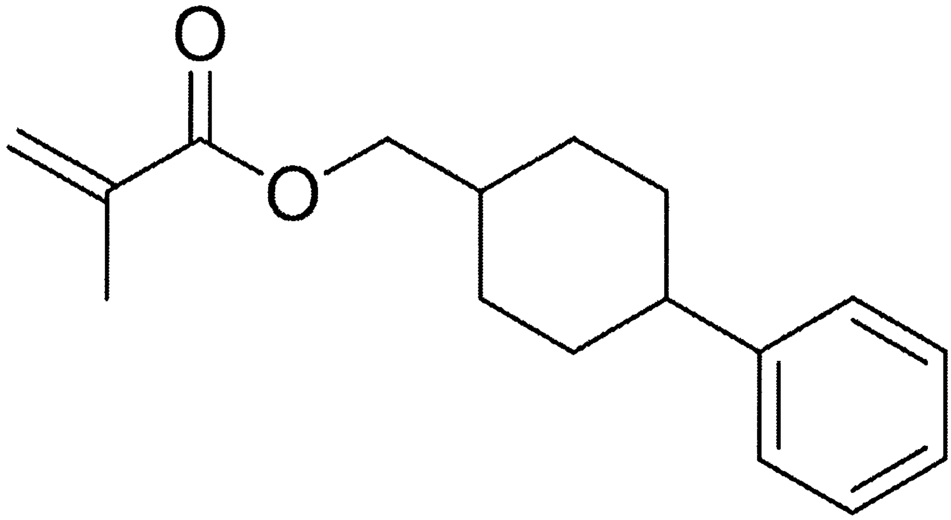

Formula below (a-1-21) (OP = 2.71, boiling point = 319.2°C, 80°C vapor pressure = 0.0566 mmHg, molecular weight = 262.3)

[Formula 36]

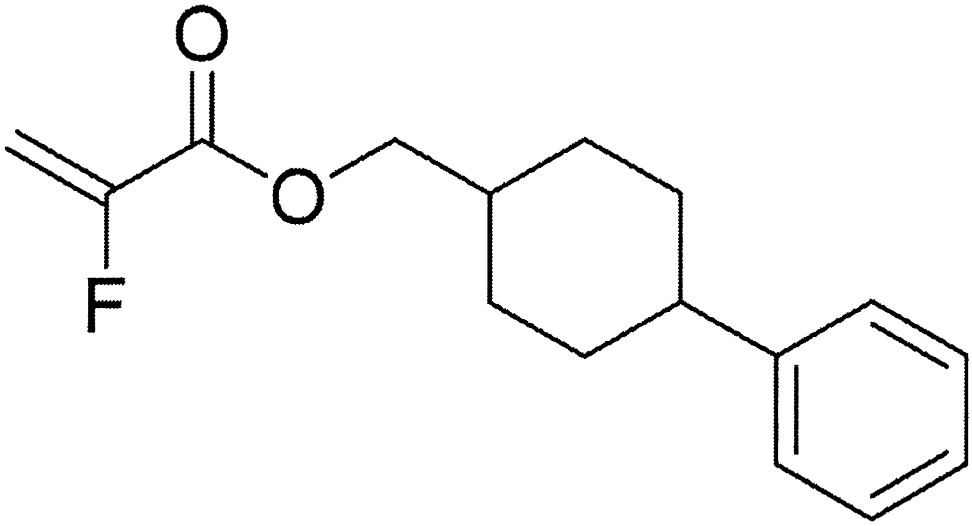

Formula below (a-1-22) (OP = 2.71, boiling point = 336.9°C, 80°C vapor pressure = 0.0055 mmHg, molecular weight = 244.3)

[Formula 37]

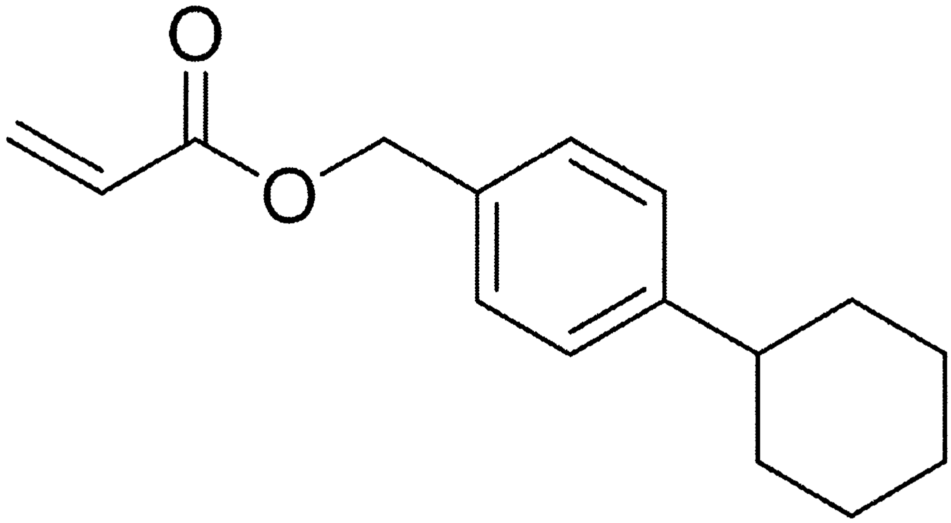

Formula below (a-1-23) (OP = 3.00, boiling point = 370.9°C, 80°C vapor pressure = 0.0021 mmHg, molecular weight = 274.4)

[Formula 38]

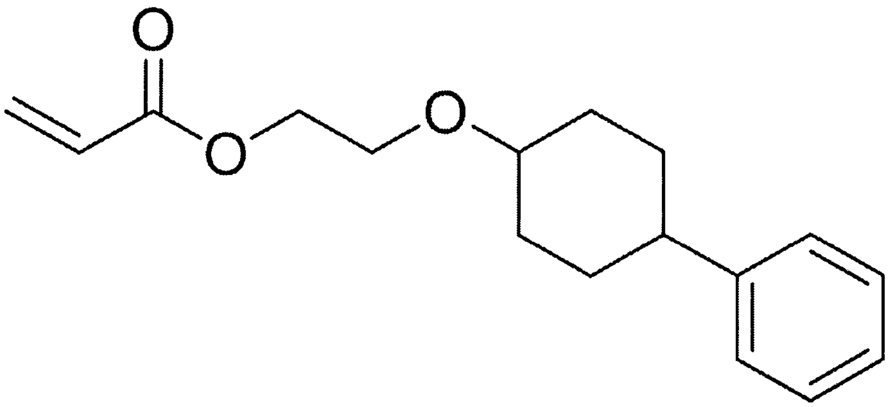

Formula below (a-1-24) (OP = 3.00, boiling point = 376.4°C, 80°C vapor pressure = 0.0005 mmHg, molecular weight = 274.4)

[Formula 39]

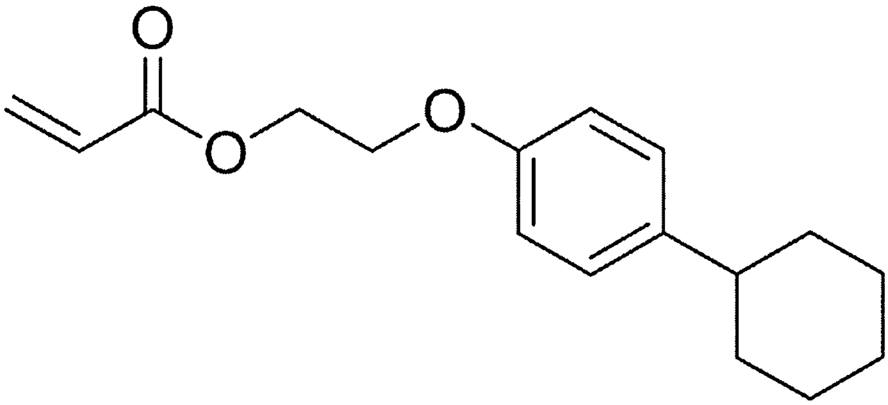

Formula below (a-1-25) (OP = 3.00, boiling point = 379.4°C, 80°C vapor pressure = 0.0002 mmHg, molecular weight = 288.4)

[Formula 40]

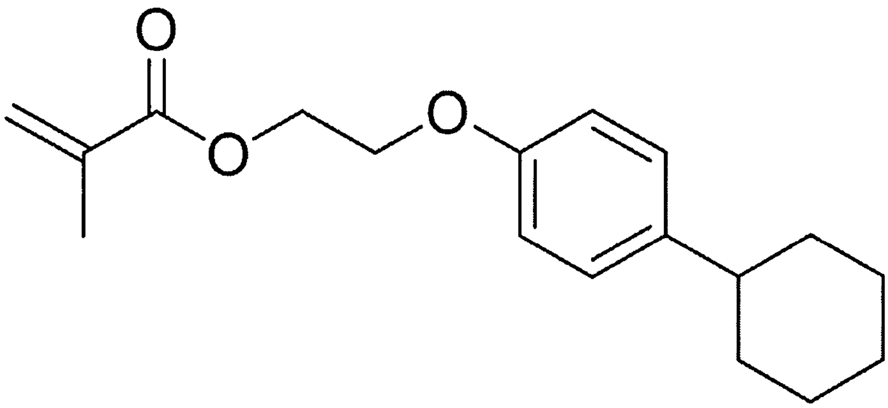

Formula below (a-1-26) (OP = 2.33, boiling point = 360.8°C, 80°C vapor pressure = 0.0006 mmHg, molecular weight = 252.3)

[Formula 41]

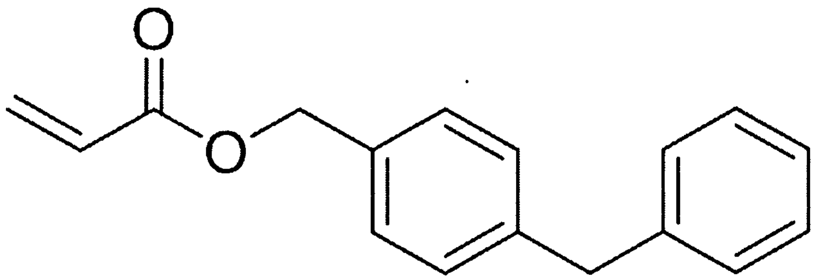

Formula below (a-1-27) (OP = 2.54, boiling point = 371.5°C, 80°C vapor pressure = 0.0003 mmHg, molecular weight = 254.3)

[Formula 42]

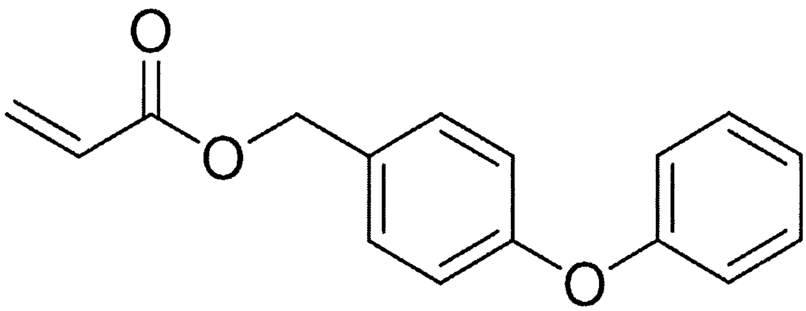

Formula below (a-1-28) (OP = 2.57, boiling point = 381.2°C, 80°C vapor pressure = 0.0001 mmHg, molecular weight = 268.3)

[Formula 43]

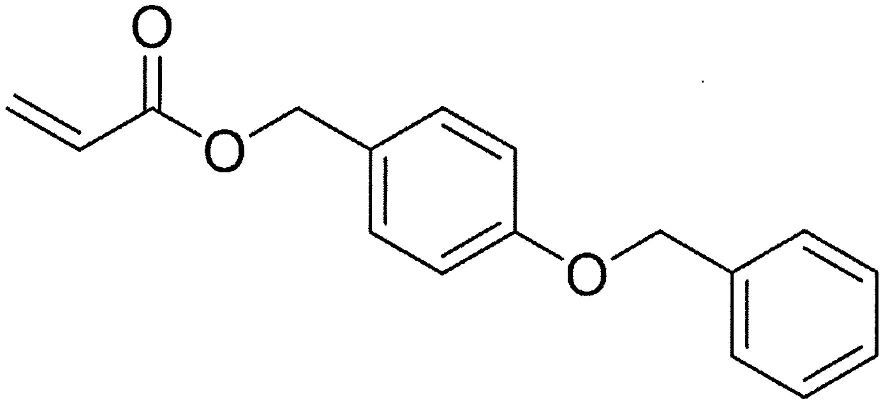

Formula below (a-1-29) (OP = 2.57, boiling point = 381.8°C, 80°C vapor pressure = 0.0004 mmHg, molecular weight = 268.3)

[Formula 44]

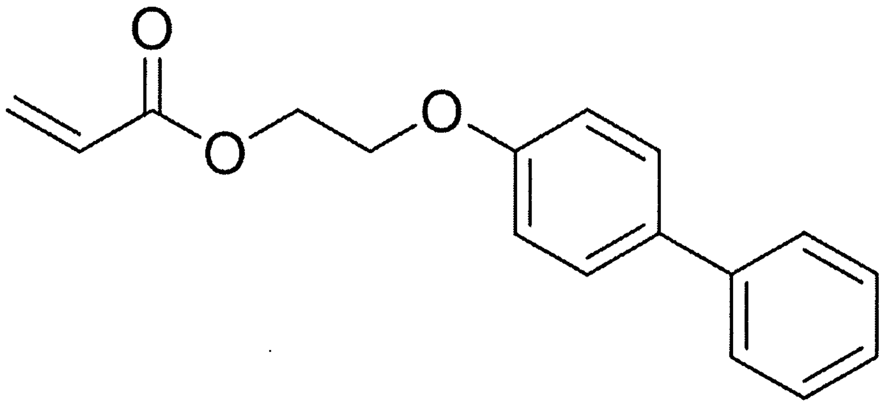

Formula below (a-1-30) (OP = 2.50, boiling point = 487.4°C, 80°C vapor pressure < 0.0001 mmHg, molecular weight = 374.4)

[Formula 45]

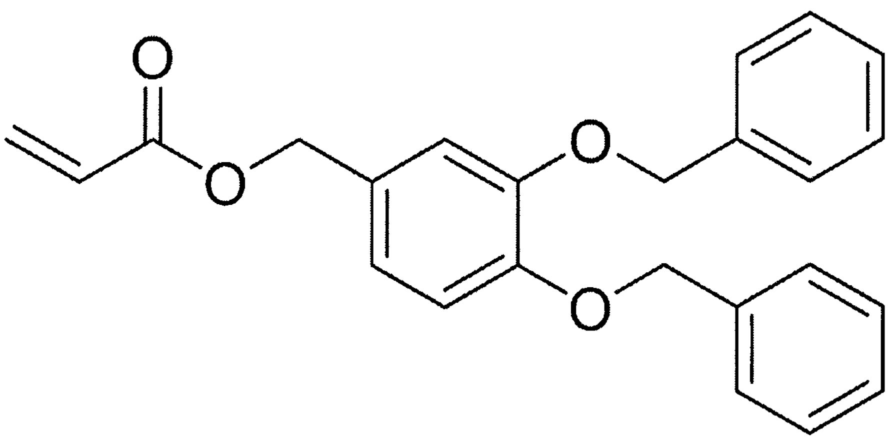

Formula below (a-1-31) (OP = 2.67, boiling point = 417.2°C, 80°C vapor pressure < 0.0001 mmHg, molecular weight = 268.3)

[Formula 46]

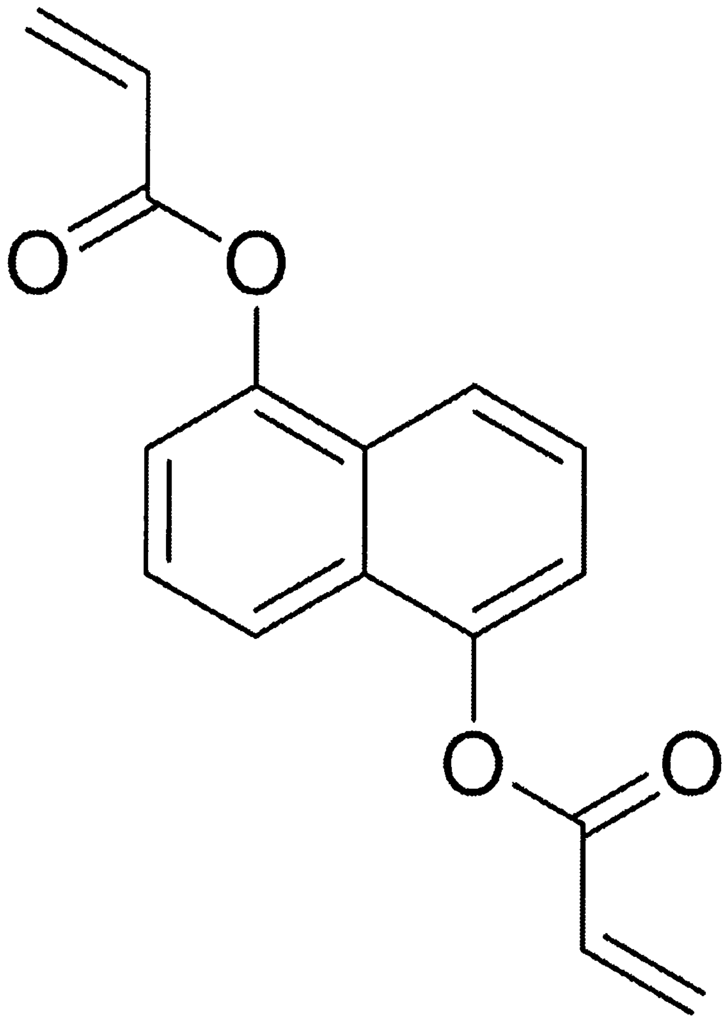

Formula below (a-1-32) (OP = 2.67, boiling point = 417.2°C, 80°C vapor pressure < 0.0001 mmHg, molecular weight = 268.3)

[Formula 47]

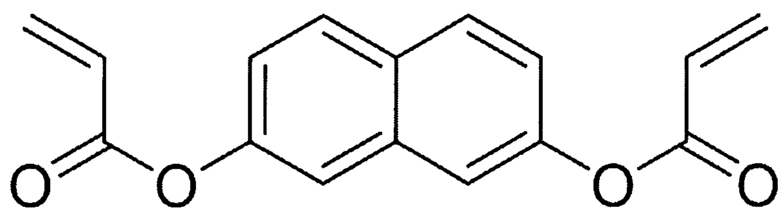

Formula below (a-1-33) (OP = 2.67, boiling point = 417.2°C, 80°C vapor pressure < 0.0001 mmHg, molecular weight = 268.3)

[Formula 48]

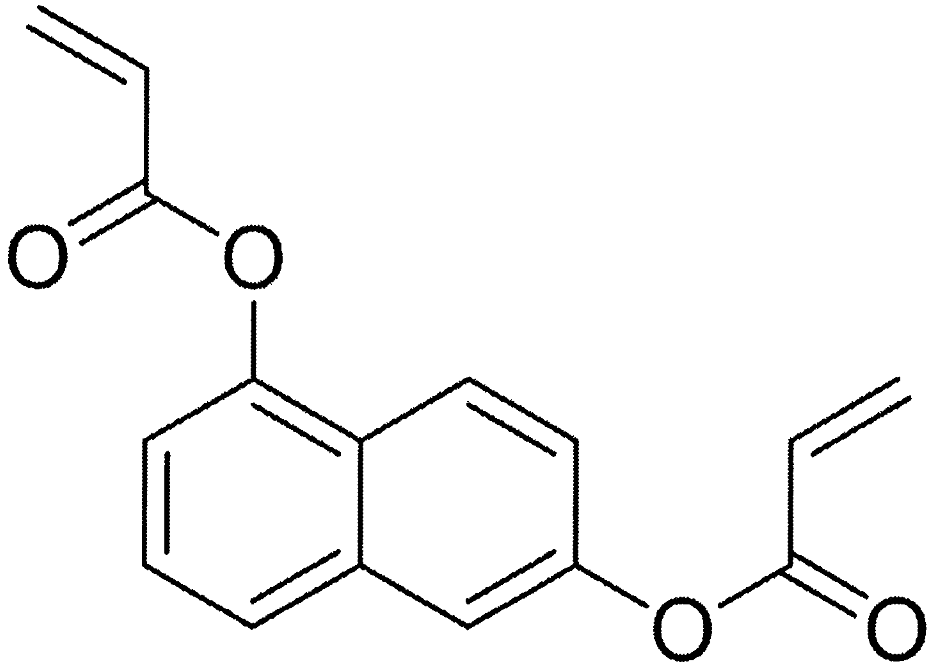

Formula below (a-1-34) (OP = 2.67, boiling point = 417.2°C, 80°C vapor pressure < 0.0001 mmHg, molecular weight = 268.3)

[Formula 49]

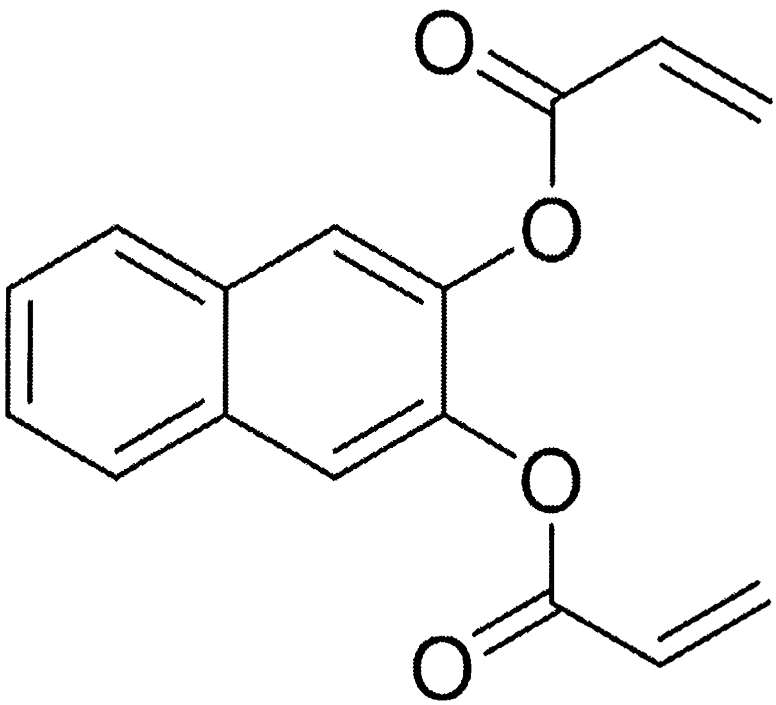

Formula below (a-1-35) (OP = 2.71, boiling point = 438.8°C, 80°C vapor pressure < 0.0001 mmHg, molecular weight = 296.3)

[Formula 50]

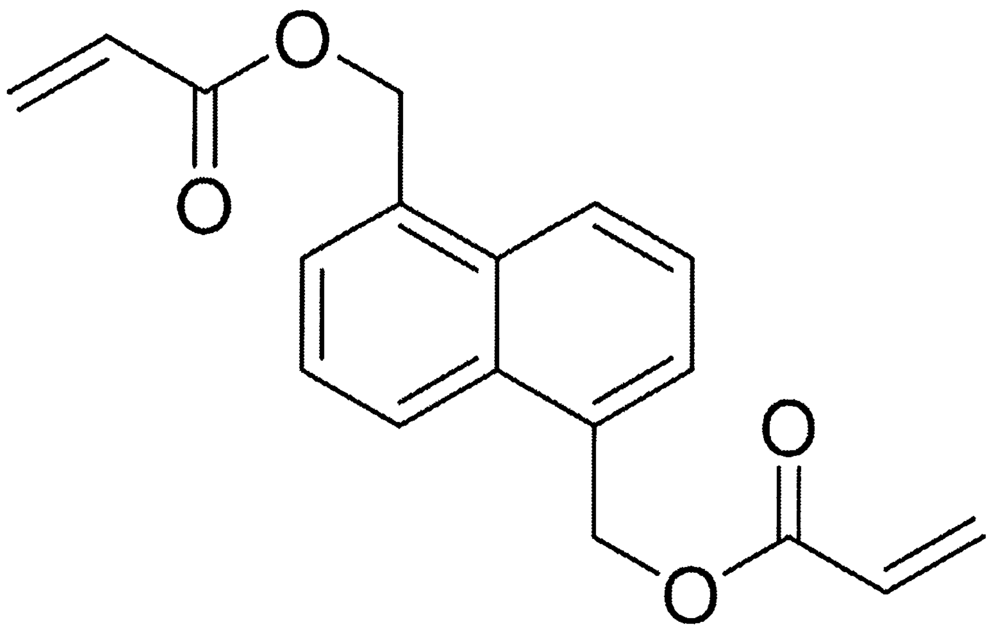

<Compound (a-2): Polymerizable Compound Containing At Least Si Atoms>

The polymerizable compound (a) according to the present invention may contain a polymerizable compound (a-2) containing at least Si atoms. Furthermore, if the polymerizable compound (a) contains the polymerizable compound (a-2), the curable composition (A) from which the solvent (d) is removed preferably contains Si atoms of 10 wt% or more with respect to the whole curable composition (A).

As an example of the polymerizable compound (a-2) containing at least Si atoms, it may have a linear structure or a branched structure. For example, as cyclic siloxane compounds, the following structures can be used. An example of a polymerizable functional group in a group Q having a polymerizable functional group is a radical polymerizable functional group. Practical examples of the radical polymerizable functional group are a (meth)acrylic group, a (meth)acrylamide group, a vinylbenzene group, an allyl ether group, a vinylether group, and a maleimide group. The group Q having a

polymerizable functional group need only be a group having the above-described polymerizable functional group.

[Formula 51]

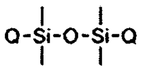
a-1

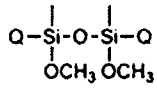
a-2

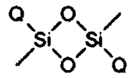
a-3

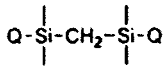
a-4

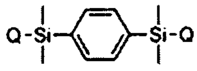
a-5

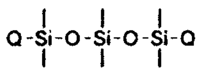
a-6

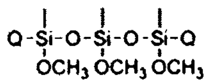
a-7

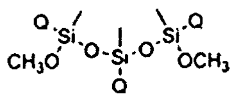
a-8

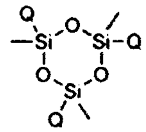
a-9

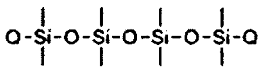
a-10

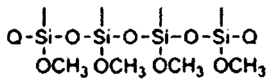
a-11

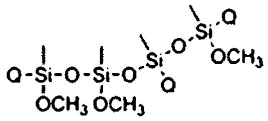
a-12

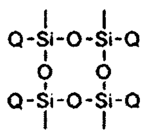
a-13

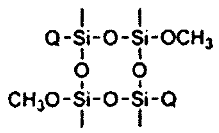
a-14

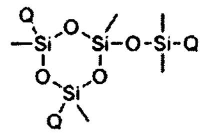
a-15

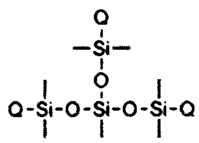
a-16

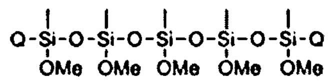
a-17

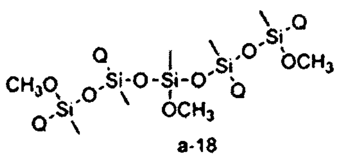
a-18

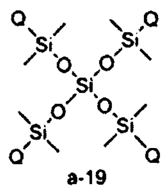
a-19

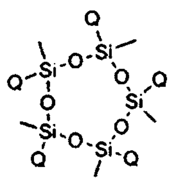
a-20

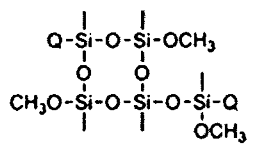
a-21

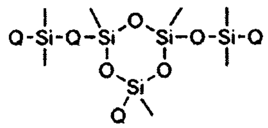
a-22

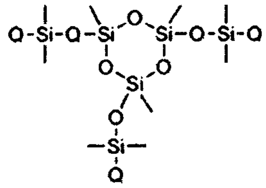
a-26

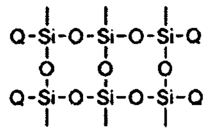
a-23

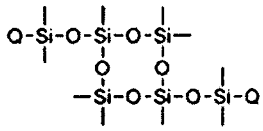
a-24

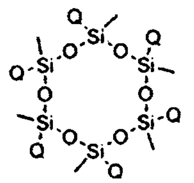
a-25

Other examples of the polymerizable compound (a-2) are a silsesquioxane skeleton as indicated by chemical formula (I) below and a silicone skeleton as indicated by chemical formula (II). In chemical formula (I), m + n =8 (8 ≥ m ≥ 1), and $R_1$ is a bivalent organic group. Additionally, in chemical formula (II), A, B, $R_2$, and $R_3$ are independently an alkyl group, a cycloalkyl group, an alkoxy group, a phenyl group, and hydroxyl group whose carbon number is 1 to 6, t is an integer of 1 to 3, and at least one of A and B is a polymerizable functional group.

[Formula 52]

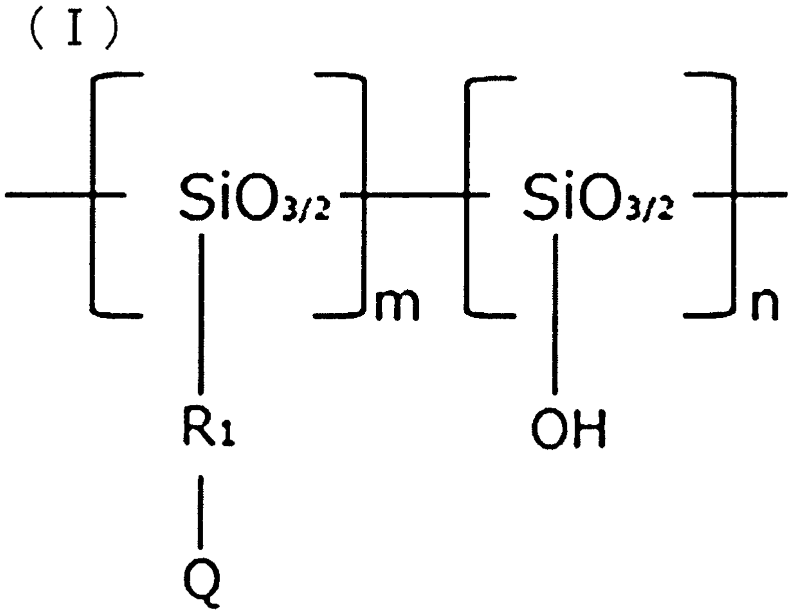

[Formula 53]

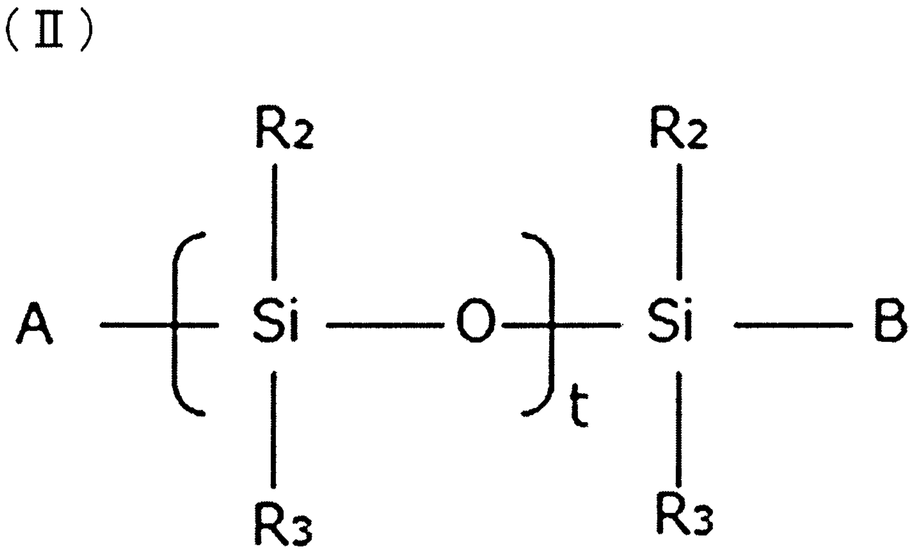

An example of a polymerizable functional group in groups Q, A, and B having a polymerizable functional group is a radical polymerizable functional group. Detailed examples of the radical polymerizable functional group are a (meth)acrylate-based compound, a (meth)acrylamide-based compound, a vinylbenzene-based compound, an aryl ether-based compound, a vinyl ether-based compound, and a maleimide-based compound. The group Q having a polymerizable functional group can be a group having the above-described polymerizable functional group.

A silicon-containing (meth)acrylate-based compound is a compound having one or more acryloyl groups or methacryloyl groups. Examples of a silicon-containing monofunctional (meth)acrylate-based compound having one acryloyl group or methacryloyl group are as follows, but the compound is not limited to these examples.

(2-acryloylethoxy)trimethylsilane,
N-(3-acryloyl-2-hydroxypropyl)-3-aminopropyltriethoxysilane,
acryloxymethyltrimethoxysilane,
(acryloxymethyl)phenethyltrimethoxysilane,

acryloxymethyltrimethylsilane,
(3-acryloxypropyl)dimethylmethoxysilane,
(3-acryloxypropyl)methylbis(trimethylsiloxy)silane,
(3-acryloxypropyl)methyldichlorosilane,
(3-acryloxypropyl)methyldiethoxysilane,
(3-acryloxypropyl)methyldimethoxysilane,
(3-acryloxypropyl)trichlorosilane,
(3-acryloxypropyl)trimethoxysilane,
(3-acryloxypropyl)tris(trimethylsiloxy)silane,
acryloxytriisopropylsilane,
acryloxytrimethylsilane,
methacryloxymethyltrimethoxysilane,
O-(methacryloxyethoxy)carbamoylpropylmethyldimethoxysilane,
(methacryloxymethyl)bis(trimethylsiloxy)methylsilane,
N-(3-methacryloyl-2-hydroxypropyl)-3-aminopropyltriethoxysilane,
(methacryloxymethyl)methyldimethoxysilane,
(methacryloxymethyl)methyldiethoxysilane,
methacryloxymethyltriethoxysilane,
methacryloxypropyltrimethoxysilane,
methacryloylpropyltriisopropoxysilane,
O-(methacryloxyethyl)-N-(triethoxysilylpropyl) carbamate,
methacryloxypropylmethyldimethoxysilane,
methacryloxypropylmethyldiethoxysilane,
methacryloxypropyldimethylmethoxysilane,
methacryloxypropyldimethylethoxysilane,
(methacryloxymethyl)dimethylethoxysilane,
methacryloxypropyltriethoxysilane,
methacryloxypropylsilatrane,
methacryloxypentamethyldisiloxane,
(methacryloxymethyl)phenyldimethylsilane,
methacryloxytrimethylsilane,
methacryloxymethyltrimethylsilane,
(3-methacryloxy-2-hydroxypropoxypropyl)methyl bis(trimethylsiloxy)silane,
methacryloxypropylpentamethyldisiloxane,
O-(methacryloxyethyl)-3-[bis(trimethylsiloxy)methylsilyl]propylcarbamate,
methacryloxymethyltris(trimethylsiloxy)silane,
methacryloxyethoxytrimethylsilane,
(3-methacryloxy-2-hydroxypropoxypropyl)methyl bis(trimethylsiloxy)silane,
methacryloxypropyltris(vinyldimethylsiloxy)silane,
methacryloxypropyltris(trimethylsiloxy)silane,
3-methacryloxypropyltriacetoxysilane,
methacryloxypropylmethyldichlorosilane,
methacryloxypropyltrichlorosilane,
3-methacryloxypropylbis(trimethylsiloxy)methylsilane,
3-methacryloxypropyldimethylchlorosilane,
O-methacryloxy(polyethyleneoxy)trimethylsilane,
poly(methacryloxypropylsilsesquioxane),
methacryloxypropylheptaisobutyl-T8-silsesquioxane, and
methacryloxypropyltris(trimethylsiloxy)silane

Examples of the commercially available products of the above-described silicon-containing monofunctional (meth)acrylic compounds are as follows, but the products are not limited to these examples.
SIA0160.0, SIA0180.0, SIA0182.0, SIA0184.0, SIA0186.0, SIA0190.0, SIA0194.0, SIA0196.0, SIA0197.0, SIA0198.0, SIA0199.0, SIA0200.0, SIA0200.A1, SIA0210.0, SIA0315.0, SIA0320.0, SIM6483.0, SIM6487.5, SIM6480.76, SIM6481.2, SIM6486.1, SIM6481.1, SIM6481.46, SIM6481.43, SIM6482.0, SIM6487.4, SIM6487.35, SIM6480.8, SIM6486.9, SIM6486.8, SIM6486.5, SIM6486.4, SIM6481.3, SIM6487.3, SIM6487.1, SIM6487.6, SIM6486.14, SIM6481.48, SIM6481.5, SIM6491.0, SIM6485.6, SIM6481.15, SIM6487.0, SIM6481.05, SIM6485.8, SIM6481.0, SIM6487.4LI, SIM6481.16, SIM6487.8, SIM6487.6HP, SIM6487.17, SIM6486.7, SIM6487.2, SIM6486.0, SIM6486.2,

SIM6487.6-06, SIM6487.6-20, SIM6485.9, SST-R8C42, SLT-3R01, and SIM6486.65 (manufactured by GELEST), and TM-0701T, FM-0711, FM-0721, and FM-0725 (manufactured by JNC)

A silicon-containing (meth)acrylamide-based compound is a compound having one or more acrylamide groups or methacrylamide groups. Examples of a silicon-containing monofunctional (meth)acrylamide-based compound having one acrylamide group or methacrylamide group are as follows, but the compound is not limited to these examples.

3-acrylamidopropyltrimethoxysilane, and 3-acrylamidopropyltris(trimethylsiloxy)silane

Examples of the commercially available products of the above-described silicon-containing monofunctional (meth)acrylamide compounds are as follows, but the products are not limited to these examples.

SIA0146.0, and SIA0150.0 (manufactured by GELEST)

Examples of a polyfunctional (meth)acrylate-based compound having two or more acryloyl groups or methacryloyl groups are as follows, but the compound is not limited to these examples.

linear polydimethylsiloxane modified on both ends with acryloxypropyl groups, linear polydimethylsiloxane modified on both ends with methacryloxypropyl groups,
cyclic siloxane modified with multiple acryloxypropyl groups,
cyclic siloxane modified with multiple methacryloxypropyl groups,
silsesquioxane modified with multiple acryloxypropyl groups, and
silsesquioxane modified with multiple methacryloxypropyl groups

Examples of the commercially available products of the above-described silicon-containing polyfunctional (meth)acrylate compounds are as follows, but the products are not limited to these examples.

SIA0200.2, SIA0200.3, SIM6487.42, DMS-R11, DMS-R05, DMS-R22, DMS-R18, DMS-R31 (manufactured by GELEST),
FM-7711, FM-7721, FM-7725 (manufactured by JNC),
X-22-2445 (manufactured by Shin-Etsu Chemical), and
AC-SQ TA-100, MAC-SQ TM-100, AC-SQ SI-20, MAC-SQ SI-20
(manufactured by TOAGOSEI)

Also, according to, for example, known literature 1, the following can be synthesized and/or obtained.

linear modified polydimethylsiloxane with methacryloxypropyl groups on both ends (MA-Si-12), 8-membered ring siloxane modified with four methacryloxypropyl groups (8-ring), and 10-membered ring siloxane modified with five methacryloxypropyl groups (10-ring).
Known Literature 1: "Ultraviolet curable branched siloxanes as low-k dielectric for imprint lithography" by Ogawa et al.

The blending ratio of the component (a) in the curable composition (A) is preferably 40 wt% or more and 99 wt% or less with respect to the sum of the component (a), a component (b) (to be described later), and a component (c) (to be described later), that is, the total mass of all the components except the solvent (d). The blending ratio is more preferably 50 wt% or more and 95 wt% or less, and further preferably 60 wt% or more and 90 wt% or less. When the blending ratio of the component (a) is 40 wt% or more, the mechanical strength of the cured film of the curable composition increases. Also, when the blending ratio of the component (a) is 99 wt% or less, it is possible to increase the blending ratios of the components (b) and (c), and obtain characteristics such as a high photopolymerization rate. At least a part of the component (a) including one or more types of polymerizable compounds can be polymers having a polymerizable functional group. A polymer like this preferably contains at least a cyclic structure such as an aromatic structure, an aromatic heterocyclic structure, or an alicyclic structure. For example, the polymer preferably contains at least one of constituent units represented by structures (1) to (6) below:

[Formula 54]

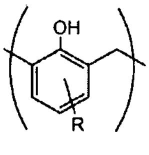 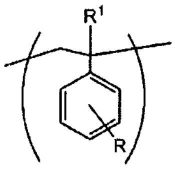 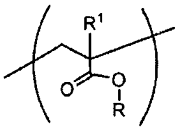 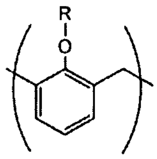 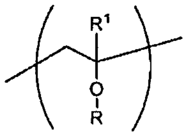 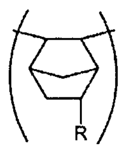

(1) (2) (3) (4) (5) (6)

In the structures (1) to (6), a substituent group R is a substituent group containing partial structures each independently containing an aromatic ring, and R1 is a hydrogen atom or a methyl group. In this specification, in constituent units represented by the structures (1) to (6), a portion other than R is the main chain of a specific polymer. The formula weight of the substituent group R is 80 or more, preferably 100 or more, more preferably 130 or more, and further preferably 150 or more. The upper limit of the formula weight of the substituent group R is practically 500 or less.

A polymer having a polymerizable functional group is normally a compound having a weight-average molecular weight of 500 or more. The weight-average molecular weight is preferably 1,000 or more, and more preferably 2,000 or more. The upper limit of the weight-average molecular weight is not particularly determined, but is preferably, for example, 50,000 or less. When the weight-average molecular weight is set at the above-described lower limit or more, it is possible to set the boiling point at 250°C or more, and further improve the mechanical properties after curing. Also, when the weight-average molecular weight is set at the above-described upper limit or less, the solubility to the solvent increases, and the flowability of discretely arranged droplets is maintained because the viscosity is not too high. This makes it possible to further improve the flatness of the liquid film surface. Note that the weight-average molecular weight (Mw) in the present invention is a molecular weight measured by gel permeation chromatography (GPC) unless it is specifically stated otherwise.

Practical examples of the polymerizable functional group of the polymer are a (meth)acryloyl group, an epoxy group, an oxetane group, a methylol group, a methylol ether group, and a vinyl ether group. A (meth)acryloyl group is particularly favorable from the viewpoint of polymerization easiness.

When adding the polymer having the polymerizable functional group as at least a part of the component (a), the blending ratio can freely be set as long as the blending ratio falls within the range of the viscosity regulation to be described later. For example, the blending ratio to the total mass of all the components except for the solvent (d) is preferably 0.1 wt% or more and 60 wt% or less, more preferably 1 wt% or more and 50 wt% or less, and further preferably 10 wt% or more and 40 wt% or less. When the blending ratio of the polymer having the polymerizable functional group is set at 0.1 wt% or more, it is possible to improve the heat resistance, the dry etching resistance, the mechanical strength, and the low volatility. Also, when the blending ratio of the polymer having the polymerizable functional group is set at 60 wt% or less, it is possible to make the blending ratio fall within the range of the upper limit regulation of the viscosity (to be described later).

<Component (b): Photopolymerization Initiator>

The component (b) is a photopolymerization initiator. In this specification, the photopolymerization initiator is a compound that senses light having a predetermined wavelength and generates a polymerization factor (radical) described earlier. More specifically, the photopolymerization initiator is a polymerization initiator (radical generator) that generates a radical by light (infrared light, visible light, ultraviolet light, far-ultraviolet light, X-ray, a charged particle beam such as an electron beam, or radiation). The component (b) can be formed by only one type of a photopolymerization initiator, and can also be formed by a plurality of types of photopolymerization initiators.

Examples of the radical generator are as follows, but the radical generator is not limited to these examples.

2,4,5-triarylimidazole dimers that can have substituent groups, such as a 2-(o-chlorophenyl)-4,5-diphenylimidazole dimer, a 2-(o-chlorophenyl)-4,5-di(methoxyphenyl)imidazole dimer, a 2-(o-fluorophenyl)-4,5-diphenylimidazole dimer, and a 2-(o- or p-methoxyphenyl)-4,5-diphenylimidazole dimer; benzophenone derivatives such as benzophenone, N,N'-tetramethyl-4,4'-diaminobenzophenone (Michiler's ketone), N,N'-tetraethyl-4,4'-diaminobenzophenone, 4-methoxy-4'-dimethylaminobenzophenone, 4-chlorobenzophenone, 4,4'-dimethoxybenzophenone, and 4,4'-diaminobenzophenone; $\alpha$-amino aromatic ketone derivatives such as 2-benzyl-2-dimethylamino-1-(4-morpholinophenyl)-butanone-1,2-methyl-1-[4-(methylthio)phenyl]-2-morpholino-propane-1-one; quinones such as 2-ethylanthraquinone, phenanthrenequinone, 2-t-butylanthraquinone, octamethylanthraquinone, 1,2-benzanthraquinone, 2,3-benzanthraquinone, 2-phenylanthraquinone, 2,3-diphenylanthraquinone, 1-chloroanthraquinone, 2-methylanthraquinone, 1,4-napthoquinone, 9,10-phenanthraquinone, 2-methyl-1,4-napthoquinone, and 2,3-dimethylanthraquinone; benzoin ether derivatives such as benzoin methyl ether, benzoin ethyl ether, and benzoin phenyl ether; benzoin derivatives such as benzoin, methyl

benzoin, ethyl benzoin, and propyl benzoin; benzyl derivatives such as benzyldimethylketal; acridine derivatives such as 9-phenylacridine and 1,7-bis(9,9'-acrydinyl)heptane; N-phenylglycine derivatives such as N-phenylglycine; acetophenone derivatives such as acetophenone, 3-methylacetophenone, acetophenone benzylketal, 1-hydroxycyclohexyl phenylketone, and 2,2-dimethoxy-2-phenyl acetophenone; thioxanthone derivatives such as thioxanthone, diethylthioxanthone, 2-isopropylthioxanthone, and 2-chlorothioxanthone; acylphosphine oxide derivatives such as 2,4,6-trimethylbenzoyldiphenylphosphine oxide, bis(2,4,6-trimethylbenzoyl)phenylphosphine oxide, and bis-(2,6-dimethoxybenzoyl)-2,4,4-trimethylpentylphosphine oxide; oxime ester derivatives such as 1,2-octanedione, 1-[4-(phenylthiol)-,2-(O-benzoyloxime)], ethanone, 1-[9-ethyl-6-(2-methylbenzoyl)-9H-carbazole-3-yl]-, and 1-(O-acetyloxime); and xanthone, fluorenone, benzaldehyde, fluorene, anthraquinone, triphenylamine, carbazole, 1-(4-isopropylphenyl)-2-hydroxy-2-methylpropane-1-one, and 2-hydroxy-2-methyl-1-phenylpropane-1-one.

Examples of commercially available products of the above-described radical generators are as follows, but the products are not limited to these examples.

Irgacure 184, 369, 651, 500, 819, 907, 784, and 2959, CGI-1700, -1750, and -1850, CG24-61, Darocur 1116 and 1173, Lucirin® TPO, LR8893, and LR8970 (manufactured by BASF), and Ubecryl P36 (manufactured by UCB).

Of the above-described radical generators, the component (b) is preferably an acylphosphine oxide-based polymerization initiator. Note that of the above-described radical generators, the acylphosphine oxide-based polymerization initiators are as follows.

Acylphosphine oxide compounds such as 2,4,6-trimethylbenzoyl diphenylphosphine oxide, bis(2,4,6-trimethylbenzoyl)phenylphosphine oxide, and bis(2,6-dimethoxybenzoyl)-2,4,4-trimethylpentylphosphine oxide.

The blending ratio of the component (b) in the curable composition (A) is preferably 0.1 wt% or more and 50 wt% or less with respect to the sum of the component (a), the component (b), and a component (c) (to be described later), that is, the total mass of all the components except for the solvent (d). Also, the blending ratio of the component (b) in the curable composition (A) is more preferably 0.1 wt% or more and 20 wt% or less, and further preferably 1 wt% or more and 20 wt% or less with respect to the total mass of all the components except for the solvent (d). When the blending ratio of the component (b) is set at 0.1 wt% or more, the curing rate of the composition increases, so the reaction efficiency can be improved. Also, when the blending ratio of the component (b) is set at 50 wt% or less, a cured film having mechanical strength to some extent can be obtained.

<Component (c): Nonpolymerizable Compound>

In addition to the components (a) and (b) described above, the curable composition (A) according to the present invention can further contain a nonpolymerizable compound as the component (c) within a range that does not impair the effect of the present invention. An example of the component (c) is a compound that does not contain a polymerizable functional group such as a (meth)acryloyl group, and does not have the ability to sense light having a predetermined wavelength and generate the polymerization factor (radical) described previously. Examples of the nonpolymerizable compound are a sensitizer, a hydrogen donor, a surfactant (c1), an antioxidant, a polymer component, and other additives. The component (c) can contain a plurality of types of the above-described compounds.

The sensitizer is a compound that is properly added for the purpose of promoting the polymerization reaction and improving the reaction conversion rate. As the sensitizer, it is possible to use one type of a compound alone, or to use two or more types of compounds by mixing them.

An example of the sensitizer is a sensitizing dye. The sensitizing dye is a compound that is excited by absorbing light having a specific wavelength and has an interaction with a photopolymerization initiator as the component (b). The "interaction" herein mentioned is energy transfer or electron transfer from the sensitizing dye in the excited state to the photopolymerization initiator as the component (b). Practical examples of the sensitizing dye are as follows, but the sensitizing dye is not limited to these examples.

An anthracene derivative, an anthraquinone derivative, a pyrene derivative, a perylene derivative, a carbazole derivative, a benzophenone derivative, a thioxanthone derivative, a xanthone derivative, a coumarin derivative, a phenothiazine derivative, a camphorquinone derivative, an acridinic dye, a thiopyrylium salt-based dye, a merocyanine-based dye, a quinoline-based dye, a styryl quinoline-based dye, a ketocoumarin-based dye, a thioxanthene-based dye, a xanthene-based dye, an oxonol-based dye, a cyanine-based dye, a rhodamine-based dye, and a pyrylium salt-based dye.

The hydrogen donor is a compound that reacts with an initiation radical generated from the photopolymerization initiator as the component (b) or a radical at a polymerization growth end, and generates a radical having higher reactivity. The hydrogen donor is preferably added when the photopolymerization initiator as the component (b) is a photo-radical generator.

Practical examples of the hydrogen donor as described above are as follows, but the hydrogen donor is not limited to these examples.

Amine compounds such as n-butylamine, di-n-butylamine, tri-n-butylphosphine, allylthiourea, s-benzylisothiuronium-p-toluenesulfinate, triethylamine, diethylaminoethyl methacrylate, triethylenetetramine, 4,4'-bis(dialkylamino) benzophenone, N,N-dimethylamino ethylester benzoate, N,N-dimethylamino isoamylester benzoate, pentyl-4-dimethylamino benzoate, triethanolamine, and N-phenylglycine; and mercapto compounds such as 2-mercapto-N-phenylbenzoimidazole and mercapto propionate ester.

It is possible to use one type of a hydrogen donor alone, or to use two or more types of hydrogen donors by mixing them. The hydrogen donor can also have a function as a sensitizer.

In the present invention, the surfactant (c1) is added to the curable composition (A) for the purpose of suppressing extrusion and oozing. The surfactant (c1) also functions as an internal mold release agent that reduces the interface bonding force between a mold and the curable composition, that is, reduces the mold release force in a mold release step (to be described later). In this specification, "internal" means that the mold release agent is added to the curable composition in advance before a curable composition arranging step. As the surfactant (c1), it is possible to use surfactants such as a silicon-based surfactant, a fluorine-based surfactant, and a hydrocarbon-based surfactant. In the present invention, however, the addition amount of the surfactant (c1) is limited, as will be described later. Note that the surfactant (c1) according to the present invention is not polymerizable. It is possible to use one type of a surfactant (c1) alone, or to use two or more types of surfactants (c1) by mixing them.

The fluorine-based surfactant includes the following.

A polyalkylene oxide (for example, polyethylene oxide or polypropylene oxide) adduct of alcohol having a perfluoroalkyl group, and a polyalkylene oxide (for example, polyethylene oxide or polypropylene oxide) adduct of perfluoropolyether.

Note that the fluorine-based surfactant can have a hydroxyl group, an alkoxy group, an alkyl group, an amino group, or a thiol group in a portion (for example, a terminal group) of the molecular structure. An example is pentadecaethyleneglycol mono1H,1H,2H,2H-perfluorooctylether.

It is also possible to use a commercially available product as the fluorine-based surfactant. Examples of the commercially available product of the fluorine-based surfactant are as follows.

MEGAFACE® F-444, TF-2066, TF-2067, and TF-2068, and DEO-15 (abbreviation) (manufactured by DIC); Fluorad FC-430 and FC-431 (manufactured by Sumitomo 3M); Surflon® S-382 (manufactured by AGC); EFTOP EF-122A, 122B, 122C, EF-121, EF-126, EF-127, and MF-100 (manufactured by Tochem Products); PF-636, PF-6320, PF-656, and PF-6520 (manufactured by OMNOVA Solutions); UNIDYNE® DS-401, DS-403, and DS-451 (manufactured by DAIKIN); and FUTAGENT® 250, 251, 222F, and 208G (manufactured by NEOS).

The surfactant (c1) can also be a hydrocarbon-based surfactant. The hydrocarbon-based surfactant includes an alkyl alcohol polyalkylene oxide adduct obtained by adding alkylene oxide having a carbon number of 2 to 4 to alkyl alcohol having a carbon number of 1 to 50, and polyalkylene oxide.

Examples of the alkyl alcohol polyalkylene oxide adduct are as follows.

A methyl alcohol ethylene oxide adduct, a decyl alcohol ethylene oxide adduct, a lauryl alcohol ethylene oxide adduct, a cetyl alcohol ethylene oxide adduct, a stearyl alcohol ethylene oxide adduct, and a stearyl alcohol ethylene oxide/propylene oxide adduct.

Note that the terminal group of the alkyl alcohol polyalkylene oxide adduct is not limited to a hydroxyl group that can be manufactured by simply adding polyalkylene oxide to alkyl alcohol. This hydroxyl group can also be substituted by a polar functional group such as a carboxyl group, an amino group, a pyridyl group, a thiol group, or a silanol group, or by a hydrophobic group such as an alkyl group or an alkoxy group.

Examples of polyalkylene oxide are as follows.

Polyethylene glycol, polypropylene glycol, their mono or dimethyl ether, mono or dioctyl ether, mono or dinonyl ether, and mono or didecyl ether, monoadipate, monooleate, monostearate, and monosuccinate.

A commercially available product can also be used as the alkyl alcohol polyalkylene oxide adduct. Examples of the commercially available product of the alkyl alcohol polyalkylene oxide adduct are as follows.

Polyoxyethylene methyl ether (a methyl alcohol ethylene oxide adduct) (BLAUNON MP-400, MP-550, and MP-1000) manufactured by AOKI OIL INDUSTRIAL, polyoxyethylene decyl ether (a decyl alcohol ethylene oxide adduct) (FINESURF D-1303, D-1305, D-1307, and D-1310) manufactured by AOKI OIL INDUSTRIAL, polyoxyethylene lauryl ether (a lauryl alcohol ethylene oxide adduct) (BLAUNON EL-1505) manufactured by AOKI OIL INDUSTRIAL, polyoxyethylene cetyl ether (a cetyl alcohol ethylene oxide adduct) (BLAUNON CH-305 and CH-310) manufactured by AOKI OIL INDUSTRIAL, polyoxyethylene stearyl ether (a stearyl alcohol ethylene oxide adduct) (BLAUNON SR-705, SR-707, SR-715, SR-720, SR-730, and SR-750) manufactured by AOKI OIL INDUSTRIAL, randomly polymerized polyoxyethylene polyoxypropylene stearyl ether (BLAUNON SA-50/50 1000R and SA-30/70 2000R) manufactured by AOKI OIL INDUSTRIAL, polyoxyethylene methyl ether (Pluriol® A760E) manufactured by BASF, and polyoxyethylene alkyl ether (EMULGEN series) manufactured by KAO.

A commercially available product can also be used as polyalkylene oxide. An example is an ethylene oxide/propylene oxide copolymer (Pluronic PE6400) manufactured by BASF.

Also, the surfactant (c1) may be a silicone surfactant. Examples of a silicone surfactant are product name SI-10

series (manufactured by TAKEMOTO OIL & FAT), MEGAFACE Paintad 31 (manufactured by DIC), and KP-341 (manufactured by Shin-Etsu Chemical).

The surfactant (c1) may contain at least both fluorine atoms and silicone atoms. Examples of the surfactant containing both fluorine atoms and silicone atoms are as follows.

Product names X-70-090, X-70-091, X-70-092, X-70-093 (manufactured by Shin-Etsu Chemical), and product names MEGAFACE R-08 and XRB-4 (manufactured by DIC)

The blending ratio of the component (c) in the curable composition (A) except for the surfactant is preferably 0.01 wt% or more and 50 wt% or less with respect to the sum of the components (a), (b), and (c), that is, the total mass of all the components except for the solvent (d). The blending ratio of the component (c) in the curable composition (A) except for the surfactant is more preferably 0.01 wt% or more and 50 wt% or less, and further preferably 0.01 wt% or more and 20 wt% or less with respect to the total mass of all the components except for the solvent (d). When the blending ratio of the component (c) except for the surfactant is set at 50 wt% or less, a cured film having mechanical strength to some extent can be obtained.

The upper limit of the blending ratio of the surfactant (c1) according to the present invention is decided from the surface tension of a composition obtained by removing the solvent (d) from the curable composition (A) and contact angles to the surface of the substrate and the surface of the mold, as will be described later. When the blending ratio of the surfactant (c1) is set to 0.01 wt% or more, the effect of the present invention can be obtained.

<Component (d): Solvent>

The curable composition according to the present invention contains a solvent having a boiling point of 100°C or more and less than 250°C at normal pressure as the component (d). The component (d) is a solvent that dissolves the components (a), (b), and (c). Examples are an alcohol-based solvent, a ketone-based solvent, an ether-based solvent, an ester-based solvent, and a nitrogen-containing solvent. As the component (d), it is possible to use one type of a component alone, or to use two or more types of components by combining them. The boiling point at normal pressure of the component (d) is 100°C or more, preferably 140°C or more, and particularly preferably 150°C or more. The boiling point at normal pressure of the component (d) is less than 250°C, and preferably less than 200°C. If the boiling point of the component (d) at normal pressure is less than 100°C, the volatilization speed in the waiting step to be described later is too high. For this reason, the component (d) may volatilize before the droplets of the curable composition (A) bond to each other, and the droplets of the curable composition (A) may not bond to each other. Also, if the boiling point at normal pressure of the component (d) is 250°C or more, it is possible that the volatilization of the solvent (d) is insufficient in the waiting step to be described later, so the component (d) remains in the cured product of the curable composition (A). Here, if the component (d) includes one or more types of solvents, the boiling point of each of the one or more types of solvents at normal pressure is preferably 100°C or more and less than 250°C (for example, 100°C or more and less than 200°C).

Examples of the alcohol-based solvent are as follows.

Monoalcohol-based solvents such as methanol, ethanol, n-propanol, isopropanol, n-butanol, iso-butanol, sec-butanol, tert-butanol, n-pentanol, isopentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethylheptanol-4, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; and polyalcohol-based solvents such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin.

Examples of the ketone-based solvent are as follows.

Acetone, methylethylketone, methyl-n-propylketone, methyl-n-butylketone, diethylketone, methyl-iso-butylketone, methyl-n-pentylketone, ethyln-butylketone, methyl-n-hexylketone, di-iso-butylketone, trimethylnonanon, cyclohexanone, methylcyclohexanone, 2,4-pentanedione, acetonylacetone, diacetone alcohol, acetophenone, and fenchone.

Examples of the ether-based solvent are as follows.

Ethyl ether, iso-propyl ether, n-butyl ether, n-hexyl ether, 2-ethylhexyl ether, ethylene oxide, 1,2-propylene oxide, dioxolane, 4-methyldioxolane, dioxane, dimethyldioxane, 2-methoxyethanol, 2-ethoxyethanol, ethylene glycol diethyl ether, 2-n-butoxyethanol, 2-n-hexoxyethanol, 2-phenoxyethanol, 2-(2-ethylbutoxy)ethanol, ethylene glycol dibutyl ether, diethylene glycol monomethyl ether, diethylene glycol monoethyl ether, diethylene glycol diethyl ether, diethylene glycol mono-n-butyl ether, diethylene glycol di-n-butyl ether, diethylene glycol mono-n-hexyl ether, ethoxy triglycol, tetraethylene glycol di-n-butyl ether, 1-n-butoxy-2-propanol, 1-phenoxy-2-propanol, propylene glycol monomethyl ether, propylene glycol monoethyl ether, propylene glycol monopropyl ether, dipropylene glycol monomethyl ether, dipropylene glycol monoethyl ether, dipropylene glycol monopropyl ether, tripropylene glycol monomethyl ether, tetrahydrofuran, and 2-methyltetrahydrofuran.

Examples of the ester-based solvent are as follows.

Diethyl carbonate, methyl acetate, ethyl acetate, amyl acetate, γ-butyrolactone, γ-valerolactone, n-propyl acetate, iso-propyl acetate, n-butyl acetate, iso-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, iso-amyl propionate, diethyl oxalate, di-n-butyl oxalate, methyl lactate, ethyl lactate, n-butyl lactate, n-amyl lactate, diethyl malonate, dimethyl phthalate, and diethyl phthalate.

Examples of the nitrogen-containing solvent are as follows.

N-methylformamide, N,N-dimethylformamide, N,N-diethylformamide, acetamide, N-methylacetamide, N,N-dimethylacetamide, N-methylpropionamide, and N-methylpyrrolidone.

Of the above-described solvents, the ether-based solvent and the ester-based solvent are favorable. Note that an ether-based solvent and an ester-based solvent each having a glycol structure are more favorable from the viewpoint of good film formation properties.

Further favorable examples of the solvent are as follows.

Propylene glycol monomethyl ether, propylene glycol monoethyl ether, propylene glycol monopropyl ether, propylene glycol monomethyl ether acetate, propylene glycol monoethyl ether acetate, and propylene glycol monopropyl ether acetate.

A particularly favorable example is propylene glycol monomethyl ether acetate. Note that ethyl)isocyanurate di(meth)acrylate is also favorable.

In the present invention, a favorable solvent is a solvent having at least one of an ester structure, a ketone structure, a hydroxyl group, and an ether structure. More specifically, a favorable solvent is one solvent or a solvent mixture selected from propylene glycol monomethyl ether acetate (boiling point = 146°C), propylene glycol monomethyl ether, cyclohexanone, 2-heptanone, γ-butyrolactone, and ethyl lactate.

In the present invention, a polymerizable compound having a boiling point of 80°C or more and less than 250°C at normal pressure is also usable as the component (d). Examples of the polymerizable compound having a boiling point of 80°C or more and less than 250°C at normal pressure are as follows.

Cyclohexyl acrylate (boiling point = 198°C), benzyl acrylate (boiling point = 229°C), isobornyl acrylate (boiling point = 245°C), tetrahydrofurfuryl acrylate (boiling point = 202°C), trimethylcyclohexyl acrylate (boiling point = 232°C), isooctyl acrylate (217°C), n-octyl acrylate (boiling point = 228°C), ethoxyethoxyethyl acrylate (boiling point = 230°C), divinylbenzene (boiling point = 193°C), 1,3-diisopropenylbenzene (boiling point = 218°C), styrene (boiling point = 145°C), and α-methylstyrene (boiling point = 165°C).

In the present invention, when the whole of the curable composition (A) is 100 vol%, the content of the solvent (d) is more than 5 vol% and 95 vol% or less, preferably 15 vol% or more and 85 vol% or less, and further preferably 40 vol% or more and 80 vol% or less. For example, the content of the solvent (d) is 40 vol% or more and 85 vol% or less. If the content of the solvent (d) is smaller than 5 vol%, it is impossible to obtain a thin film after the solvent (d) volatilized under the condition that a practically continuous liquid film can be obtained. Also, if the content of the solvent (d) is larger than 95 vol%, it is impossible to obtain a thick film after the solvent (d) volatilized even when droplets are closely dropped by an inkjet method.

<Temperature When Blending Curable Composition>

When preparing the curable composition (A) according to the present invention, at least the components (a), (b), and (d) are mixed and dissolved under a predetermined temperature condition. The predetermined temperature condition is 0°C or more and 100°C or less. Note that the same applies to a case in which the curable composition (A) contains the component (c).

<Viscosity of Curable Component>

The curable composition (A) according to the present invention is a liquid. This is so because droplets of the curable composition (A) are discretely dropped on a substrate by an inkjet method. The viscosity of the curable composition (A) according to the present invention is 1.3 mPa·s or more and 60 mPa·s or less at 23°C and at 1 atm, preferably 2 mPa·s or more and 30 mPa·s or less, and more preferably 5 mPa·s or more and 15 mPa·s or less. If the viscosity of the curable composition (A) is smaller than 2 mPa·s, the discharge property of droplets by an inkjet method is unstable. Also, if the viscosity of the curable composition (A) is larger than 60 mPa·s, it is impossible to form droplets having

a volume of about 1.0 to 3.0 pL favorable in the present invention.

The viscosity in a state in which the solvent (d) volatilized from the curable composition (A), that is, the viscosity of a mixture of components except for the solvent (d) of the curable composition (A) at 23°C and at 1 atm is 30 mPa·s or more and 10,000 mPa·s or less. The viscosity of the mixture of components except for the solvent (d) of the curable composition (A) at 23°C and at 1 atm is preferably 90 mPa·s or more and 2,000 mPa·s or less, for example, 120 mPa·s or more and 1,000 mPa·s or less. Also, the viscosity of the mixture of components except for the solvent (d) of the curable composition (A) at 23°C and at 1 atm is further preferably 150 mPa·s or more and 500 mPa·s or less. When the viscosity of the components except for the solvent (d) of the curable composition (A) is set to 1,000 mPa·s or less, spreading and filling are rapidly completed when bringing the curable composition (A) into contact with a mold. Accordingly, the use of the curable composition (A) according to the present invention makes it possible to perform an imprinting process at high throughput, and suppress pattern defects caused by insufficient filling. Also, when the viscosity of components except for the solvent (d) of the curable composition (A) is set to 1 mPa·s or more, it is possible to prevent an unnecessary flow of droplets of the curable composition (A) after the solvent (d) volatilized. Furthermore, when bringing the curable composition (A) into contact with a mold, the curable composition (A) does not easily flow out from the end portions of the mold.

<Surface Tension of Curable Composition>

The surface tension $\gamma 1$ in a state in which the solvent (d) volatilizes from the curable composition (A) according to the present invention is preferably 5 mN/m or more and 70 mN/m or less at 23°C and at 1 atm. Also, the surface tension of the composition containing the components except for the solvent (component (d)) is more preferably 7 mN/m or more and 50 mN/m or less at 23°C and at 1 atm, and further preferably 10 mN/m or more and 40 mN/m or less. Note that when the surface tension is high, for example, 5 mN/m or more, the capillarity strongly acts, so filling (spreading and filling) is complete within a short time period when the curable composition (A) and a mold are brought into contact with each other. Also, when the surface tension is 70 mN/m or less, a cured film obtained by curing the curable composition has surface smoothness.

In the present invention, if the surface tension of the curable composition in a state in which the solvent (d) is removed is $\gamma 1$ (mN/m), and the surface tension of the solvent (d) at 23°C is $\gamma 2$ (mN/m), the curable composition is configured such that $\gamma 1$ is larger than $\gamma 2$. In other words, when $\Delta\gamma = \gamma 1 - \gamma 2$, the curable composition is configured such that $\Delta\gamma$ is larger than zero. More specifically, the solvent (d) is selected such that $\Delta\gamma$ is larger than zero. If $\Delta\gamma$ is larger than zero, in the waiting step to be described later, spread of each droplet of the curable composition is accelerated by the Marangoni effect, and the droplets quickly bond to each other to form a continuous liquid film. In addition, since volatilization of the solvent is accelerated by the quick spread of the droplets, the waiting step to be described later is completed in a short time, or the conditions of a baking step are relaxed or omitted. $\Delta\gamma$ is preferably 0.1 or more, particularly preferably 1.0 or more, and further preferably 2.0 or more. Note that $\gamma 1$ and $\gamma 2$ are each a surface tension at normal pressure.

<Contact Angle of Curable Composition>

Concerning the composition of components except for the solvent (component (d)), the contact angle of the curable composition (A) according to the present invention is preferably 0° or more and 90° or less with respect to both the surface of a substrate and the surface of a mold. If the contact angle is larger than 90°, the capillarity acts in a negative direction (a direction in which the contact interface between the mold and the curable composition is shrunk) inside a pattern of the mold or in a gap between the substrate and the mold, and the curable composition (A) may not be filled in the mold. When the contact angle is small, the capillarity strongly acts, and the filling speed increases.

Concerning the contact angle of the curable composition (A) according to the present invention, the contact angle of the composition of components except for the solvent (component (d)) and the surfactant (c1) with respect to the surface of the substrate is defined as $\alpha 1$ [°], and the contact angle of the composition of components except for the solvent (component (d)) with respect to the surface of the substrate is defined as $\alpha 2$ [°]. In this case, the type and amount of the surfactant (c1) are selected such that $\alpha 2$ is larger than $\alpha 1$. More specifically, when the surfactant (c1) is selected such that $\alpha 2$ is larger than $\alpha 1$, the pinning effect is exhibited to the spread of droplets, the spread of droplets on the substrate can be stopped in a desired size, and the extrusion amount of the curable composition can be suppressed.

Also, concerning the contact angle of the curable composition (A) according to the present invention, when the contact angle of the composition of components except for the solvent (component (d)) is defined as $\beta$ [°] with respect to the surface of the mold, the type and amount of the surfactant (c1) are selected such that $\beta$ is 25° or more. More specifically, when the surfactant (c1) is selected such that $\beta$ is 25° or more, the pinning effect is exhibited to the spread of droplets, and oozing can be suppressed. $\beta$ is preferably 30° or more, and more preferably 40° or more.

<Impurities Mixed in Curable Composition>

The curable composition (A) according to the present invention preferably contains impurities as little as possible. Note that impurities mean components other than the components (a), (b), (c), and (d) described above. Therefore, the curable composition (A) according to the present invention is favorably a composition obtained through a refining step. A refining step like this is preferably filtration using a filter.

As this filtration using a filter, it is favorable to mix the components (a), (b), and (c) described above, and filtrate the mixture by using, for example, a filter having a pore diameter of 0.001 μm or more and 5.0 μm or less. When performing filtration using a filter, it is further favorable to perform the filtration in multiple stages, or to repetitively perform the filtration a plurality of times (cycle filtration). It is also possible to re-filtrate a liquid once filtrated through a filter, or perform filtration by using filters having different pore diameters. Examples of the filter for use in filtration are filters made of, for example, a polyethylene resin, a polypropylene resin, a fluorine resin, and a nylon resin, but the filter is not particularly limited. Impurities such as particles mixed in the curable composition can be removed through the refining step as described above. Consequently, it is possible to prevent impurities mixed in the curable composition from causing pattern defects by forming unexpected unevenness on a cured film obtained after the curable composition is cured.

Note that when using the curable composition according to the present invention in order to fabricate a semiconductor integrated circuit, it is favorable to avoid mixing of impurities (metal impurities) containing metal atoms in the curable composition as much as possible so as not to obstruct the operation of a product. The concentration of the metal impurities contained in the curable composition is preferably 10 ppm or less, and more preferably 100 ppb or less.

<Glass Transition Temperature of Curable Composition>

If a glass transition temperature is much higher than the temperature at the time of mold release, the cured product at the time of mold release exhibits a firm glass state, that is, a high mechanical strength, and therefore, pattern collapse or breakage due to impact of mold release hardly occurs. Hence, when executing the mold release step at room temperature, the glass transition temperature of the cured product (after curing of the polymerizable compound (a)) is preferably 70°C or more, more preferably 100°C or more, and particularly preferably 150°C or more.

As a method of measuring the glass transition temperature of the cured product (photocured product), a method of performing measurement using differential scanning calorimetry (DSC) or a dynamic viscoelasticity measuring apparatus can be applied. For example, consider a case where the glass transition temperature is measured using DSC. In this case, a line obtained by extending the baseline of the DSC curve of a cured product on the low temperature side (a DSC curve portion in a temperature region where neither transition nor reaction occurs in a test piece) to the high temperature side and a tangent drawn at a point where the gradient of the curve of the stepwise change portion of glass transition is maximum are obtained. From the intersection between the line and the tangent, an extrapolated glass transition start temperature (Tig) is obtained, and this can be obtained as the glass transition temperature. An example of a major apparatus is STA-6000 (manufactured by Perkin Eimer). On the other hand, when measuring the glass transition temperature using a dynamic viscoelasticity measuring apparatus, a temperature at which the loss sine (tanδ) of the cured product is maximum is defined as the glass transition temperature. An example of a major apparatus for measuring dynamic viscoelasticity is MCR301 (manufactured by Anton Paar).

[Substrate]

In this specification, a member on which droplets of the curable composition (A) are discretely dropped is explained as a substrate.

This substrate is a substrate to be processed, and a silicon wafer is normally used. The substrate can have a layer to be processed on the surface. On the substrate, another layer can also be formed below the layer to be processed. When a quartz substrate is used as the substrate, a replica (replica mold) of a mold for imprinting can be manufactured. However, the substrate is not limited to a silicon wafer or a quartz substrate. The substrate can freely be selected from those known as semiconductor device substrates such as aluminum, a titanium-tungsten alloy, an aluminum-silicon alloy, an aluminum-copper-silicon alloy, silicon oxide, and silicon nitride. Note that the surface of the substrate or the layer to be processed is preferably treated by a surface treatment such as a silane coupling treatment, a silazane treatment, or deposition of an organic thin film, thereby improving the adhesion to the curable composition (A). As a practical example of the organic thin film to be deposited as the surface treatment, an adhesive layer described in Japanese Patent Laid-Open No. 2009-503139 can be used.

[Pattern Forming Method]

The pattern forming method according to the present invention will be explained with reference to Figs. 1A to 1G.

The cured film formed by the present invention is preferably a film having a pattern with a size of 1 nm or more and 10 mm or less, and more preferably a film having a pattern with a size of 10 nm or more and 100 μm or less. Generally, a film forming method of forming a film having a pattern (uneven structure) of a nano size (1 nm or more and 100 nm or less) by using light is called a photoimprint method. The film forming method of the present invention forms a film of a curable composition in a space between a mold and a substrate by using the photoimprint method. However, the curable composition can also be cured by another energy (for example, heat or an electromagnetic wave). A film forming method according to the present invention can be performed as a method of forming a film having a pattern, that is, as a pattern forming method, and can also be performed as a method of forming a film (for example, a planarization film) having no pattern, that is, as a planarization film forming method.

An example in which the film forming method according to the present invention is applied to the pattern forming method will be explained below. The pattern forming method includes, for example, a forming step, an arranging step, a waiting step, a contact step, a curing step, and a mold release step. The forming step is a step of forming an underlayer. The arranging step is a step of discretely arranging droplets of the curable composition (A) on the underlayer. The waiting step is a step of waiting until the droplets of the curable composition (A) bond to each other and the solvent (d) volatilizes. The contact step is a step of bringing the curable composition (A) and a mold in contact with each other. The curing step is a step of curing the curable composition (A). The mold release step is a step of releasing the mold from the cured film of the curable composition (A). The arranging step is performed after the forming step, the waiting step is performed after the arranging step, the contact step is performed after the waiting step, the curing step is performed after the contact step, and the mold release step is performed after the curing step.

<Arranging Step>

In the arranging step, as schematically shown in Fig. 1A, droplets 102 of the curable composition (A) are discretely arranged on a substrate 101. In the arranging step, the droplets 102 of the curable composition (A) having a volume of 1.0 pL or more are arranged at a density of 80 droplets/$mm^2$ or more. As the substrate 101, a substrate on which an underlayer is stacked can also be used as the substrate 101. In addition, the adhesion of the surface of the substrate 101 with respect to the curable composition (A) can be improved by a surface treatment such as a silane coupling treatment, a silazane treatment, or deposition of an organic thin film.

An inkjet method is particularly favorable as the arranging method of arranging the droplets 102 of the curable composition (A) on the substrate. It is favorable to arrange the droplets 102 of the curable composition (A) densely on that region of the substrate 101, which faces a region in which recesses forming the pattern of a mold 106 densely exist, and sparsely on that region of the substrate 101, which faces a region in which recesses forming the pattern of the mold 106 sparsely exist. Consequently, a film (residual film) 109 (to be described later) of the curable composition (A) formed on the substrate 101 is controlled to have a uniform thickness regardless of the sparsity and density of the pattern of the mold 106.

An index called an average residual liquid film thickness is defined in order to prescribe the volume of the curable composition (A) to be arranged. The average residual liquid film thickness is a value obtained by dividing the volume of the curable composition (A) (except for the solvent (d)) to be arranged in the arranging step by the area of a film formation region of the mold. The volume of the curable composition (A) (except for the solvent (d)) is the sum total of the volumes of the individual droplets of the curable composition (A) after the solvent (d) volatilized. According to this definition, the average residual liquid film thickness can be prescribed regardless of the state of unevenness even when the substrate surface is uneven. Here, the average residual liquid film thickness may be understood as a value obtained by dividing the volume of the curable composition (A) remaining after the waiting step to be described later by the area of the film formation region of the mold, and is preferably 20 nm or less.

<Waiting Step>

In the present invention, the waiting step is provided after the arranging step and before the contact step. Here, a value obtained by dividing the total volume of the droplets of the curable composition (A) dropped in one-time pattern formation by the total area of regions (pattern formation regions) in which patterns are formed in one-time pattern formation is defined as an average initial liquid film thickness. In the waiting step, as schematically shown in Fig. 1B, the droplets 102 of the curable composition (A) spread on the substrate 101. Consequently, the whole pattern formation region of the substrate 101 is covered with the curable composition (A).

As described above, in the present invention, if the surface tension of the curable composition in a state in which the solvent (d) is removed is $\gamma 1$ [mN/m], and the surface tension of the solvent (d) is $\gamma 2$ [mN/m], the curable composition (A) is formed such that $\gamma 1$ is larger than $\gamma 2$. More specifically, since the solvent (d) is selected such that $\gamma 1$ is larger than $\gamma 2$, the droplets 102 of the curable composition (A) dropped on the substrate 101 largely spread (that is, the spreading speed of the droplets 102 increases). A factor for this will be described below.

Since the droplets of the curable composition (A) dropped on the substrate contain a volatile component, the

concentration of the volatile component changes due to volatilization after dropping. The surface tension γ1 of nonvolatile components is larger than the surface tension γ2 of the volatile component. For this reason, if the concentration of the volatile component lowers along with the volatilization, the surface tension becomes large. In general, the dropped droplets gradually spread, and the spread of the droplets stops at a static contact angle. The spreading speed is high when the contact angle to the substrate at the end portion of the droplet is greatly different from the static contact angle. Also, since the thickness of the cured film is very thin as compared to the radius of the droplet, concentration diffusion in the radial direction is very slow as compared to concentration diffusion in the thickness direction.

The behavior of the droplet 102 of the curable composition (A) dropped on the substrate 101 (the behavior after dropping) will be described with reference to Fig. 2. Fig. 2 shows a state in which the droplet 102 dropped on the substrate spreads. As described above, volatilization of the solvent component progresses even during the spread of the droplet 102. The volatilization speed greatly depends on the surface area of the droplet 102. Comparing a center portion 303 of the droplet 102 and an end portion 304 of the droplet 102, since the surface area of the end portion 304 of the droplet 102 is slightly larger than the surface area of the center portion 303 of the droplet 102, volatilization progresses fast. On the other hand, the volume of the droplet 102 is smaller at the end portion 304 of the droplet 102 than at the center portion 303 of the droplet 102. Hence, at the end portion 304 of the droplet 102, volatilization progresses quickly and volume is small, as compared to the center portion 303 of the droplet 102. For this reason, the concentration of the volatilization component is lower, and the surface tension is higher. Thus, since the surface tension is higher at the end portion 304 of the droplet 102 than at the center portion 303 of the droplet 102, a force is generated from the center portion 303 of the droplet 102 to the end portion 304 by the Marangoni effect, and a flow (spread) of the droplet 102 is induced.

Fig. 3 is a view showing the shape of the droplet 102 in a case where the flow of the droplet 102 is induced by the Marangoni effect. If the flow of the droplet 102 is induced toward the end portion of the droplet 102, the droplet 102 obtains a shape with the end portions rising, as shown in Fig. 4. Thus, the contact angle between the end portion of the droplet 102 and the substrate 101 is larger than in a case where the flow of the droplet 102 is not induced, and the spread speed of the droplet 102 also increases.

Also, as described above, concerning the contact angle of the curable composition (A), the type and amount of the surfactant (c1) are selected such that α2 [°] is larger than α1 [°]. Here, α1 is the contact angle of the composition of components except for the solvent (component (d)) and the surfactant (c1) with respect to the surface of the substrate 101, and α2 is the contact angle of the composition of components except for the solvent (component (d)) with respect to the surface of the substrate 101. More specifically, since the surfactant (c1) is selected such that α2 is larger than α1, the pinning effect is exhibited to the spread of the droplet 102, the spread of the droplet 102 on the substrate can be stopped in a desired size, and the extrusion amount can be suppressed. A factor for this will be described below.

Fig. 4 is a view showing a state in which the droplet 102 of the curable composition (A) is dropped on the substrate 101. The droplet 102 dropped on the substrate 101 spreads while volatilizing. If the surfactant (c1) is not contained in the curable composition (A), the droplet 102 spreads up to the contact angle α1, as shown in Fig. 5. Particularly, if the contact angle α1 is close to zero, the droplet 102 continuously spreads to a large range. On the other hand, if the surfactant (c1) is contained in the curable composition (A), the droplet 102 dropped on the substrate 101 spreads such that the contact angle changes to α2 (α2 > α1), as shown in Fig. 6. Comparing Fig. 5 and Fig. 6, since the contact angle increases from α1 to α2 because of the surfactant (c1), pinning of the droplet 102 occurs in a region determined by the contact angle α2, and the spread can be stopped, the extrusion amount can be suppressed.

According to an example to be described later, for example, a case where the solvent (d) is a highly volatile solvent, the volume ratio of nonvolatile components is 20%, and the droplet pitch is 88 μm, that is, the average initial liquid film thickness is 13 nm or more is selected. In this case, as schematically shown in Fig. 1C, it is indicated by numerical calculation that the droplets of the curable composition (A') bond to each other on the substrate, and a practically continuous liquid film 103 is formed. Also, this means that the droplets of the curable composition (A) having a volume of 1.0 pL or more are arranged at a density of 130 droplets/$mm^2$ or more.

A flow behavior during the waiting step of the droplets of the curable composition (A) arranged on the substrate will be explained with reference to Figs. 7A to 7D. The droplets 102 of the curable composition (A) are discretely arranged on the substrate 101, as shown in Fig. 7A, and each droplet 102 gradually spreads on the substrate, as shown in Fig. 7B. Then, the droplets of the curable composition (A) on the substrate begin bonding to each other to form a liquid film, as shown in Fig. 7C, and a continuous liquid film is formed (the surface of the substrate 101 is covered with the curable composition (A) and there is no more exposed surface), as shown in Fig. 7D. The state of the curable composition (A) as shown in Fig. 7D is called "a practically continuous liquid film".

In addition, as schematically shown in Fig. 1D, a solvent 105 (solvent (d)) contained in a liquid film 104 is volatilized in the waiting step. Assuming that the total weight of the components except for the solvent (d) is 100 vol%, the residual amount of the solvent (d) in a liquid film 103 after the waiting step (for example, at the start of the contact step) is preferably 10 vol% or less. If the residual amount of the solvent (d) is larger than 10 vol%, the mechanical properties of the cured film may deteriorate.

In the waiting step, it is possible to perform a baking step of heating the substrate 101 and the curable composition

(A), or ventilate the atmospheric gas around the substrate 101, for the purpose of accelerating the volatilization of the solvent (d). Heating is performed at, for example, 30°C or more and 200°C or less, preferably 80°C or more and 150°C or less, and particularly preferably 90°C or more and 110°C or less. The heating time can be 10 sec or more and 600 sec or less. The baking step can be performed by using a known heater such as a hotplate or an oven.

The waiting step is, for example, 0.1 to 600 sec, and is preferably 10 to 300 sec. If the waiting step is shorter than 0.1 sec, the bonding of the droplets of the curable composition (A) becomes insufficient, so no practically continuous liquid film is formed. If the waiting step exceeds 600 sec, the productivity decreases. To suppress the decrease in productivity, therefore, it is also possible to sequentially move substrates completely processed in the arranging step to the waiting step, perform the waiting step in parallel to a plurality of substrates, and sequentially move the substrates completely processed in the waiting step to the contact step. Note that in the related art, a few thousands of seconds to a few tens of thousands of seconds are theoretically required before a practically continuous liquid film is formed. In practice, however, no continuous liquid film can be formed because the spread of the droplets of the curable composition stagnates due to the influence of volatilization.

When the solvent (d) volatilizes in the waiting step, the practically continuous liquid film 104 formed by the components (a), (b), and (c) remains. The average residual liquid film thickness of the practically continuous liquid film 104 from which the solvent (d) volatilized (was removed) becomes smaller than the liquid film 103 by the volatilized amount of the solvent (d). A state in which the entire pattern formation region of the substrate 101 is covered with the practically continuous liquid film 104 of the curable composition (A) from which the solvent (d) was removed is maintained in the entire region.

<Contact Step>

In the contact step, as schematically shown in Fig. 1E, the mold 106 is brought into contact with the practically continuous liquid film 104 of the curable composition (A) from which the solvent (d) is removed. The contact step includes a step of changing a state in which the curable composition (A) and the mold 106 are not in contact with each other to a state in which they are in contact with each other, and a step of maintaining the state in which they are in contact with each other. As a consequence, the liquid of the curable composition (A) is filled in recesses of fine patterns on the surface of the mold 106, and the liquid forms a liquid film filled in the fine patterns of the mold 106.

In the present invention, the curable composition (A) forms the practically continuous liquid film 104 from which the solvent (d) is removed in the waiting step, so the volume of a gas involved between the mold 106 and the substrate 101 becomes small. Accordingly, spreading of the curable composition (A) in the contact step is rapidly completed. Fig. 8 shows comparison (difference) between a contact step in a prior art disclosed in Japanese Patent No. 6584578 or the like and a contact step in the present invention.

When spreading and filling of the curable composition (A) are quickly completed in the contact step, it is possible to shorten the time (the time required for the contact step) for maintaining the state in which the mold 106 is in contact with the curable composition (A). Since shortening the time required for the contact step leads to shortening the time required for pattern formation (film formation), the productivity improves. The contact step is preferably 0.1 sec or more and 3 sec or less, and particularly preferably 0.1 sec or more and 1 sec or less. If the contact step is shorter than 0.1 sec, spreading and filling become insufficient, so many defects called incomplete filling defects tend to occur.

As described above, a phenomenon called oozing may occur in the contact step. This is a phenomenon that the curable composition extrudes from the contact surface of the mold and adheres to (crawls up) the side wall (side surface) of the mold in the contact step. The concept of oozing will be described with reference to Fig. 9. As shown in Fig. 16, a curable composition 1602 extruded from the mold 106 is a factor of so-called oozing (defect) which occurs when it crawls up the side wall of the mold 106 and forms, as a defect, an unnecessary cured product of the curable composition 1602 outside the contact surface of the mold 106. Here, the height the curable composition 1602 crawls up the side wall of the mold 106 is defined as an oozing height 1604.

In the present invention, as described above, concerning the contact angle of the curable composition (A), if the composition of components except for the solvent (component (d)) has the contact angle $\beta$ [°] with respect to the surface of the mold, the type and amount of the surfactant (c1) are selected such that $\beta$ is 25° or more. A factor for this will be described with reference to Fig. 10. As described above, the curable composition 1602 extruding from the mold 106 crawls up the side wall of the mold 106. If the contact angle $\beta$ is smaller than 25°, for example, an interface 1705 indicated by a solid line in Fig. 10 is formed. The contact angle $\beta$ between the mold 106 and the interface 1705 $\beta < 25°$. On the other hand, if the curable composition 1602 contains a surfactant and the contact angle $\beta$ is 25° or more, for example, an interface 1706 as indicated by a broken line in Fig. 10 is formed. The contact angle $\beta$ between the mold 106 and the interface 1705 is $\beta \geq 25°$. Comparing the interface 1705 and the interface 1706, it is found that the volume of the curable composition 1602 extruding from the mold 106 is larger on the interface 1706 but the oozing height is lower on the interface 1706. Thus, when the contact angle $\beta$ increases, the dependence of the oozing height on the volume of the curable composition 1602 extruding from the mold 106 decreases, and the oozing height can be suppressed. $\beta$ is preferably 30° or more, and more preferably 40° or more.

When the curing step includes a photoirradiation step, a mold made of a light-transmitting material is used as the mold 106 by taking this into consideration. Favorable practical examples of the type of the material forming the mold 106 are glass, quartz, PMMA, a photo-transparent resin such as a polycarbonate resin, a transparent metal deposition film, a soft film such as polydimethylsiloxane, a photo-cured film, and a metal film. When using the photo-transparent resin as the material forming the mold 106, a resin that does not dissolve in components contained in a curable composition is selected. Quartz is suitable as the material forming the mold 106 because the thermal expansion coefficient is small and pattern distortion is small.

A pattern formed on the surface of the mold 106 has a height of, for example, 4 nm or more and 200 nm or less. As the pattern height of the mold 106 decreases, it becomes possible to decrease the force of releasing the mold 106 from the cured film of the curable composition, that is, the mold release force in the mold release step, and this makes it possible to decrease the number of mold release defects remaining in the mold 106 because the pattern of the curable composition is torn off. Also, in some cases, the pattern of the curable composition elastically deforms due to the impact when the mold is released, and adjacent pattern elements come in contact with each other and adhere to each other or break each other. Note that to avoid these inconveniences, it is advantageous to make the height of pattern elements be about twice or less the width of the pattern elements (make the aspect ratio be 2 or less). On the other hand, if the height of pattern elements is too small, the processing accuracy of the substrate 101 decreases.

A surface treatment can also be performed on the mold 106 before performing the contact step, in order to improve the detachability of the mold 106 with respect to the curable composition (A). An example of this surface treatment is to form a mold release agent layer by coating the surface of the mold 106 with a mold release agent. Examples of the mold release agent to be applied on the surface of the mold 106 are a silicon-based mold release agent, a fluorine-based mold release agent, a hydrocarbon-based mold release agent, a polyethylene-based mold release agent, a polypropylene-based mold release agent, a paraffine-based mold release agent, a montane-based mold release agent, and a carnauba-based mold release agent. It is also possible to suitably use a commercially available coating-type mold release agent such as Optool® DSX manufactured by Daikin. Note that it is possible to use one type of a mold release agent alone, or use two or more types of mold release agents together. Of the mold release agents described above, fluorine-based and hydrocarbon-based mold release agents are particularly favorable.

In the contact step, the pressure to be applied to the curable composition (A) when bringing the mold 106 into contact with the curable composition (A) is not particularly limited, and is, for example, 0 MPa or more and 100 MPa or less. Note that when bringing the mold 106 into contact with the curable composition (A), the pressure to be applied to the curable composition (A) is preferably 0 MPa or more and 50 MPa or less, more preferably 0 MPa or more and 30 MPa or less, and further preferably 0 MPa or more and 20 MPa or less.

The contact step can be performed in any of a normal air atmosphere, a reduced-pressure atmosphere, and an inert-gas atmosphere. However, the reduced-pressure atmosphere or the inert-gas atmosphere is favorable because it is possible to prevent the influence of oxygen or water on the curing reaction. Practical examples of an inert gas to be used when performing the contact step in the inert-gas atmosphere are nitrogen, carbon dioxide, helium, argon, various freon gases, and gas mixtures thereof. A gas containing 10% or more of carbon dioxide or helium in a molar ratio is preferable, and a gas containing 10% or more of carbon dioxide in a molar ratio is particularly preferable. Since the helium gas readily diffuses to the mold, the substrate, the curable composition, and the like, the atmospheric gas confined in the pattern of the mold quickly disappears. Since carbon dioxide readily dissolves to the curable composition or the underlayer on the substrate, the atmospheric gas confined in the pattern of the mold quickly disappears. Also, the solubility coefficient of carbon dioxide to the curable composition is preferably 0.5 $kg/m^3 \cdot atm$ or more and 10 $kg/m^3 \cdot atm$ or less. Details of these are disclosed in Japanese Patent Laid-Open No. 2022-99271. When performing the contact step in a specific gas atmosphere including a normal air atmosphere, a favorable pressure is 0.0001 atm or more and 10 atm or less.

<Curing Step>

In the curing step, as schematically shown in Fig. 1F, the curable composition (A) is cured by being irradiated with irradiation light 107 as curing energy, thereby forming a cured film. In the curing step, for example, the curable composition (A) is irradiated with the irradiation light 107 through the mold 106. More specifically, the curable composition (A) filled in the fine pattern of the mold 106 is irradiated with the irradiation light 107 through the mold 106. Consequently, the curable composition (A) filled in the fine pattern of the mold 106 is cured and forms a cured film 108 having the pattern.

The irradiation light 107 is selected in accordance with the sensitivity wavelength of the curable composition (A). More specifically, the irradiation light 107 is properly selected from ultraviolet light, X-ray, and an electron beam each having a wavelength of 150 nm or more and 400 nm or less. Note that the irradiation light 107 is particularly preferably ultraviolet light. This is so because many compounds commercially available as curing assistants have sensitivity to ultraviolet light. Examples of a light source that emits ultraviolet light are a high-pressure mercury lamp, an ultrahigh-pressure mercury lamp, a low-pressure mercury lamp, a Deep-UV lamp, a carbon arc lamp, a metal halide lamp, a xenon lamp, a KrF excimer laser, an ArF excimer laser, and an $F_2$ laser. Note that the ultrahigh-pressure mercury lamp is

particularly favorable as the light source for emitting ultraviolet light. It is possible to use one light source or a plurality of light sources. Light can be emitted to the entire region of the curable composition (A) filled in the fine pattern of the mold, or to only a partial region thereof (by limiting the region). It is also possible to intermittently emit light to the entire region of the substrate a plurality of times, or to continuously emit light to the entire region of the substrate. Furthermore, a first region of the substrate can be irradiated with light in a first irradiation process, and a second region different from the first region of the substrate can be irradiated with light in a second irradiation process.

<Mold Release Step>

In the mold release step, as schematically shown in Fig. 1G, the mold 106 is released from the cured film 108. When the mold 106 is released from the cured film 108 having the pattern, the cured film 108 having a pattern formed by inverting the fine pattern of the mold 106 is obtained in an independent state. In this state, a cured film remains in recesses of the cured film 108 having the pattern. This film is called a residual film.

A method of releasing the mold 106 from the cured film 108 having the pattern can be any method provided that the method does not physically break a part of the cured film 108 having the pattern during the release, and various conditions and the like are not particularly limited. For example, it is possible to fix the substrate 101 and move the mold 106 away from the substrate 101. It is also possible to fix the mold 106 and move the substrate 101 away from the mold 106. Furthermore, the mold 106 can be released from the cured film 108 having the pattern by moving both the mold 106 and the substrate 101 in exactly opposite directions.

<Repetition>

A series of steps (a fabrication process) having the above-described steps from the arranging step to the mold release step in this order make it possible to obtain a cured film having a desired uneven pattern shape (a pattern shape conforming to the uneven shape of the mold 106) in a desired position.

In the pattern forming method according to the present invention, a repetition unit (shot) from the arranging step to the mold release step can repetitively be performed a plurality of times on the same substrate, so the cured film 108 having a plurality of desired patterns in desired positions of the substrate can be obtained.

[Planarization Film Forming Method]

An example in which the film forming method of according to the present invention is applied to a planarization film forming method will be explained below. The planarization film forming method includes, for example, an arranging step, a waiting step, a contact step, a curing step, and a mold release step. The arranging step is a step of arranging droplets of the curable composition (A) on a substrate. The waiting step is a step of waiting until the droplets of the curable composition (A) bond to each other and the solvent (d) volatilizes. The contact step is a step of bringing the curable composition (A) and a mold into contact with each other. The curing step is a step of curing the curable composition (A). The mold release step is a step of releasing the mold from the cured film of the curable composition (A). In the planarization film forming method, a substrate having unevenness having a difference in height of about 10 to 1,000 nm is used as the substrate, a mold having a flat surface is used as the mold, and a cured film having a surface conforming to the flat surface of the mold is formed through the contact step, the curing step, and the mold release step. In the arranging step, the droplets of the curable composition (A) are densely arranged in recesses of the substrate, and sparsely arranged on projections of the substrate. The waiting step is performed after the arranging step, the contact step is performed after the waiting step, the curing step is performed after the contact step, and the mold release step is performed after the curing step.

[Article Manufacturing Method]

An article manufacturing method includes a forming step of forming a film of a curable composition on a substrate using the above-described film forming method, a processing step of processing the substrate on which the film of the curable composition is formed in the forming step, and a manufacturing step of manufacturing an article from the substrate processed in the processing step. The film forming method is a pattern forming method or a planarization film forming method, as described above.

The cured film 108 having a pattern formed by the pattern forming method according to the present invention can directly be used as at least a partial constituent member of various kinds of articles. Also, the cured film 108 having a pattern formed by the pattern forming method according to the present invention can temporarily be used as a mask for etching or ion implantation with respect to the substrate 101 (a layer to be processed when the substrate 101 has the layer to be processed). This mask is removed after etching or ion implantation is performed in a processing step of the substrate 101. Consequently, various kinds of articles can be manufactured.

When removing a cured product in recesses of a pattern of the cured product by etching, a practical method is not particularly limited, and a conventionally known method such as dry etching can be used. A conventionally known dry etching apparatus can be used in this dry etching. A source gas for dry etching is appropriately selected in accordance with an element composition of the cured product to be etched. More specifically, it is possible to use halogen gases such as $CF_4$, $C_2F_6$, $C_3F_8$, $CCl_2F_2$, $CCl_4$, $CBrF_3$, $BCl_3$, $PCl_3$, $SF_6$, and $Cl_2$ as the source gas. As the source gas, it is also possible to use gases containing oxygen atoms such as $O_2$, CO, and $CO_2$, inert gases such as He, $N_2$, and Ar, and gases such as $H_2$ and $NH_3$ as the source gas. Note that these gases can also be mixed and used as the source gas. In this case, the photo-cured film is required to have a high dry etching system in order to process the base substrate with high yield.
An article is, for example, an electric circuit element, an optical element, MEMS, a recording element, a sensor, or a mold. Examples of the electric circuit element are volatile or nonvolatile semiconductor memories such as a DRAM, an SRAM, a flash memory, and an MRAM, and semiconductor elements such as an LSI, a CCD, an image sensor, and an FPGA. Examples of the optical element are a micro lens, a light guide body, a waveguide, an antireflection film, a diffraction grating, a polarizer, a color filter, a light-emitting element, a display, and a solar battery. Examples of the MEMS are a DMD, a microchannel, and an electromechanical transducer. Examples of the recording element are optical disks such as a CD and a DVD, a magnetic disk, a magneto-optical disk, and a magnetic head. Examples of the sensor are a magnetic sensor, a photosensor, and a gyro sensor. An example of the mold is a mold for imprinting.
In addition, a well-known photolithography step such as an imprint lithography technique or an extreme ultraviolet exposure technique (EUV) can be performed on the planarization film formed by the planarization film forming method according to the present invention. It is also possible to stack a spin-on-glass (SOG) film and/or a silicon oxide layer, and perform a photolithography step by applying a curable composition on that. Consequently, a device such as a semiconductor device can be fabricated. It is further possible to form an apparatus including the device, for example, an electronic apparatus such as a display, a camera, or a medical apparatus. Examples of the device are an LSI, a system LSI, a DRAM, an SDRAM, an RDRAM, a D-RDRAM, and a NAND flash memory.

[Examples]

To supplement the above-described embodiment, more detailed examples will be described.

<Example 1>

Example 1 shows that $\alpha 2$ is made larger than $\alpha 1$ by adding a surfactant, spread of droplets on the substrate is thus controlled by the pinning effect, and the extrusion amount can be suppressed. Example 1 also shows that $\gamma 1$ is made larger than $\gamma 2$, thereby controlling the extrusion amount while forming a liquid film by spread of droplets.
In Example 1, concerning the spread of droplets, experiments were conducted using three types of compositions, as shown in Table 1 below. In Table 1, FS2000M1 (manufactured by CHANGZHOU FOREIGN) is the surfactant. Composition 1 is a composition containing no surfactant, composition 2 is a composition containing 0.4 wt% surfactant added by a mass ratio, and composition 3 is a composition containing 3% surfactant added by a mass ratio.

[Table 1]

| | Composition 1 | | Composition 2 | | Composition 3 | |
|---|---|---|---|---|---|---|
| Solvent | 80 vol% | PGMEA | 80 vol% | PGMEA | 80 vol% | PGMEA |
| Polymerizable compound | 20 vol% | DCPDA (100 parts by weight) | 20 vol% | DCPDA (100 parts by weight) | 20 vol% | DCPDA (100 parts by weight) |
| Photopolymerization initiator | | Omnirad819 (3 parts by weight) | | Omnirad819 (3 parts by weight) | | Omnirad819 (3 parts by weight) |
| Surfactant | | none | | FS2000M1 (0.4 parts by weight) | | FS2000M1 (3.0 parts by weight) |

First, this example shows that $\alpha 2$ is made larger than $\alpha 1$ by adding the surfactant. To measure the contact angle, the amount of Liquid-compatible was set to 1 $\mu$L, and an automatic static contact angle meter Dropmaster 300 (manufactured by Kyowa Interface Science) was used. Fig. 11 is a view showing a result of measuring a contact angle to a substrate for each of composition 1, composition 2, and composition 3. In Fig. 11, the abscissa indicates time, and the ordinate indicates a contact angle so that Fig. 11 shows the time-rate change of the contact angle of each composition. Referring to Fig. 11, it is found that at each time, the contact angle is larger in composition 2 than in composition 1, the

contact angle is larger in composition 3 than in composition 2, and $\alpha2$ is larger than $\alpha1$. In Fig. 11, as for the contact angle 10 sec after dropping of the droplets of each composition, the contact angle is larger by about 0.5° in composition 2 than in composition 1.

A change of the surface tension associated with addition of the surfactant will be shown next. To measure the surface tension, an automatic surface tensiometer DY-300 (manufactured by Kyowa Interface Science) was used, and a plate method using a platinum plate was performed. Fig. 12 is a view showing a result of measuring the surface tension. In Fig. 12, the abscissa indicates the addition amount of the surfactant, and the abscissa indicates the value of the surface tension. A graph 901 is a graph showing the dependence of the surface tension of the curable composition in a state in which the solvent (d) was removed on the addition amount of the surfactant, and a graph 902 is a graph showing the value of the surface tension of the solvent. As described above, if $\gamma1$ is larger than $\gamma2$, droplets quickly spread to form a liquid film. This is a region where the surface tension of the graph 901 is larger than the surface tension of the graph 902, and is a region 903 in Fig. 12. According to this, $\gamma1$ is larger than $\gamma2$ in composition 2, and $\gamma1$ is smaller than $\gamma2$ in composition 3.

Fig. 13 shows the time-rate change of the radius of a droplet when a droplet of about 2 pL was dropped. To shoot (measure) the situation of droplet dropping and droplet spread, a commercially available industrial material printer DMP-2850 (manufactured by Fuji Film) was used. In Fig. 13, the abscissa indicates time, and the ordinate indicates the radius of a droplet. Referring to Fig. 13, it is found that in composition 1, the droplet spreads along with the elapse of time, but in composition 2, the spread of the droplet is stopped in an appropriate radius by the pinning effect. It is also found that in composition 3, the droplet shrinks due to the pinning effect and the Marangoni effect. It is therefore possible to control the spread of the droplet by adding the surfactant and obtaining the pinning effect.

Next, Fig. 14 shows a result of measuring the extrusion amount of a liquid film in a case where droplets of about 2 pL were arranged in an array of 6 rows at a pitch of 70 $\mu$m using the industrial material printer DMP-2850 (manufactured by Fuji Film). Note that the extrusion amount of the liquid film was defined as an amount obtained by subtracting 70 $\times$ 6 $\mu$m from the length of the liquid film. In Fig. 14, the abscissa indicates time, and the ordinate indicates the extrusion amount. Note that for composition 3, no practically continuous liquid film could be formed because of excessive shrinkage, and it was determined that the composition was inappropriate because the purpose of the waiting step could not be met. Typically, in composition 3, as shown in Fig. 15, droplets 1302 are isolated on a substrate 1301. On the other hand, for composition 1 and composition 2, a practically continuous liquid film can be formed, and typically, as shown in Fig. 16, the droplets are bonded to each other to form a liquid film 1202 on a substrate 1201.

For composition 1 and composition 2 other than composition 3 determined as inappropriate, referring to Fig. 14, it is fount that, in composition 1, the extrusion amount is large and increases along with the elapse of time, but in composition 2, the extrusion amount is small, and it dependence on time is small.

Fig. 17 shows the summary of experiment results concerning composition 1, composition 2, and composition 3. Fig. 17 shows values after the elapse of 600 sec as extrusion amounts. Referring to Fig. 17, it is found that when $\alpha2$ is made larger than $\alpha1$, like from composition 1 to composition 2, the extrusion amount can be suppressed from 120 $\mu$m to 48 $\mu$m. Also, it is found that when $\gamma1$ is made larger than $\gamma2$, like from composition 3 to composition 2, liquid film formation and extrusion amount suppression can simultaneously be implemented.

As described above, it is indicated that when $\alpha2$ is made larger than $\alpha1$, the extrusion amount can be suppressed. Also, it is indicated that when $\gamma1$ is made larger than $\gamma2$, liquid film formation and extrusion amount suppression can simultaneously be implemented. Note that as shown in Fig. 11, for the contact angle 10 sec after dropping of the droplets, $\alpha2 - \alpha1 > 0.5°$ preferably holds.

Next, preferable $\Delta\gamma$ defined by equation (3) below will be explained.

$$\Delta\gamma = \gamma1 - \gamma2 \qquad ...(3)$$

Fig. 18 is a view showing the dependence of the maximum radius of a droplet on $\Delta\gamma$ in a case where a droplet of about 1 pL is dropped. Fig. 18 shows a result of numerical calculation obtained by solving Navier-Stokes equations approximated to a thin film having a free surface (lubrication theory). In Fig. 18, the abscissa indicates $\Delta\gamma$ [mN/m], and the ordinate indicates $\Delta r$ [$\mu$m]. Here, $\Delta r$ is defined by equation (4) below.

$$\Delta r = r - r_0 \qquad ...(4)$$

where r is the maximum radius of the droplet, and $r_0$ is the maximum radius of the droplet when $\Delta\gamma = 0$.

Referring to Fig. 18, it is found that if $\Delta\gamma > 0.1$ mN/m, $\Delta r > 1$ $\mu$m and the droplets spread as compared to a case where $\Delta\gamma = 0$, and if $\Delta\gamma > 1$ mN/m, $\Delta r > 10$ $\mu$m and the droplets spread more conspicuously as compared to a case where $\Delta\gamma = 0$. It is therefore found that to obtain the effect in the maximum radius of the droplet, $\Delta\gamma > 0.1$ mN/m preferably holds, and $\Delta\gamma > 1$ mN/m more preferably holds.

<Example 2>

Example 2 shows that when β is made larger than 25° by adding a surfactant, it is possible to control spread of droplets on the surface of the mold by the pinning effect and suppress the oozing height to the side wall of the mold. In Example 2 as well, experiments were conducted using three types of compositions shown in Table 1.

First, this example shows that β (contact angle) increases in accordance with addition of the surfactant. Measurement of contact angles was executed like Example 1. Fig. 19 is a view showing a result of measuring a contact angle to a mold for each of composition 1, composition 2, and composition 3. In Fig. 19, the abscissa indicates time, and the ordinate indicates a contact angle so that Fig. 19 shows the time-rate change of the contact angle of each composition to the surface of the mold. Referring to Fig. 19, it is found that at each time after 1 sec, the contact angle is larger in composition 2 than in composition 1, the contact angle is larger in composition 3 than in composition 2, and β increases. In Fig. 19, as for the contact angle 10 sec after dropping of the droplets of each composition, the contact angle is about 14° in composition 1 and about 31° in composition 2.

Next, Fig. 20 shows a result of obtaining oozing heights to different contact angles by numerical calculation. Fig. 20 shows a result obtained by approximating the substrate and the mold by rigid bodies and solving Navier-Stokes equations approximated to a thin film. In Fig. 20, the abscissa indicates the contact angle, and the ordinate indicates the oozing height.

Referring to Fig. 20, it is found that the oozing height of composition 1 for which the contact angle is about 14° is about 95 nm, and the oozing height of composition 2 for which the contact angle is about 31° is about 70 nm. It is therefore found that the oozing height can be suppressed by selecting not composition 1 but composition 2. Note that it is found that, for composition 3, the oozing height can be suppressed more since the contact angle is higher, but based on Example 1, composition 2 in which $\gamma 1$ is larger than $\gamma 2$ is needed to implement both liquid film formation and oozing height suppression.

In accordance with abbreviations shown in Table 2 below, the curable composition (A) was mixed by mixing the components (a), (b), (c), and (d) such that a total ratio of 100 wt% was obtained, and the curable composition (A) was mixed without using the component (d), as shown in Table 3 below. A result obtained by measuring the viscosities of these curable compositions (A) at 23°C and calculating/measuring the Si atom contents of the curable compositions when the component (d) was removed and Tg after curing by the above-described method is shown in Table 4 below. Note that as for the component (d) in Table 3, PGMEA is short for propylene glycol monomethyl ether, and Gly is short for glycerin.

[Table 2]

| Name | Chemical structure | Manufacturer |
|---|---|---|
| monofunctional organic monomer (a) | 2-phenoxyethyl acrylate | KYOEISHA CHEMICAL |
| monofunctional organic monomer (b) | tetrahydrofurfuryl acrylate | OSAKA ORGANIC CHEMICAL INDUSTRY |
| monofunctional organic monomer (c) | isobornyl acrylate | OSAKA ORGANIC CHEMICAL INDUSTRY |
| monofunctional organic monomer (d) | 2-(o-phenylphenoxy)ethyl acrylate | NIPPON SHOKUBAI |
| monofunctional organic monomer (e) | 1-naphthalene methyl acrylate | KYOEISHA CHEMICAL |
| monofunctional Si monomer (f) | 3-methacryloxypropyltris(trimethylsiloxy)silane | JNC |
| polyfunctional organic monomer (A) | dimethylol-tricyclodecanediacrylate | KYOEISHA CHEMICAL |
| polyfunctional organic monomer (B) | pentaerythritol tetraacrylate | Sartomer |
| polyfunctional organic monomer (C) | ditrimethylolpropane tetraacrylate | Sartomer |
| polyfunctional Si monomer (D) | acryloyl group-modified silsesquioxane derivatives | TOAGOSEI |

[Table 3]

| | Polymerizable compound (a) | | | | Polymerization initiator (b) | | Surfactant (c) | | Solvent (d) | |
|---|---|---|---|---|---|---|---|---|---|---|
| | Polymerizable monomer (monofunctional) | | Polymerizable monomer (polyfunctional) | | | | | | | |
| | name | amount | name | amount | type | amount | type | amount | type | amount |
| Example 3 | monofunctional organic monomer (a) | 3 | polyfunctional organic monomer (A) | 3 | Omnirad819 | 1.0 | Pluronic PE6400 | 0.04 | PGMEA | 92.96 |
| Example 4 | monofunctional organic monomer (a) | 3 | polyfunctional organic monomer (A) | 3 | Omnirad819 | 1.0 | Pluronic PE6400 | 0.08 | PGMEA | 92.92 |
| Example 5 | monofunctional organic monomer (a) | 8 | polyfunctional organic monomer (A) | 8 | Omnirad819 | 1.0 | Pluronic PE6400 | 0.10 | PGMEA | 82.90 |
| Example 6 | monofunctional organic monomer (a) | 23 | polyfunctional organic monomer (A) | 23 | Omnirad819 | 1.0 | Pluronic PE6400 | 0.50 | PGMEA | 52.50 |
| Example 7 | monofunctional organic monomer (a) | 23 | polyfunctional organic monomer (A) | 23 | Omnirad819 | 1.0 | Pluronic PE6400 | 1.00 | PGMEA | 52.00 |
| Example 8 | monofunctional organic monomer (a) | 15 | polyfunctional organic monomer (A) | 15 | Omnirad819 | 1.0 | F-444 | 0.05 | PGMEA | 68.95 |
| Example 9 | monofunctional organic monomer (a) | 15 | polyfunctional organic monomer (A) | 15 | Omnirad819 | 1.0 | F-444 | 0.10 | PGMEA | 68.90 |
| Example 10 | monofunctional organic monomer (a) | 15 | polyfunctional organic monomer (B) | 15 | Omnirad819 | 1.0 | F-444 | 0.10 | PGMEA | 68.90 |
| Example 11 | monofunctional organic monomer (a) | 15 | polyfunctional organic monomer (C) | 15 | Omnirad819 | 1.0 | F-444 | 0.10 | PGMEA | 68.90 |
| Example 12 | monofunctional organic monomer (a) | 15 | polyfunctional organic monomer (A) | 15 | Omnirad819 | 1.0 | KP-341 | 0.10 | PGMEA | 68.90 |
| Example 13 | monofunctional organic monomer (a) | 15 | polyfunctional organic monomer (B) | 15 | Omnirad819 | 1.0 | KP-341 | 0.10 | PGMEA | 68.90 |
| Example 14 | monofunctional organic monomer (a) | 15 | polyfunctional organic monomer (C) | 15 | Omnirad819 | 1.0 | KP-341 | 0.10 | PGMEA | 68.90 |
| Example 15 | monofunctional organic monomer (b) | 15 | polyfunctional organic monomer (A) | 15 | Omnirad819 | 1.0 | F-444 | 0.10 | PGMEA | 68.90 |
| Example 16 | monofunctional organic monomer (c) | 15 | polyfunctional organic monomer (A) | 15 | Omnirad819 | 1.0 | F-444 | 0.10 | PGMEA | 68.90 |
| Example 17 | monofunctional organic monomer (d) | 15 | polyfunctional organic monomer (A) | 15 | Omnirad819 | 1.0 | F-444 | 0.10 | PGMEA | 68.90 |
| Example 18 | monofunctional organic monomer (e) | 30 | polyfunctional organic monomer (A) | 30 | Omnirad819 | 1.0 | F-444 | 0.10 | PGMEA | 38.90 |
| Example 19 | monofunctional organic monomer (e) | 30 | polyfunctional organic monomer (A) | 30 | Omnirad819 | 1.0 | F-444 | 0.10 | PGMEA | 38.90 |
| Example 20 | monofunctional organic monomer (e) | 30 | polyfunctional organic monomer (A) | 30 | Omnirad820 | 1.0 | F-444 | 0.10 | PGMEA | 38.90 |
| Example 21 | monofunctional organic monomer (e) | 30 | polyfunctional organic monomer (A) | 30 | Omnirad821 | 1.0 | F-444 | 0.10 | PGMEA | 38.90 |
| Example 22 | monofunctional organic monomer (e) | 15 | polyfunctional organic monomer (A) | 70 | Omnirad820 | 1.0 | F-444 | 2.00 | PGMEA | 12.00 |
| Example 23 | monofunctional Si monomer (f) | 20 | polyfunctional Si monomer (D) | 40 | Omnirad819 | 1.0 | F-444 | 0.10 | PGMEA | 38.90 |
| Example 24 | monofunctional organic monomer (a) | 5.0 | polyfunctional Si monomer (D) | 40.0 | Omnirad819 | 1.0 | F-444 | 0.10 | PGMEA | 53.90 |
| Example 25 | monofunctional organic monomer (a) | 10 | polyfunctional Si monomer (D) | 40 | Omnirad819 | 1.0 | F-444 | 0.10 | PGMEA | 48.90 |
| Example 26 | monofunctional organic monomer (a) | 20.0 | polyfunctional Si monomer (D) | 40.0 | Omnirad819 | 1.0 | F-444 | 0.10 | PGMEA | 38.90 |
| Example 27 | monofunctional organic monomer (a) | 20 | polyfunctional Si monomer (D) | 30 | Omnirad819 | 1.0 | F-444 | 0.10 | PGMEA | 48.90 |
| Example 28 | monofunctional organic monomer (a) | 30.0 | polyfunctional Si monomer (D) | 5.0 | Omnirad819 | 1.0 | F-444 | 0.10 | PGMEA | 63.90 |
| Comparative Example 1 | monofunctional organic monomer (a) | 15 | polyfunctional organic monomer (A) | 70 | Omnirad819 | 1.0 | Pluronic PE6400 | 0.05 | Gly | 13.95 |
| Comparative Example 2 | monofunctional organic monomer (a) | 20 | polyfunctional organic monomer (A) | 20 | Omnirad819 | 1.0 | - | 0 | PGMEA | 59.00 |

[Table 4]

| | Initial viscosity (23°C)/mPa·s | Solvent content (%) | Boiling point of the solvent (°C) | α1-α2 | β | γ1-γ2 | Viscosity when the solvent is removed (23°C) | Polyfunctional monomer in monomer | Glass transition temperature of the cured product | Curable composition OP | Si atom contents of the curable compositions |
|---|---|---|---|---|---|---|---|---|---|---|---|
| Example 3 | 1.4 | 92.99 | 146 | 0.2 | 19.9 | 9.5 | 39.5 | 50 | 98 | 2.97 | - |
| Example 4 | 1.4 | 92.95 | 146 | 0.3 | 26.1 | 4.4 | 39.5 | 50 | 98 | 2.97 | - |
| Example 5 | 2.0 | 82.9 | 146 | 0.2 | 25.3 | 5.2 | 39.5 | 50 | 98 | 2.97 | - |
| Example 6 | 5.9 | 52.5 | 146 | 0.3 | 27.9 | 2.7 | 39.5 | 50 | 98 | 2.97 | - |
| Example 7 | 5.9 | 52 | 146 | 0.3 | 31.4 | 2.0 | 39.5 | 50 | 98 | 2.97 | - |
| Example 8 | 3.3 | 68.95 | 146 | 3.1 | 29.3 | 7.1 | 39.5 | 50 | 98 | 2.97 | - |
| Example 9 | 3.3 | 68.9 | 146 | 3.3 | 34.3 | 4.0 | 39.5 | 50 | 98 | 2.97 | - |
| Example 10 | 2.7 | 68.9 | 146 | 3.3 | 34.3 | 4.5 | 22.4 | 50 | 54 | 3.56 | - |
| Example 11 | 4.1 | 68.9 | 146 | 3.3 | 34.3 | 3.3 | 84.9 | 50 | 52 | 3.27 | - |
| Example 12 | 3.3 | 68.9 | 146 | 2.9 | 33.2 | 4.9 | 39.5 | 50 | 98 | 2.97 | - |
| Example 13 | 2.7 | 68.9 | 146 | 2.9 | 33.2 | 5.4 | 22.4 | 50 | 54 | 3.56 | - |
| Example 14 | 4.1 | 68.9 | 146 | 2.9 | 33.2 | 4.2 | 84.9 | 50 | 52 | 3.27 | - |
| Example 15 | 2.9 | 68.9 | 146 | 2.3 | 34.3 | 2.0 | 27.9 | 50 | 88 | 4.15 | - |
| Example 16 | 3.1 | 68.9 | 146 | 1.3 | 34.3 | -0.5 | 34.2 | 50 | 139 | 3.22 | - |
| Example 17 | 4.7 | 68.9 | 146 | 0.3 | 34.3 | 5.2 | 134.9 | 50 | 112 | 2.91 | - |
| Example 18 | 12.8 | 38.9 | 146 | 3.1 | 29.4 | 9.6 | 62.4 | 50 | 110 | 2.72 | - |
| Example 19 | 12.8 | 38.9 | 146 | 3.1 | 29.4 | 9.6 | 62.4 | 50 | 110 | 2.72 | - |
| Example 20 | 12.8 | 38.9 | 146 | 3.1 | 29.4 | 9.6 | 62.4 | 50 | 110 | 2.72 | - |
| Example 21 | 12.8 | 38.9 | 146 | 3.1 | 29.4 | 9.6 | 62.4 | 50 | 110 | 2.72 | - |
| Example 22 | 57.4 | 12 | 146 | 4.0 | 53.7 | -7.1 | 100.4 | 82 | 162 | 3.06 | - |
| Example 23 | 47.5 | 38.9 | 146 | 3.1 | 29.4 | -9.9 | 545.1 | 67 | 197 | - | 24.26 |
| Example 24 | 40.3 | 53.9 | 146 | 3.2 | 31.3 | -4.4 | 3007.9 | 89 | 223 | - | 20.58 |
| Example 25 | 45.5 | 48.9 | 146 | 3.2 | 30.6 | -1.0 | 1731.2 | 80 | 201 | - | 18.52 |
| Example 26 | 57.9 | 38.9 | 146 | 3.1 | 29.4 | 2.4 | 756.0 | 67 | 168 | - | 15.44 |
| Example 27 | 24.3 | 48.9 | 146 | 3.2 | 30.6 | 2.7 | 499.5 | 60 | 152 | - | 13.89 |
| Example 28 | 3.5 | 63.9 | 146 | 3.3 | 33.1 | 4.4 | 29.2 | 14 | 40 | - | 3.30 |
| Comparative Example 1 | 126.5 | 13.95 | 290 | 0.1 | 17.1 | -24.0 | 85.4 | 82 | 157 | 3.16 | - |
| Comparative Example 2 | 4.7 | 59 | 146 | -9.9 | 0.0 | 11.4 | 39.5 | 50 | 98 | 2.97 | - |

<Evaluation of Discharge of Inkjet>

To evaluate discharge of inkjet, a commercially available industrial material printer DMP-2850 (manufactured by Fuji Film) was used. Each of the curable compositions of Examples 3 to 28 and Comparative Examples 1 and 2 shown in Table 3 was filled in a cartridge. A droplet discharge state was observed by an internal discharge observation camera, and the discharge of inkjet was evaluated based on the following evaluation criteria.

(Evaluation Criteria)

AAA: no deviation of landing positions was observed at all at a discharge speed (flying speed) of 6 m/sec or more.
AA: a slight deviation of landing positions without any practical influence was observed at a discharge speed of 6 m/sec or more.
A: a slight deviation of landing positions without any practical influence was observed at a discharge speed of 4 m/sec or more.
B: no discharge was performed.

<Evaluation of Extrusion Amount>

To evaluate the extrusion amount, a commercially available industrial material printer DMP-2850 (manufactured by Fuji Film) was used. Each of the curable compositions of Examples 3 to 28 and Comparative Examples 1 and 2 shown in Table 3 was filled in a cartridge. Droplets of about 2 pl were dropped and arranged in an array of 6 rows at a pitch of 70 $\mu$m. In all examples and comparative examples, it was confirmed that the liquid film after the elapse of 600 sec formed a practically continuous liquid film, and the extrusion amount was measured. Note that the extrusion amount of the liquid film is defined as an amount obtained by subtracting $70 \times 6$ $\mu$m from the length of the liquid film, and the extrusion amount was evaluated based on the following evaluation criteria.

(Evaluation Criteria)

AAA: the extrusion amount was 50 $\mu$m or less.
AA: the extrusion amount was 70 $\mu$m or less.
A: the extrusion amount was 100 $\mu$m or less.
B: the extrusion amount was larger than 100 $\mu$m.

<Evaluation of Oozing Amount>

To evaluate the oozing amount, a commercially available industrial material printer DMP-2850 (manufactured by Fuji Film) was used. Each of the curable compositions of Examples 3 to 28 and Comparative Examples 1 and 2 shown in Table 3 was filled in an amount of 1 pL in a cartridge. Using the pattern editor software of DMP-2850, a pattern array in which X Width was set to 25.5 mm, Y Height was set to 32.5 mm, and Drop Spacing was set to 50 $\mu$m was produced. Droplets were dropped on a silicon substrate, and the arranging step, the waiting step, and the contact step were executed using a blank mold made of quartz. The arranging step, the waiting step, and the contact step were executed under a carbon dioxide atmosphere, and an image of the outer peripheral portion of the plane mold after the steps was captured at an interval of 500 $\mu$m, thereby obtaining a total of 232 images. All images were observed, and the oozing amount was evaluated based on the following evaluation criteria.

(Evaluation Criteria)

AAA: the ratio of images with oozing confirmed was 1% or less of the total.
AA: the ratio of images with oozing confirmed was 3% or less of the total.
A: the ratio of images with oozing confirmed was 5% or less of the total.
B: the ratio of images with oozing confirmed was more than 5% of the total.

<Evaluation of Drop Bonding>

Under a condition that the thickness of a liquid film before the solvent (d) volatilizes is 80 nm, each of the curable compositions of Examples 3 to 28 and Comparative Examples 1 and 2 shown in Table 3 was discretely dropped (arranged) on a silicon substrate. Time until a practically continuous liquid film was formed was measured, and drop bonding was evaluated based on the following evaluation criteria.

(Evaluation Criteria)

AAA: a practically continuous liquid film was formed within time less than 100 sec.
AA: a practically continuous liquid film was formed within time of 100 sec or more and less than 200 sec.
A: a practically continuous liquid film was formed within time of 200 sec or more and less than 300 sec.
B: no practically continuous liquid film was formed even after the elapse of 300 sec.

<Evaluation of Pattern Collapse>

For each of the curable compositions of Examples 3 to 28 and Comparative Examples 1 and 2 shown in Table 3, the arranging step, the waiting step, the contact step, the curing step, and the mold release step were executed using a mold made of quartz on which a line-and-space (L/S) pattern having a depth of 50 nm and a width of 20 nm was formed on the entire region. A pattern obtained by these steps was observed, and pattern collapse was evaluated based on the following evaluation criteria.

(Evaluation Criteria)

AAA: pattern collapse was observed in a region less than 0.5% the pattern formation region.
AA: pattern collapse was observed in a region less than 1% the pattern formation region.
A: pattern collapse was observed in a region less than 10% the pattern formation region.
B: pattern collapse was observed in a region 10% or more the pattern formation region.

<Evaluation of Dry Etching Resistance>

A cured film obtained from each of the curable compositions of Examples 3 to 22 and Comparative Examples 1 and 2 shown in Table 3 was exposed to oxygen plasma in a dry etching apparatus. Also, a cured film obtained from each of the curable compositions of Examples 23 to 28 shown in Table 3 was exposed to $CF_4$ plasma in a dry etching apparatus. A weight change of the cured film remaining after the exposure was measured, and the dry etching resistance was evaluated based on the following evaluation criteria.

(Evaluation Criteria)

AAA: the weight of the remaining cured film was 46% or more the weight before etching.
AA: the weight of the remaining cured film was 42% or more the weight before etching.
A: the weight of the remaining cured film was 38% or more the weight before etching.
B: the weight of the remaining cured film was less than 38% the weight before etching.

The above evaluation results are shown in Table 5.

[Table 5]

| | Evaluation result | | | | | |
|---|---|---|---|---|---|---|
| | IJ discharge | Extrusion amount | Oozing amount | Drop bonding | Pattern collapse | Dry etching resistance |
| Example 3 | A | A | A | AAA | A | AAA |

(continued)

| | Evaluation result | | | | | |
|---|---|---|---|---|---|---|
| | IJ discharge | Extrusion amount | Oozing amount | Drop bonding | Pattern collapse | Dry etching resistance |
| Example 4 | A | A | A | AAA | A | AAA |
| Example 5 | A | A | A | AAA | A | AAA |
| Example 6 | AAA | A | A | AAA | A | AAA |
| Example 7 | AAA | A | AA | AA | A | AAA |
| Example 8 | AA | AAA | A | AAA | A | AAA |
| Example 9 | AA | AAA | AA | AAA | A | AAA |
| Example 10 | AA | AAA | AA | AAA | B | A |
| Example 11 | AA | AAA | AA | AAA | B | AA |
| Example 12 | AA | AA | AA | AAA | A | AAA |
| Example 13 | AA | AA | AA | AAA | B | A |
| Example 14 | AA | AA | AA | AAA | B | AA |
| Example 15 | AA | AA | AA | AA | A | B |
| Example 16 | AA | AA | AA | B | AAA | AA |
| Example 17 | AA | A | AA | AAA | AA | AAA |
| Example 18 | AAA | AAA | A | AAA | AA | AAA |
| Example 19 | AAA | AAA | A | AAA | AA | AAA |
| Example 20 | AAA | AAA | A | AAA | AA | AAA |
| Example 21 | AAA | AAA | A | AAA | AA | AAA |
| Example 22 | A | AAA | AAA | B | AAA | AA |
| Example 23 | A | AAA | A | B | AAA | AAA |
| Example 24 | A | AAA | AA | B | AAA | AAA |
| Example 25 | A | AAA | AA | B | AAA | AA |
| Example 26 | A | AAA | A | AAA | AAA | AA |
| Example 27 | AA | AAA | AA | AAA | AAA | A |
| Example 28 | AA | AAA | AA | AAA | B | B |
| Comparative Example 1 | B | A | B | B | AAA | AA |
| Comparative Example 2 | AA | B | B | AAA | A | AA |

It is found that if the viscosity of the curable composition at 23° is 2 mPa·s or more and 60 mPa·s or less, inkjet discharge is satisfactory, and the viscosity is preferably 5 mPa·s or more and 30 mPa·s or less, and further preferably 5 mPa·s or more and 15 mPa·s or less.

As for the extrusion amount, it is found that letting $\alpha 1$ [°] be the contact angle of the composition obtained by removing the solvent (d) and the surfactant (c1) to the substrate and $\alpha 2$ [°] be the contact angle of the composition obtained by removing the solvent (d) to the substrate, the extrusion amount is satisfactory if $\alpha 2$ is larger than $\alpha 1$. It is also found that $\alpha 2 - \alpha 1 > 0.5$ is preferable, and $\alpha 2 - \alpha 1 \geq 3.0$ is further preferable.

It is fount that the oozing amount is satisfactory if the contact angle $\beta$ [°] of the composition obtained by removing the solvent (d) to quartz is $\beta \geq 25°$, $\beta \geq 30°$ is preferable, and $\beta \geq 40°$ is further preferable.

It is found that letting $\gamma 1$ [mN/m] be the surface tension of the composition obtained by removing the solvent (d) at 23°C and $\gamma 2$ [mN/m] be the surface tension of the solvent (d) at 23°C, drop bonding is satisfactory if $\gamma 1$ is larger than y2. It is also found that $\gamma 1 - \gamma 2 \geq 1.0$ is preferable, and $\gamma 1 - \gamma 2 \geq 2.0$ is further preferable.

As for the pattern collapse, it is found that the glass transition temperature of the curable composition after curing is preferably 70°C or more, more preferably 100°C or more, and further preferably 130°C or more.

As for the dry etching resistance, it is found from Examples 3 to 22 and Comparative Examples 1 and 2 that the OP of the polymerizable compound (a) is preferably 1.80 or more and 4.00 or less, more preferably 2.00 or more and 3.50 or less, further preferably 2.40 or more and 3.00 or less. Also, as for the dry etching resistance, it is found from Examples 3 to 28 that the Si content of the polymerizable compound (a) is preferably 10 wt% or more, more preferably 15 wt% or more, and further preferably 20 wt% or more.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2023-119299 filed July 21, 2023, which is hereby incorporated by reference herein.

## Claims

1. A curable composition containing a polymerizable compound (a), a photopolymerization initiator (b), a solvent (d), and a surfactant (c1), **characterized in that**

    the curable composition has a viscosity of not less than 1.3 mPa·s and not more than 60 mPa·s at 23°C and at 1 atm,
    a content of the solvent (d) with respect to the whole curable composition is larger than 5 vol% and not more than 95 vol%,
    a boiling point of the solvent (d) is less than 250°C at 1 atm, and
    letting $\alpha 1$ [°] be a contact angle of a composition obtained by removing the solvent (d) and the surfactant (c1) from the curable composition to a substrate and $\alpha 2$ [°] be the contact angle of a composition obtained by removing the solvent (d) from the curable composition to the substrate, $\alpha 2$ is larger than $\alpha 1$.

2. The curable composition according to claim 1, **characterized in that** $\alpha 2 - \alpha 1 > 0.5$ [°].

3. A curable composition containing a polymerizable compound (a), a photopolymerization initiator (b), a solvent (d), and a surfactant (c1), **characterized in that**

    the curable composition has a viscosity of not less than 1.3 mPa·s and not more than 60 mPa·s at 23°C and at 1 atm,
    a content of the solvent (d) with respect to the whole curable composition is larger than 5 vol% and not more than 95 vol%,
    a boiling point of the solvent (d) is less than 250°C at 1 atm, and
    a contact angle $\beta$ of a composition obtained by removing the solvent (d) from the curable composition to a mold is not less than 25°.

4. The curable composition according to claim 1 or 3, **characterized in that** letting $\gamma 1$ [mN/m] be a surface tension of the composition obtained by removing the solvent (d) from the curable composition at 23°C and at 1 atm and $\gamma 2$ [mN/m] be a surface tension of the solvent (d) at 23°C and at 1 atm, $\gamma 1$ is larger than $\gamma 2$.

5. The curable composition according to claim 4, **characterized in that** $\gamma 1 - \gamma 2 > 0.1$ [mN/m].

6. The curable composition according to claim 4, **characterized in that** $\gamma 1 - \gamma 2 > 1$ [mN/m].

7. The curable composition according to claim 1 or 3, **characterized in that** the surfactant (c1) contains fluorine atoms.

8. The curable composition according to claim 1 or 3, **characterized in that** the surfactant (c1) contains silicone atoms.

9. The curable composition according to claim 1 or 3, **characterized in that** the composition obtained by removing the solvent (d) from the curable composition has a viscosity of not less than 30 mPa·s and not more than 10,000 mPa·s at 23°C and at 1 atm.

10. The curable composition according to claim 1 or 3, **characterized in that** the solvent (d) contains not less than one type of solvent, and a boiling point of each of the not less than one type of solvent at 1 atm is not less than 100°C and less than 250°C.

**11.** The curable composition according to claim 1 or 3, **characterized in that** the solvent (d) contains a polymerizable compound whose boiling point at 1 atm is not less than 100°C and less than 250°C.

**12.** The curable composition according to claim 1 or 3, **characterized in that** the solvent (d) contains not less than one type of solvent, and a boiling point of each of the not less than one type of solvent at 1 atm is not less than 100°C and less than 200°C.

**13.** The curable composition according to claim 1 or 3, **characterized in that** a content of the solvent (d) with respect to the whole curable composition is not less than 40 vol% and not more than 85 vol%.

**14.** The curable composition according to claim 1 or 3, **characterized in that** a ratio of a polyfunctional polymerizable compound in the polymerizable compound (a) is not less than 20 wt%.

**15.** The curable composition according to claim 1 or 3, **characterized in that** the polymerizable compound (a) contains not less than one type of polymerizable compound, and a boiling point of each of the not less than one type of polymerizable compound at 1 atm is not less than 250°C.

**16.** The curable composition according to claim 1 or 2, **characterized in that** the polymerizable compound (a) contains not less than one type of polymerizable compound, and a molecular weight of each of the not less than one type of polymerizable compound is not less than 200.

**17.** The curable composition according to claim 1 or 2, **characterized in that** the polymerizable compound (a) contains a polymer having a polymerizable functional group.

**18.** The curable composition according to claim 1 or 3, **characterized in that** a glass transition temperature of the polymerizable compound (a) after curing is not less than 70°C.

**19.** The curable composition according to claim 1 or 3, **characterized in that** the polymerizable compound (a) contains not less than one type of polymerizable compound, and a vapor pressure of each of the not less than one type of polymerizable compound at 80°C and at 1 atm is not more than 0.001 mmHg.

**20.** The curable composition according to claim 1 or 3, **characterized in that** the polymerizable compound (a) contains a compound (a-1) having one of an aromatic structure, an aromatic heterocyclic structure, and an alicyclic structure.

**21.** The curable composition according to claim 1 or 3, **characterized in that**

the polymerizable compound (a) contains not less than one type of polymerizable compound, and
an Ohnishi Parameter (OP) of the polymerizable compound (a) is not less than 1.80 and not more than 4.00, and is a molar fraction weighted average value of an $N/(N_C - N_O)$ value of each molecule of the not less than one type of polymerizable compound, in which N is the total number of atoms in a molecule, $N_C$ is the number of carbon atoms in the molecule, and No be the number of oxygen atoms in the molecule.

**22.** The curable composition according to claim 1 or 3, **characterized in that** the polymerizable compound (a) contains a compound (a-2) containing silicon atoms.

**23.** The curable composition according to claim 22, **characterized in that** the compound (a-2) includes a polymerizable compound having one of a silsesquioxane skeleton and a cyclic siloxane compound.

**24.** The curable composition according to claim 1 or 3, **characterized in that** the composition obtained by removing the solvent (d) from the curable composition contains Si atoms of not less than 10 wt%.

**25.** The curable composition according to claim 1 or 3, **characterized in that** the curable composition is a composition for inkjet.

**26.** The curable composition according to claim 1 or 3, **characterized in that** a solubility coefficient of carbon dioxide to the curable composition is not less than 0.5 $kg/m^3 \cdot atm$ and not more than 10 $kg/m^3 \cdot atm$.

**27.** A film forming method for forming a film of a curable composition in a space between a mold and a substrate,

**characterized by** comprising:

an arranging step of discretely arranging, on the substrate, a plurality of droplets of a curable composition defined in claim 1 or 3;
a waiting step of waiting until the plurality of droplets bond to adjacent droplets to form a liquid film; and
after the waiting step, a contact step of bringing the mold and the liquid film into contact with each other.

**28.** The film forming method according to claim 27, **characterized in that** in the waiting step, waiting is performed until a solvent contained in the liquid film volatilizes, and a content of the solvent is not more than 10 vol% with respect to the whole liquid film.

**29.** The film forming method according to claim 27, **characterized in that** in the waiting step, the substrate is heated under conditions of not less than 30°C and not more than 200°C and not less than 10 sec and not more than 600 sec.

**30.** The film forming method according to claim 27, **characterized in that** in the arranging step, the droplets of the curable composition having a volume of not less than 1.0 pL are arranged on the substrate at a density of not less than 80 droplets/$mm^2$.

**31.** The film forming method according to claim 27, **characterized in that** an average residual liquid film thickness that is a value obtained by dividing a volume of the curable composition remaining after the waiting step by an area of a film formation region is not more than 20 nm.

**32.** The film forming method according to claim 27, **characterized in that**

the mold includes a pattern,
in the contact step, the pattern of the mold and the liquid film are brought into contact with each other, and
the film forming method further comprises, after the contact step, a curing step of curing the liquid film to form a cured film having a pattern corresponding to the pattern of the mold.

**33.** The film forming method according to claim 27, **characterized in that**

the mold includes a flat surface,
in the contact step, the flat surface of the mold and the liquid film are brought into contact with each other, and
the film forming method further comprises, after the contact step, a curing step of curing the liquid film to form a cured film having a surface conforming to the flat surface of the mold.

**34.** The film forming method according to claim 27, **characterized in that** in the arranging step, the plurality of droplets are discretely arranged on the substrate using an inkjet method.

**35.** The film forming method according to claim 27, **characterized in that** in the contact step, a gas that fills the space between the mold and the substrate contains not less than 10% of carbon dioxide in a molar ratio.

**36.** An article manufacturing method **characterized by** comprising:

a forming step of forming a film of a curable composition on a substrate using a film forming method defined in claim 27;
a processing step of processing the substrate on which the film is formed in the forming step; and
a manufacturing step of manufacturing an article from the substrate processed in the processing step.

FIG. 1A

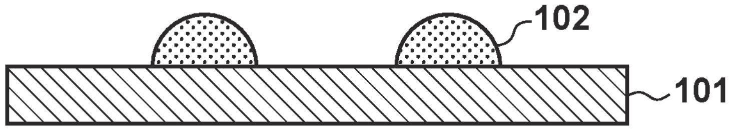


FIG. 1B

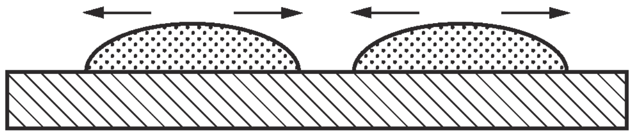

FIG. 1C

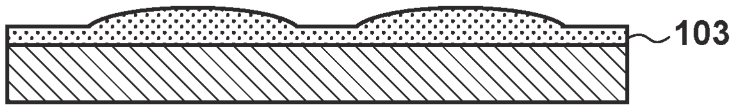


FIG. 1D

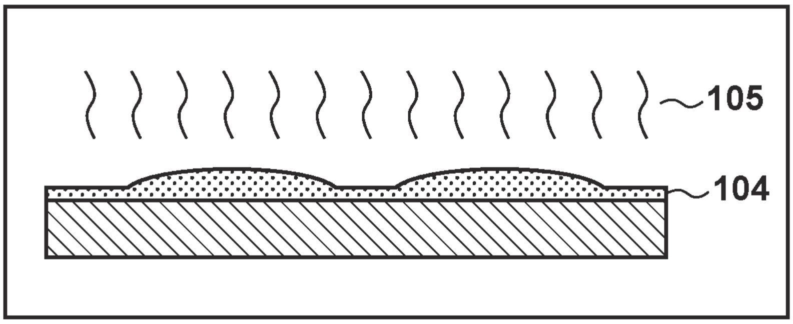


FIG. 1E

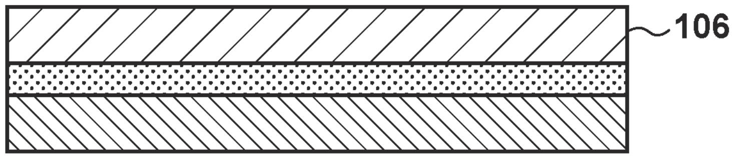


FIG. 1F

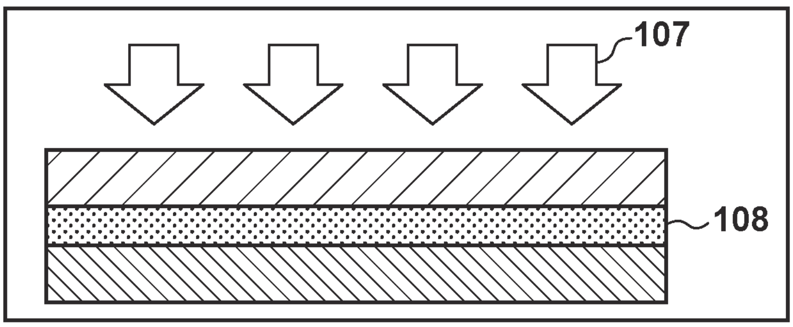


FIG. 1G

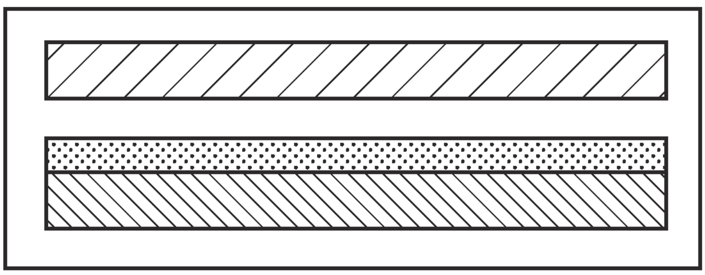

FIG. 2

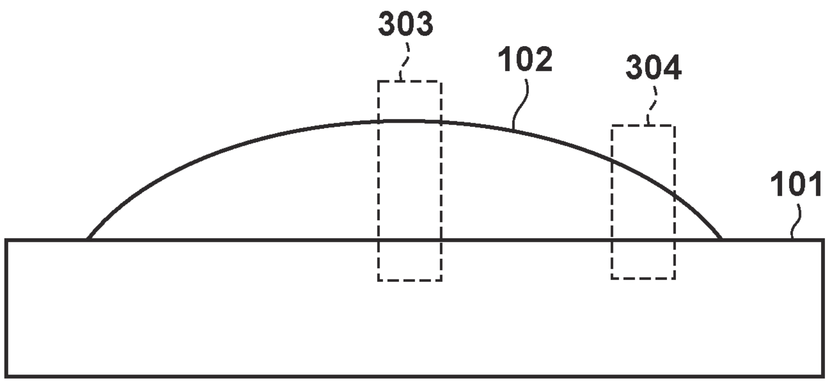


FIG. 3

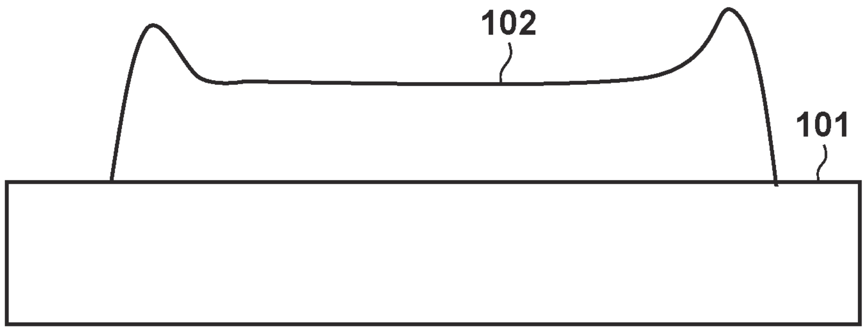


FIG. 4

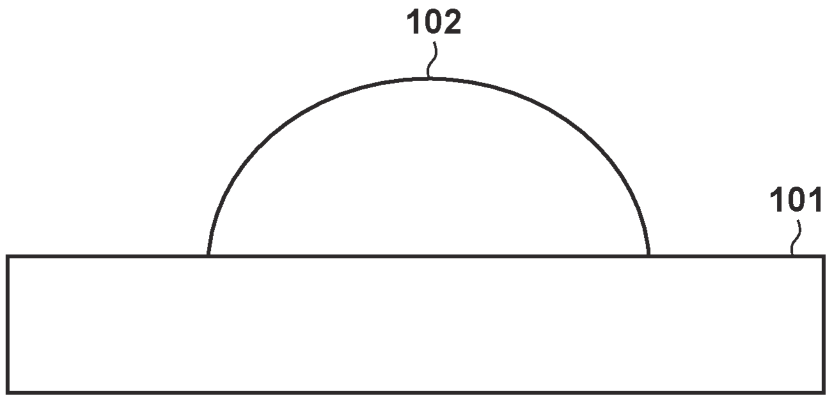

F I G. 5

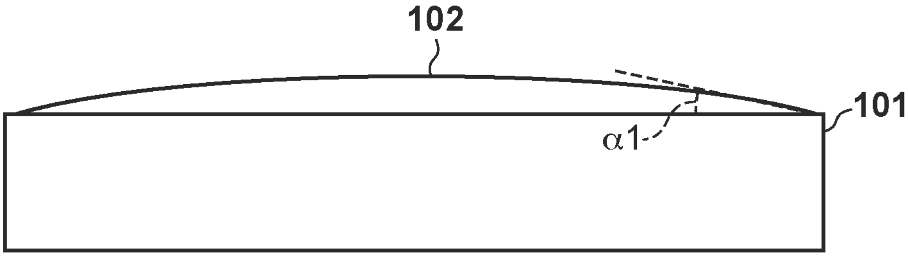


F I G. 6

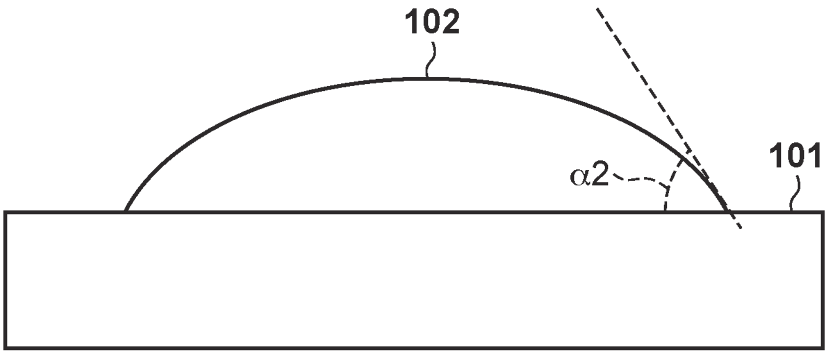

FIG. 7A

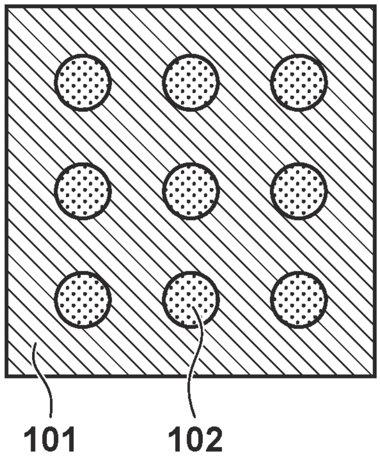


FIG. 7B

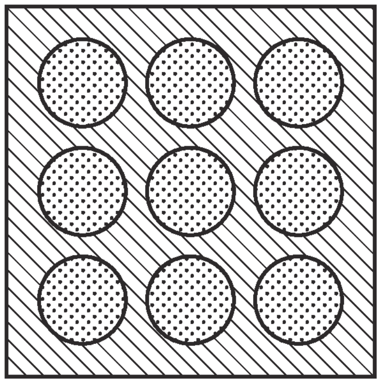

FIG. 7C

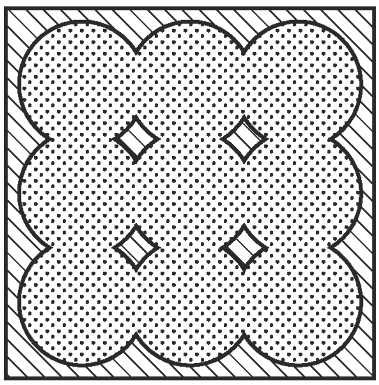

FIG. 7D

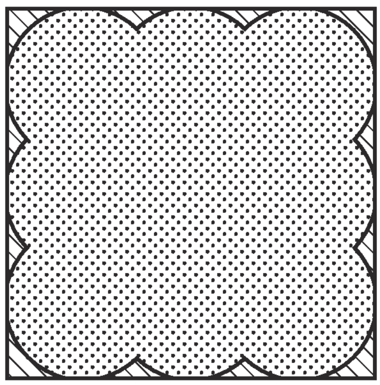

FIG. 8

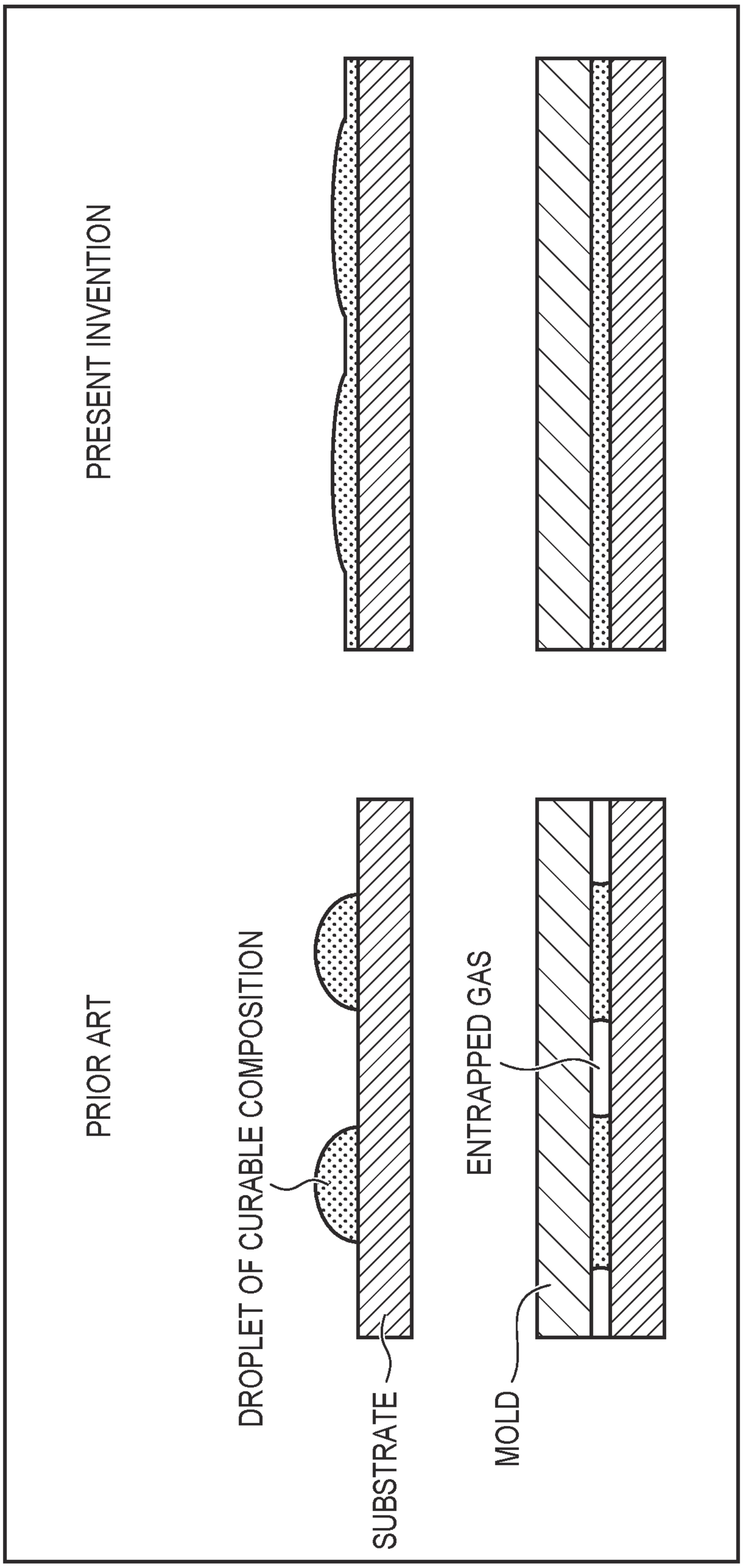
PRIOR ART
PRESENT INVENTION
DROPLET OF CURABLE COMPOSITION
SUBSTRATE
ENTRAPPED GAS
MOLD

FIG. 9

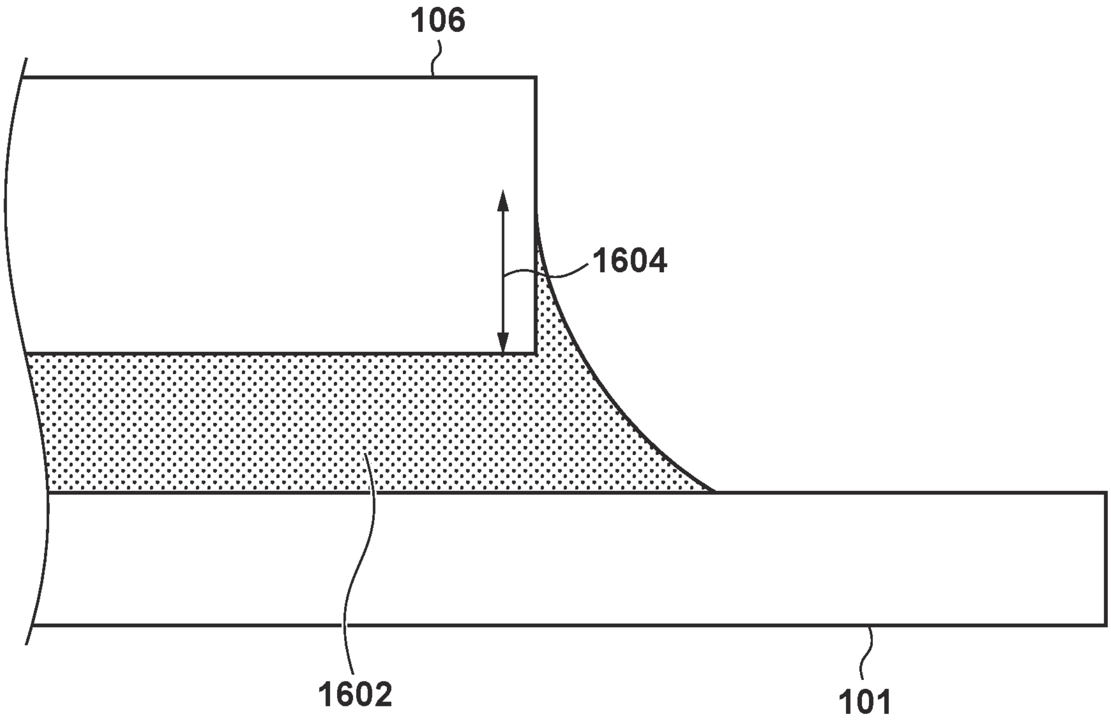


FIG. 10

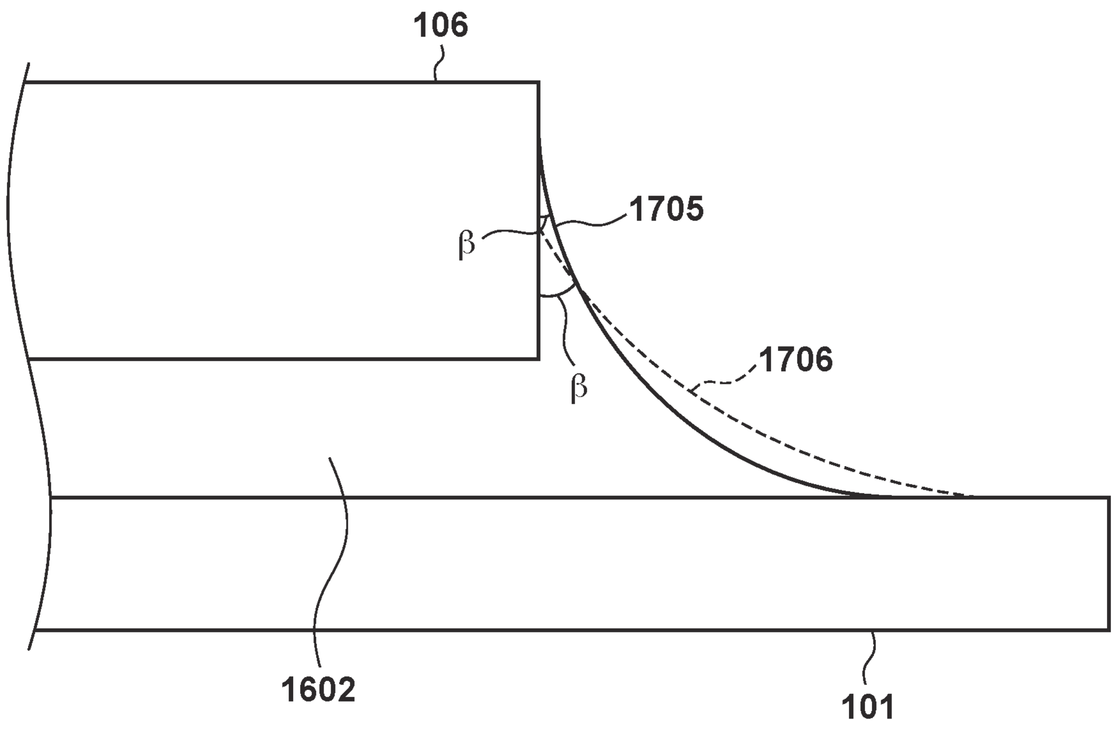

FIG. 11

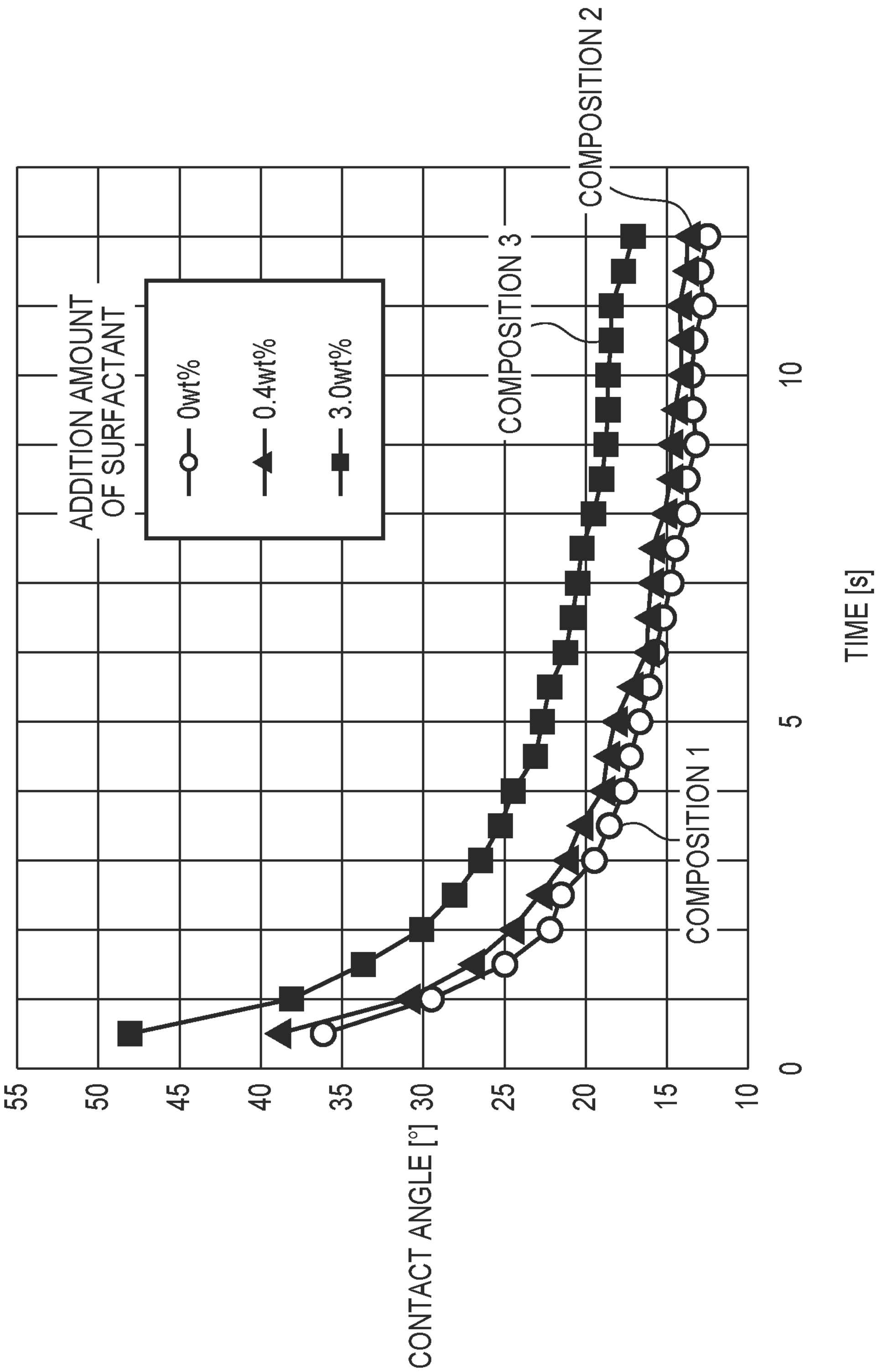
CONTACT ANGLE [°]
55
50
45
40
35
30
25
20
15
10
0
5
10
TIME [s]
ADDITION AMOUNT
OF SURFACTANT
0wt%
0.4wt%
3.0wt%
COMPOSITION 1
COMPOSITION 2
COMPOSITION 3

FIG. 12

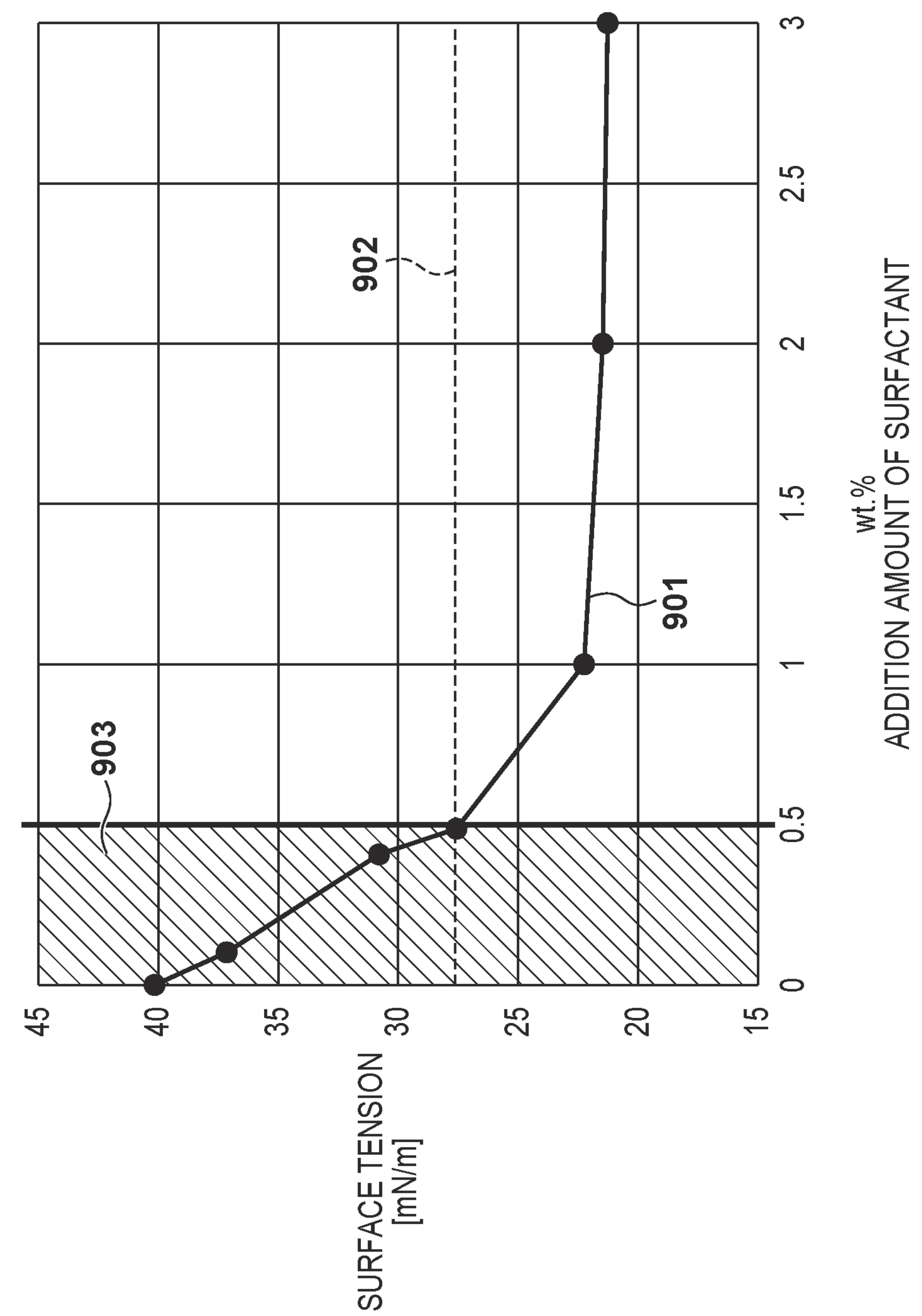
SURFACE TENSION
[mN/m]
45
40
35
30
25
20
15
0
0.5
1
1.5
2
2.5
3
wt.%
ADDITION AMOUNT OF SURFACTANT
901
902
903

FIG. 13

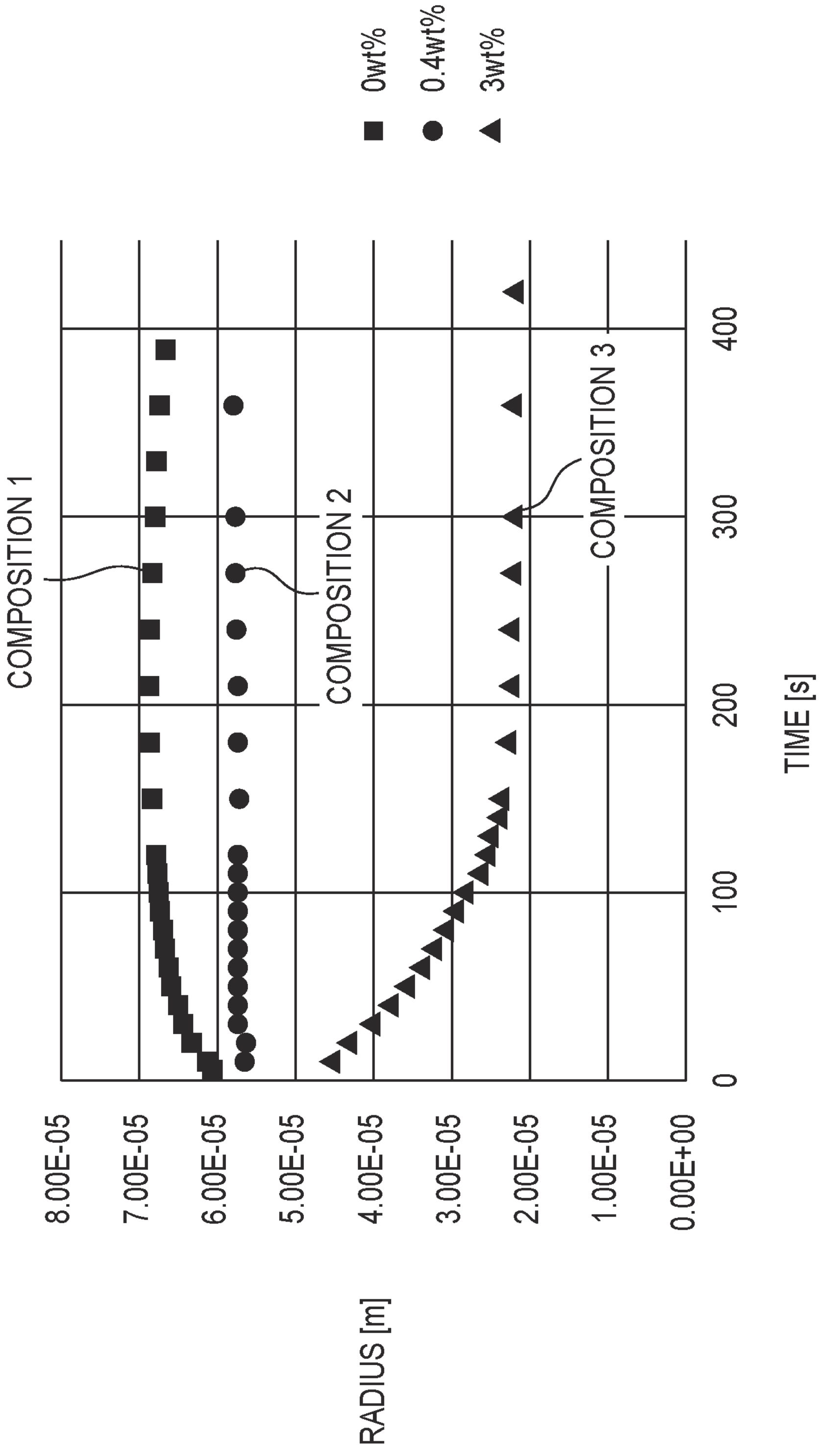

0wt%
0.4wt%
3wt%
COMPOSITION 1
COMPOSITION 2
COMPOSITION 3
RADIUS [m]
8.00E-05
7.00E-05
6.00E-05
5.00E-05
4.00E-05
3.00E-05
2.00E-05
1.00E-05
0.00E+00
0
100
200
300
400
TIME [s]

FIG. 14

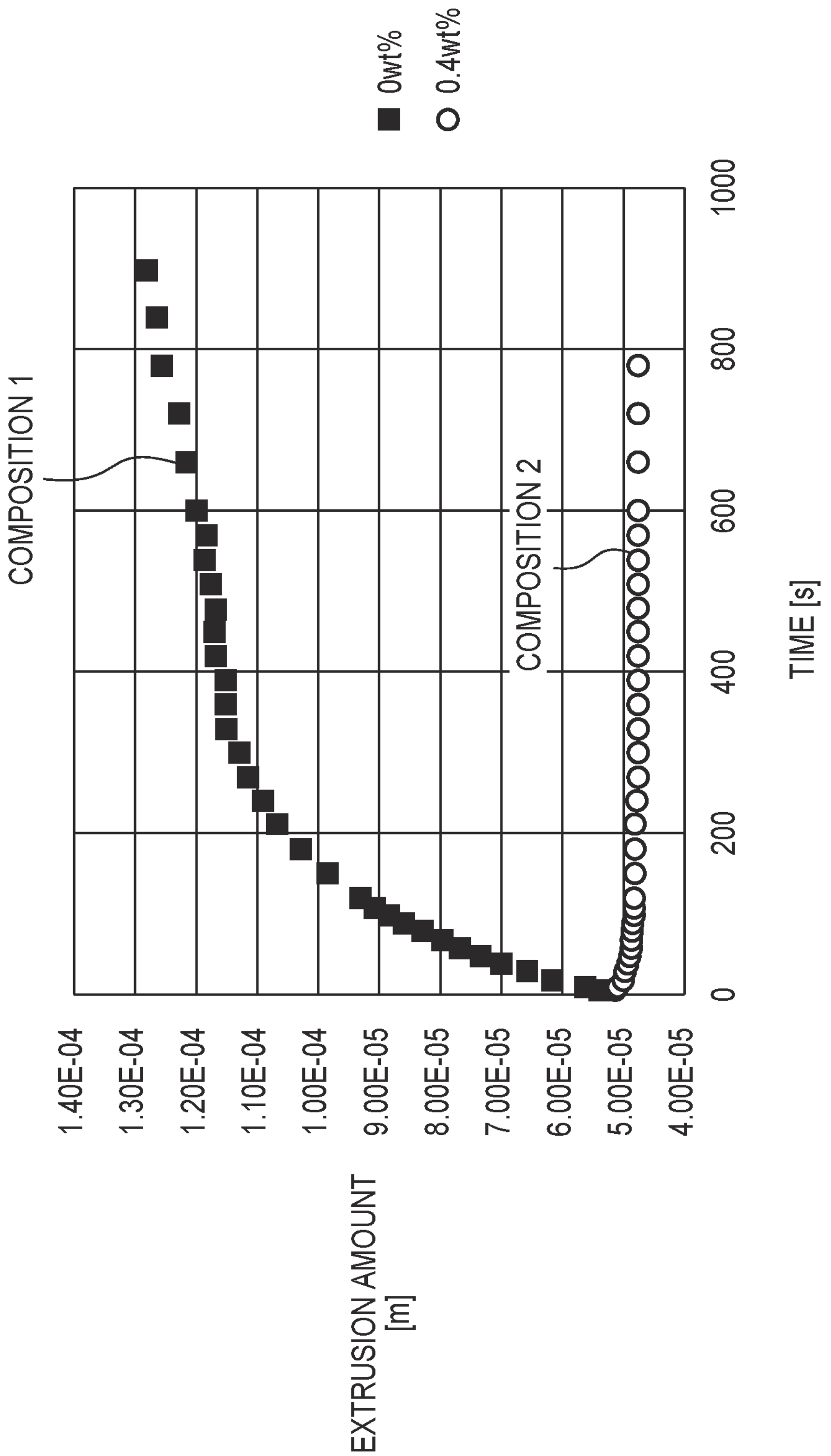

EXTRUSION AMOUNT [m]
1.40E-04
1.30E-04
1.20E-04
1.10E-04
1.00E-04
9.00E-05
8.00E-05
7.00E-05
6.00E-05
5.00E-05
4.00E-05
TIME [s]
0
200
400
600
800
1000
COMPOSITION 1
COMPOSITION 2
0wt%
0.4wt%

FIG. 15

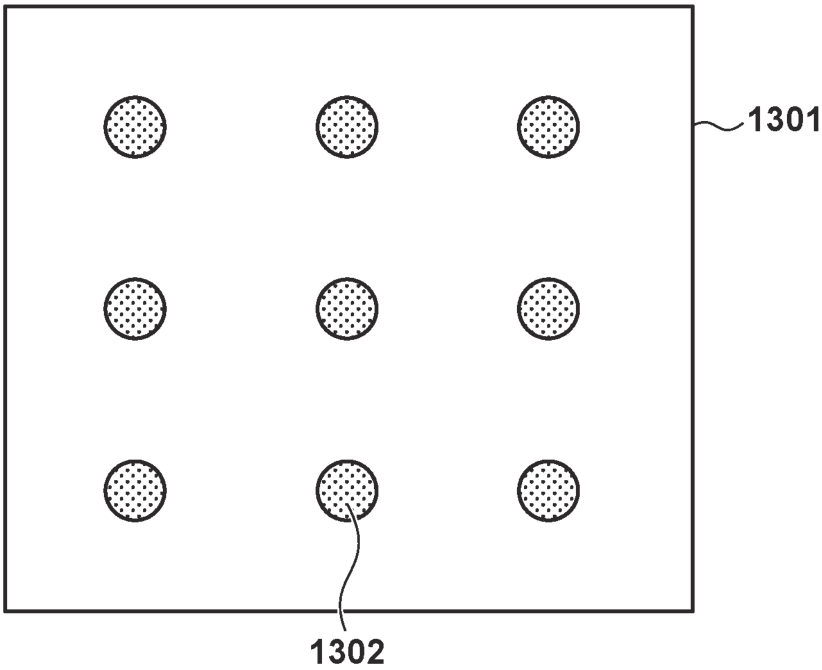


FIG. 16

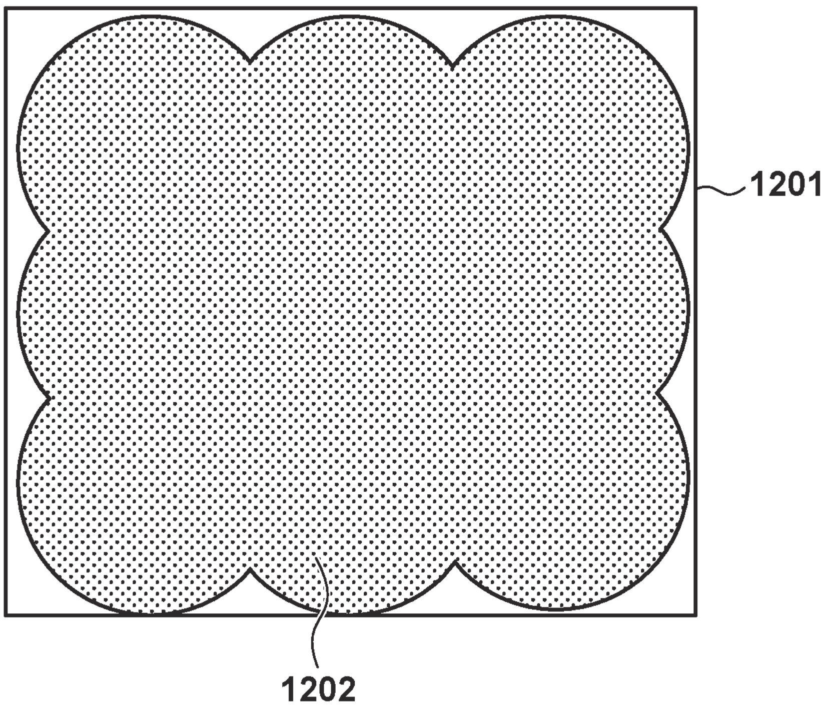

# FIG. 17

| | COMPOSITION 1 | COMPOSITION 2 | COMPOSITION 3 |
|---|---|---|---|
| | 0wt% | 0.4wt% | 3wt% |
| CONCEPTUAL DIAGRAM OF LIQUID FILM FORMATION | 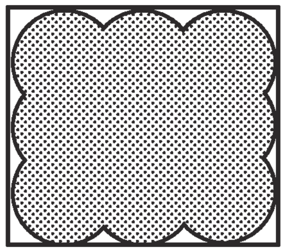 | 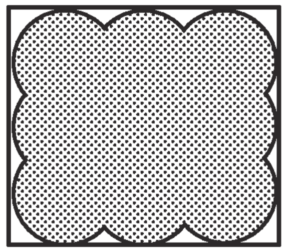 | 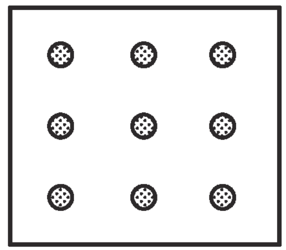 |
| LIQUID FILM FORMATION | ○ | ○ | × |
| EXTRUSION AMOUNT | 120μm | 48μm | – |

FIG. 18

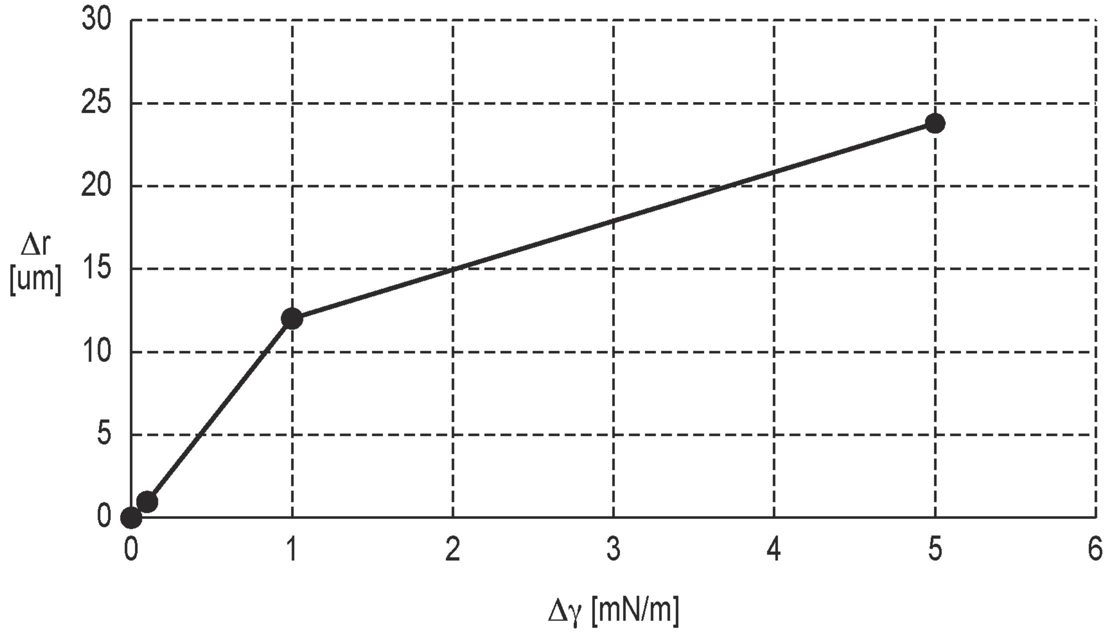
30
25
20
Δr
[um]
15
10
5
0
0
1
2
3
4
5
6
Δγ [mN/m]

FIG. 19

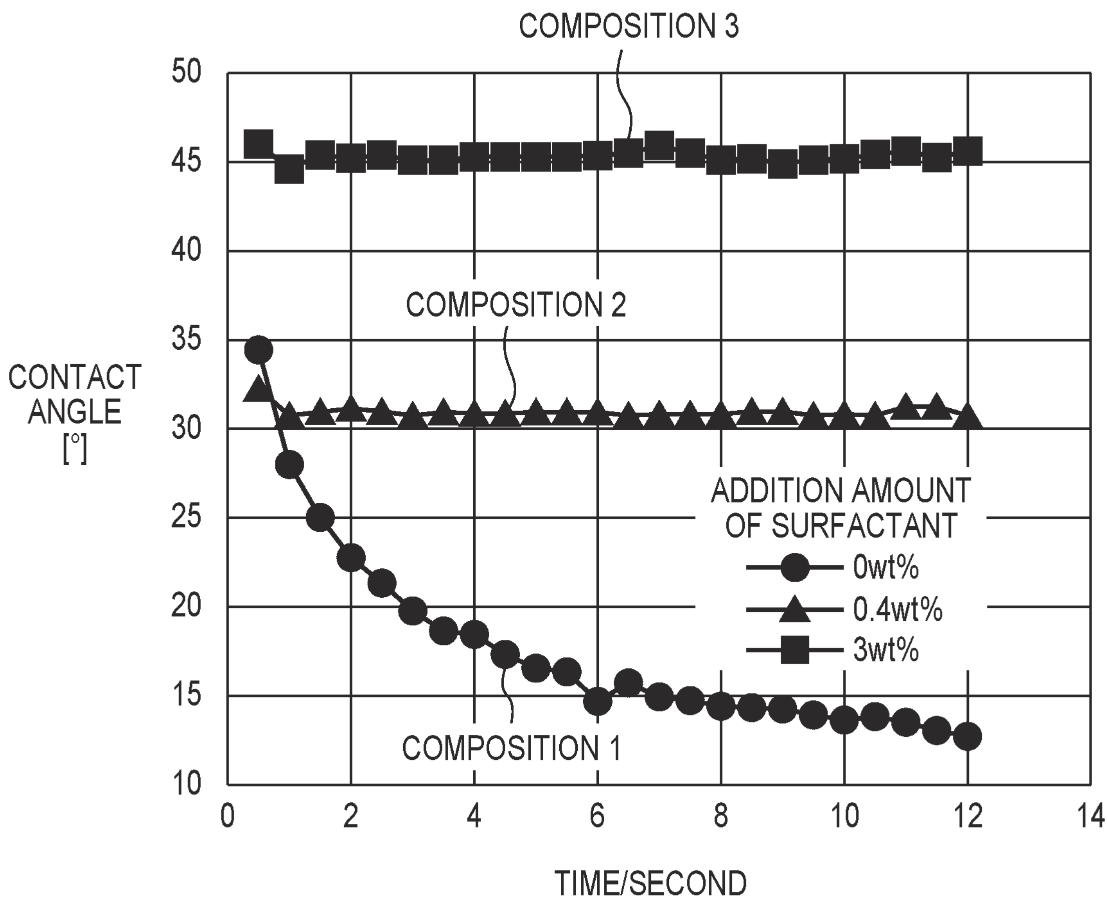
COMPOSITION 3
COMPOSITION 2
COMPOSITION 1
CONTACT
ANGLE
[°]
50
45
40
35
30
25
20
15
10
0
2
4
6
8
10
12
14
TIME/SECOND
ADDITION AMOUNT
OF SURFACTANT
0wt%
0.4wt%
3wt%

FIG. 20

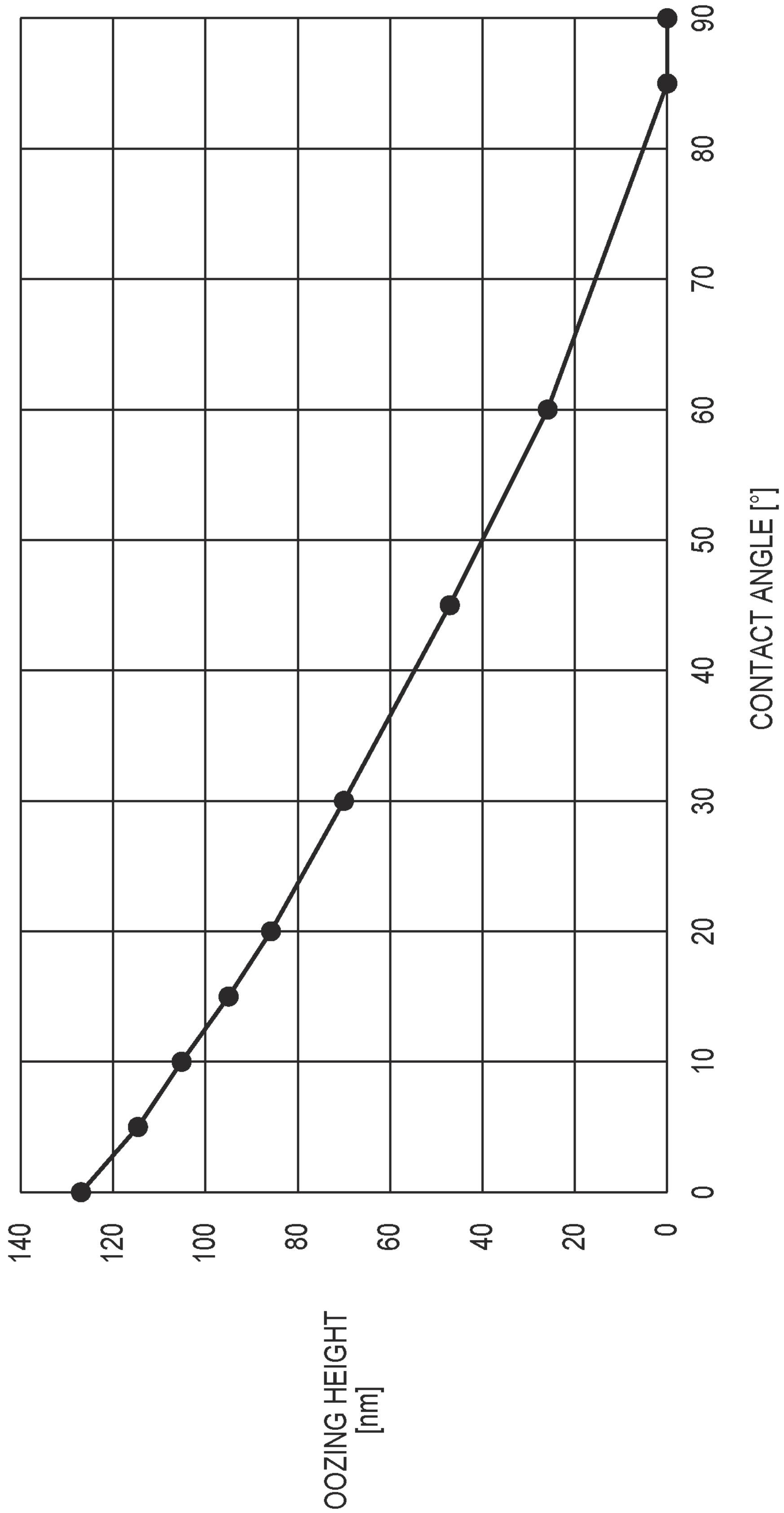
OOZING HEIGHT
[nm]
140
120
100
80
60
40
20
0
0
10
20
30
40
50
60
70
80
90
CONTACT ANGLE [°]

## INTERNATIONAL SEARCH REPORT

International application No.
**PCT/JP2024/022283**

### A. CLASSIFICATION OF SUBJECT MATTER

***H01L 21/027***(2006.01)i; ***B29C 59/02***(2006.01)i; ***C08F 20/18***(2006.01)i
FI: H01L21/30 502D; B29C59/02 Z; C08F20/18

According to International Patent Classification (IPC) or to both national classification and IPC

### B. FIELDS SEARCHED

Minimum documentation searched (classification system followed by classification symbols)

H01L21/027; B29C59/02; C08F20/18

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2022-188736 A (CANON KABUSHIKI KAISHA) 21 December 2022 (2022-12-21) claims 1-20, paragraphs [0032]-[0036], [0063]-[0120] | 1-21, 25, 27-34, 36<br>22-24, 26, 35 |
| Y | JP 2022-170427 A (TOKYO OHKA KOGYO CO., LTD.) 10 November 2022 (2022-11-10) paragraphs [0035]-[0047] | 22-24 |
| Y | JP 2022-99271 A (CANON KABUSHIKI KAISHA) 04 July 2022 (2022-07-04) claims 1-4, paragraphs [0143]-[0156] | 26, 35 |
| A | WO 2022/044999 A1 (FUJIFILM CORPORATION) 03 March 2022 (2022-03-03) paragraphs [0283]-[0293] | 1-36 |
| A | JP 2022-165788 A (TOKYO OHKA KOGYO CO., LTD.) 01 November 2022 (2022-11-01) paragraphs [0065], [0066] | 1-36 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 July 2024** | **23 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/022283**

| Patent document cited in search report | Publication date (day/month/year) | Patent family member(s) | Publication date (day/month/year) |
|---|---|---|---|
| JP 2022-188736 A | 21 December 2022 | US 2024/0101842 A1<br>claims 1-20, paragraphs [0057]-[0061], [0096]-[0170]<br>EP 4354488 A1 | |
| JP 2022-170427 A | 10 November 2022 | US 2022/0347913 A1<br>paragraphs [0068]-[0087] | |
| JP 2022-99271 A | 04 July 2022 | US 2023/0343591 A1<br>claims 1-4, paragraphs [0226]-[0240]<br>EP 4270448 A1 | |
| WO 2022/044999 A1 | 03 March 2022 | TW 202219119 A | |
| JP 2022-165788 A | 01 November 2022 | US 2022/0334470 A1<br>paragraphs [0117]-[0123] | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022188736 A
- US 20200286740 A
- JP 2009503139 A
- JP 6584578 B
- JP 2022099271 A
- JP 2023119299 A


### Non-patent literature cited in the description


- **OGAWA**. *Ultraviolet curable branched siloxanes as low-k dielectric for imprint lithography*